# EUROPEAN PATENT SPECIFICATION

(11) **EP 3 858 943 B1**
(45) Date of publication and mention of the grant of the patent: **28.02.2024**
(21) Application number: 19866229.8
(22) Date of filing: 05.09.2019
(51) Int. Cl.: C09K 3/18, C08G 65/336, C23C 14/24, B05D 5/08, C08G 65/00, C09D 5/16, C09D 171/00, C23C 14/12

(54) **SURFACE TREATMENT AGENT**
OBERFLÄCHENBEHANDLUNGSMITTEL
AGENT DE TRAITEMENT DE SURFACE

(30) Priority: 28.09.2018 JP 2018185812
(43) Date of publication of application: 04.08.2021
(73) Proprietor: DAIKIN INDUSTRIES, LTD., Osaka-Shi, Osaka 530-0001 (JP)
(72) Inventor: NOSE, Masatoshi, Osaka-shi, Osaka 530-8323 (JP); MITSUHASHI, Hisashi, Osaka-shi, Osaka 530-8323 (JP)
(74) Representative: Hoffmann Eitle
(86) International application number: PCT/JP2019/035035
(87) International publication number: WO 2020/066534

(56) References cited:
- WO-A1-2016/199908
- WO-A1-2018/056410
- WO-A1-2019/039186
- CN-A- 106 432 686
- CN-A- 106 432 686

## Description

### Technical Field

The present disclosure relates to a surface-treating agent containing a perfluoropolyether group-containing compound.

### Background Art

It is known that certain fluorine-containing silane compounds can provide excellent water-repellency, oilrepellency, antifouling property, or the like when used for the surface treatment of a base material. A layer obtained from a surface-treating agent containing a fluorine-containing silane compound (hereinafter, also referred to as "surface-treating layer") is applied as a so-called functional thin film to a variety of base materials such as glass, plastics, fibers and construction materials, for example.

As such a fluorine-containing silane compound, for example, perfluoropolyether group-containing silane compounds having an isocyanuric nucleus with a perfluoropolyether group and Si atoms having a hydrolyzable group, as disclosed in Patent Literature 1 and 2, are known (Patent Literature 1 and 2, CN106432686A).

### Citation List

### Patent Literature

Patent Literature 1: International Publication No. WO2018/056410
Patent Literature 2: International Publication No. WO2018/056413

### Summary of Invention

### Technical Problem

Although perfluoropolyether group-containing silane compounds disclosed in Patent Literature 1 and 2 can provide a surface-treating layer with excellent functionality, there is a need for a surface-treating agent that can provide a surface-treating layer with a higher level of balanced frictional durability, surface lubricity, UV resistance and weathering resistance.

### Solution to Problem

The present disclosure includes the following embodiments.
[1] A surface-treating agent comprising:
   (α) a compound represented by the following formula (α1) or formula (α2): 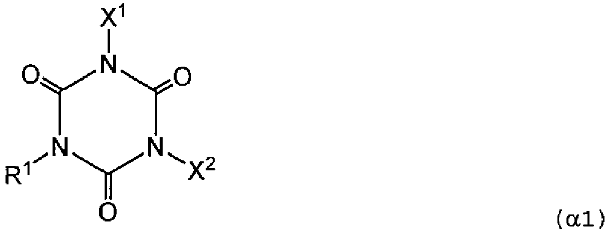 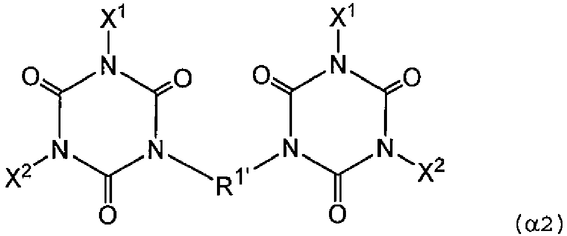 wherein:
      R¹ is a monovalent organic group containing a polyether chain;
      R^{1'} is a divalent organic group containing a polyether chain;
      the polyether chain is a chain represented by the formula:

         - (OC₆F₁₂)ₘ₁₁-(OC₅F₁₀)ₘ₁₂-(OC₄F₈)ₘ₁₃-(OC₃X¹⁰₆)ₘ₁₄-(OC₂F₄)ₘ₁₅-(OCF₂)ₘ₁₆-
      wherein m11, m12, m13, m14, m15 and m16 are each independently 0 or an integer of 1 or more;
      X¹⁰ is independently H, F or Cl; and
      the occurrence order of the respective repeating units is not limited;
      X¹ is independently a silane-containing reactive crosslinkable group; and
      X² independently represents a monovalent group; and
   (β) a perfluoropolyether group-containing silane compound having an OCF₂ unit.
[2] The surface-treating agent according to the above [1], wherein R¹ is a group represented by:

   R³-(OR²)ₐ-L-

   wherein (OR²)ₐ is a polyether chain;
      R³ is an alkyl group or a fluorinated alkyl group; and
      L is a single bond or a divalent linking group; and
      R^{1'} is a group represented by:

         -L'- (OR²)ₐ-L-
   wherein (OR²)ₐ is a polyether chain;
      L is independently a single bond or a divalent linking group; and
      L' is independently a single bond or a divalent linking group.
[3] The surface-treating agent according to the above [2], wherein (OR²)ₐ is a group represented by:

   -(OC₄F₈)ₘ₁₃-(OC₃F₆)ₘ₁₄-(OC₂F₄)ₘ₁₅-(OCF₂)ₘ₁₆-

   wherein m13 and m14 are each an integer of 0 to 30, and m15 and m16 are each an integer of 1 to 200; m13 to m16 are 5 or more in total; and the occurrence order of the respective repeating units is not limited.
[4] The surface-treating agent according to the above [2] or [3], wherein L is a group represented by:

   - (CX¹²¹X¹²²)ₒ-(L¹)ₚ-(CX¹²³X¹²⁴)_{q}-

   wherein X¹²¹ to X¹²⁴ are each independently H, F, OH, or - OSi (OR¹²⁵)₃ wherein three R¹²⁵ are each independently an alkyl group having 1 to 4 carbon atoms;
   L¹ is -C(=O)NH-, -NHC(=O)-, -O-, -C(=O)O-, -OC(=O)-, - OC(=O)O-, or -NHC(=O)NH-, in which the left side of each bond is bonded to CX¹²¹X¹²²;
   o is an integer of 0 to 10;
   p is 0 or 1; and
   q is an integer of 1 to 10; and
   L' is a group represented by:

      - (CX¹²⁶X¹²⁷)ᵣ-(CX¹²¹X¹²²)ₒ-(L¹)ₚ-(CX¹²³X¹²⁴)_{q}-

      wherein X¹²¹ to X¹²⁴, L¹, o, p, and q have the same meanings as defined in L;
   X¹²⁶ and X¹²⁷ are each independently H, F or Cl; and
   r is an integer of 1 to 6.
[5] The surface-treating agent according to any one of the above [1] to [4], wherein X¹ is a group represented by the formula:

   -L²-{Si(R^{a})ₛ(R^{b})ₜ(R^{c})ᵤ(R^{d})ᵥ}ₙ

   wherein L² is a single bond or a divalent linking group;
   R^{a}, R^{b} and R^{c} are the same or different and are each hydrogen, halogen, an alkoxy group having 1 to 10 carbon atoms, an amino group having 1 to 10 carbon atoms, an acetoxy group having 1 to 10 carbon atoms, an allyl group having 3 to 10 carbon atoms, or a glycidyl group having 3 to 10 carbon atoms;
   R^{d} is the same or different and is -O-, -NH-, -C=C-, or a silane bond;
   s, t and u are the same or different and are each 0 or 1;
   v is an integer of 0 to 3;
   n is an integer of 1 to 20;
   in a case where n is 1, s+t+u is 3 and v is 0;
   in a case where n is 2 to 20, s+t+u is the same or different and is 0 to 2, and v is the same or different and is 0 to 2; and
   in a case where v is an integer of 1 or more, at least two Si atoms are bonded to each other via R^{d} in a linear, ladder, cyclic, or polycyclic form.
[6] The surface-treating agent according to any one of the above [1] to [5], wherein X¹ is a group represented by -L²-SiR⁵₃, -L²-Si(OR⁶)₃, -L²-Si(NR⁶₂)₃ or -L²-Si(OCOR⁶)₃ wherein L² is -C₂H₄-, -C₃H₆-, -C₄H₈-O-CH₂-, -CO-O-CH₂-CH(OH)-CH₂-, -CH₂-, or -C₄H₈-;
   R⁵ is a halogen atom; and
   R⁶ is independently an alkyl group having 1 to 4 carbon atoms.
[7] The surface-treating agent according to any one of the above [1] to [4], wherein X¹ is a silane-containing reactive crosslinkable group represented by the formula:

   -L²-{Si(R^{a})ₛ(R^{b})ₜ(R^{c})ᵤ(R^{d'})ᵥ}ₙ

   wherein L² is a single bond or a divalent linking group;
   R^{a}, R^{b} and R^{c} are the same or different and are each hydrogen, halogen, an alkoxy group having 1 to 10 carbon atoms, an amino group having 1 to 10 carbon atoms, an acetoxy group having 1 to 10 carbon atoms, an allyl group having 3 to 10 carbon atoms, or a glycidyl group having 3 to 10 carbon atoms;
   R^{d'} are the same or different, and is a group represented by -Z-SiR^{d1'}_{p'}R^{d2'}_{q'}R^{d3'}_{r'}
      wherein Z is the same or different and is a single bond or a divalent linking group;
   R^{d1'} is the same or different and is R^{d"};
   R^{d"} has the same meaning as R^{d'};
   the number of Si atoms linearly linked via a Z group in R^{d'} is at most 5;
   R^{d2'} is the same or different and is a hydroxyl group or a hydrolyzable group;
   R^{d3'} is the same or different and is a hydrogen atom or a lower alkyl group;
   p' is the same or different and is an integer of 0 to 3;
   q' is the same or different and is an integer of 0 to 3; and
   r' is the same or different and is an integer of 0 to 3,
   provided that the sum of p', q' and r' is 3.
   s, t and u are the same or different and are each 0 or 1;
   v is an integer of 0 to 3; and
   n is an integer of 1 to 20.
[8] The surface-treating agent according to any one of the above [1] to [4], wherein X¹ is a silane-containing reactive crosslinkable group represented by the formula:

   -L⁶-{C(R^{a6})ₛ₆(R^{b6})ₜ₆(R^{c6})ᵤ₆(R^{d6})ᵥ₆}ₙ₆

   wherein L⁶ is a single bond or a divalent linking group;
   R^{a6}, R^{b6} and R^{c6} are the same or different and are each hydrogen, halogen, an alkoxy group having 1 to 10 carbon atoms, an amino group having 1 to 10 carbon atoms, an acetoxy group having 1 to 10 carbon atoms, an allyl group having 3 to 10 carbon atoms, a glycidyl group having 3 to 10 carbon atoms, OCOR⁶⁷, wherein R⁶⁷ is an alkyl group having 1 to 6 carbon atoms, OH or -Y⁶-SiR⁶⁵ⱼ₆R⁶⁶₃₋ⱼ₆;
   R^{d6} is the same or different and is -O-, -NH-, -C≡C-, or -Z⁶-CR⁶¹ₚ₆R⁶²_{q6}R⁶³ᵣ₆;
   Z⁶ is the same or different and is an oxygen atom or a divalent organic group;
   wherein R⁶¹ is the same or different and represents R^{d6'};
   R^{d6'} has the same meaning as R^{d6};
   the number of C atoms linearly linked via a Z⁶ group in R^{d6} is at most 5;
   R⁶² is the same or different and is -Y⁶-SiR⁶⁵ⱼ₆R⁶⁶₃₋ⱼ₆;
   Y⁶ is the same or different and is a divalent organic group;
   R⁶⁵ is the same or different and is a hydroxyl group or a hydrolyzable group;
   R⁶⁶ is the same or different and is a hydrogen atom or a lower alkyl group;
   j6 with respect to each (-Y⁶-SiR⁶⁵ⱼ₆R⁶⁶₃₋ⱼ₆) unit is independently an integer of 1 to 3;
   R⁶³ is the same or different and is a hydrogen atom or a lower alkyl group;
   p6 is the same or different and is an integer of 0 to 3;
   q6 is the same or different and is an integer of 0 to 3;
   r6 is the same or different and is an integer of 0 to 3; and
   s6, t6 and u6 are the same or different and are each 0 or 1, v6 is an integer of 0 to 3, and n6 is an integer of 1 to 20,
   provided that in the formula, at least two -Y⁶-SiR⁶⁵ⱼ₆R⁶⁶₃₋ⱼ₆ are present.
[9] The surface-treating agent according to any one of the above [1] to [8], wherein (β) the perfluoropolyether group-containing silane compound having an OCF₂ unit is a compound represented by the following formula (A1), (A2), (B1), (B2), (C1), (C2), (D1), (D2), or (E1):

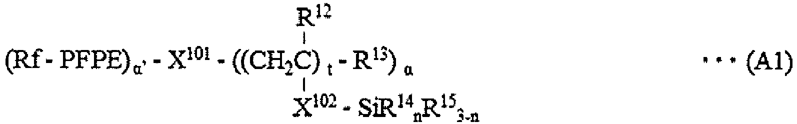

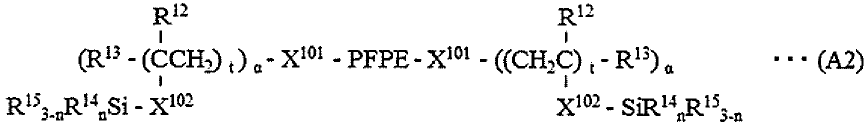

   (Rf- PFPE)_{β'}-X¹⁰⁵-(SiR¹⁴ₙR¹⁵₃₋ₙ)_{β} ... (B1)

   (R¹⁵₃₋ₙR¹⁴ₙSi)_{β}- X¹⁰⁵- PFPE-X¹⁰⁵-(SiR¹⁴ₙR¹⁵₃₋ₙ)_{β} ... (B2)

   (Rf-PFPE)_{γ'}-X¹⁰⁷-(SiR^{a3}ₖR^{b3}ₗR^{c3}ₘ)_{γ} ··· (C1)

   (R^{c3}ₘR^{b3}ₗR^{a3}ₖSi)_{γ}-X¹⁰⁷-PFPE-X¹⁰⁷-(SiR^{a3}ₖR^{b3}ₗR^{c3}ₘ)_{γ} ··· (C2)

   (Rf-PFPE)_{δ'}-X¹⁰⁹-(CR^{d3}_{k'}R^{e3}_{l'}R^{f3}_{m'})_{δ} ... (D1)

   (R^{f3}_{m'}R^{e3}_{l'}R^{d3}_{k'}C)_{δ}-X¹⁰⁹-PFPE-X¹⁰⁹-(CR^{d3}_{k'}R^{e3}_{l'}R^{f3}_{m'})_{δ} ... (D2)

   (Rf-PFPE-G⁵)ₐ₅-Z⁵-((O-R¹⁶)_{c5}-SiR¹⁴ₙR¹⁵₃₋ₙ)_{b5} ··· (E1)

   wherein
   Rf is each independently an alkyl group having 1 to 16 carbon atoms optionally substituted with one or more fluorine atoms;
   PFPE is a group represented by:

      - (OC₆F₁₂)ₐ₁-(OC₅F₁₀)_{b1}-(OC₄F₈)_{c1}-(OC₃F₆)_{d1}-(OC₂F₄)ₑ₁-(OCF₂)_{f1}-

      wherein a1, b1, c1, d1 and e1 are each independently an integer of 0 or more and 200 or less, fl is an integer of 1 or more and 200 or less, and the occurrence order of the respective repeating units in parenthesis with al, b1, c1, d1, e1 or f1, is not limited in the formula;
   R¹⁴, at each occurrence, is each independently a hydrogen atom or an alkyl group having 1 to 22 carbon atoms;
   R¹⁵, at each occurrence, is each independently a hydroxyl group or a hydrolyzable group;
   R¹³, at each occurrence, is each independently a hydrogen atom or a halogen atom;
   R¹², at each occurrence, is each independently a hydrogen atom or a lower alkyl group;
   n with respect to each (-SiR¹⁴ₙR¹⁵₃₋ₙ) unit is independently an integer of 0 to 3;
   provided that at least one R¹⁵ is present in formulae (A1), (A2), (B1), and (B2);
   X¹⁰¹ is each independently a single bond or a di- to decavalent organic group;
   X¹⁰², at each occurrence, is each independently a single bond or a divalent organic group;
   t is each independently an integer of 1 to 10;
   α is each independently an integer of 1 to 9;
   α' is an integer of 1 to 9;
   X¹⁰⁵ is each independently a single bond or a di- to decavalent organic group;
   β is each independently an integer of 1 to 9;
   β' is an integer of 1 to 9;
   X¹⁰⁷ is each independently a single bond or a di- to decavalent organic group;
   γ is each independently an integer of 1 to 9;
   γ' is an integer of 1 to 9;
   R^{a3}, at each occurrence, is each independently -Z³-SiR⁷¹ₚR⁷²_{q}R⁷³ᵣ;
   Z³, at each occurrence, is each independently an oxygen atom or a divalent organic group;
   R⁷¹, at each occurrence, is each independently R^{a}';
   R^{a}' has the same meaning as R^{a3};
   the number of Si atoms linearly linked via a Z³ group in R^{a3} is at most 5;
   R⁷², at each occurrence, is each independently a hydroxyl group or a hydrolyzable group;
   R⁷³, at each occurrence, is each independently a hydrogen atom or a lower alkyl group;
   p, at each occurrence, is each independently an integer of 0 to 3;
   q, at each occurrence, is each independently an integer of 0 to 3;
   r, at each occurrence, is each independently an integer of 0 to 3;
   provided that the sum of p, q and r with respect to (-Z³-SiR⁷¹ₚR⁷²_{q}R⁷³ᵣ) is 3 and at least one R⁷² is present in formulae (C1) and (C2);
   R^{b3}, at each occurrence, is each independently a hydroxyl group or a hydrolyzable group;
   R^{c3}, at each occurrence, is each independently a hydrogen atom or a lower alkyl group;
   k, at each occurrence, is each independently an integer of 1 to 3;
   1, at each occurrence, is each independently an integer of 0 to 2;
   m, at each occurrence, is each independently an integer of 0 to 2;
   provided that, in the unit in parentheses with γ, the sum of k, 1 and m is 3;
   X¹⁰⁹ is each independently a single bond or a di- to decavalent organic group;
   δ is each independently an integer of 1 to 9;
   δ' is an integer of 1 to 9;
   R^{d3}, at each occurrence, is each independently -Z³'-CR⁸¹_{p'}R⁸²_{q'}R⁸³_{r'};
   Z³, at each occurrence, is each independently an oxygen atom or a divalent organic group;
   R⁸¹, at each occurrence, is each independently R^{d3}";
   R^{d3}" has the same meaning as R^{d3};
   the number of C atoms linearly linked via a Z^{3'} group in R^{d3} is at most 5;
   R⁸² is -Y³-SiR⁸⁵ⱼR⁸⁶₃₋ⱼ;
   Y³, at each occurrence, is independently a divalent organic group;
   R⁸⁵, at each occurrence, is each independently a hydroxyl group or a hydrolyzable group;
   R⁸⁶, at each occurrence, is each independently a hydrogen atom or a lower alkyl group;
   j with respect to each (-Y³-SiR⁸⁵ⱼR⁸⁶₃₋ⱼ) unit is independently an integer of 1 to 3;
   R⁸³, at each occurrence, is each independently a hydrogen atom, a hydroxyl group or a lower alkyl group;
   p' , at each occurrence, is each independently an integer of 0 to 3;
   q', at each occurrence, is each independently an integer of 0 to 3;
   r', at each occurrence, is each independently an integer of 0 to 3;
   R^{e3}, at each occurrence, is each independently -Y³-SiR⁸⁵ⱼR⁸⁶₃₋ⱼ;
   R^{f3}, at each occurrence, is each independently a hydrogen atom, a hydroxyl group or a lower alkyl group;
   k', at each occurrence, is each independently an integer of 0 to 3;
   l', at each occurrence, is each independently an integer of 0 to 3;
   m', at each occurrence, is each independently an integer of 0 to 3,
   provided that, in the formula, at least one q' is 2 or 3 or at least one l' is 2 or 3;
   G⁵ is -R¹⁷-O-, -R¹⁷-CONH-, -CONH-, or a single bond;
   R¹⁷ is an alkylene group;
   Z⁵ is an (a5+b5)-valent hydrocarbon group or an (a5+b5)-valent group having 2 or more carbon atoms and having at least one etheric oxygen atom between carbon atoms in the hydrocarbon group;
   R¹⁶ is an alkylene group;
   a5 is an integer of 1 or more;
   b5 is an integer of 1 or more;
   provided that (a5+b5) is 3 or more; and
   c5 is 0 or 1.
[10] The surface-treating agent according to the above [9], wherein (β) the perfluoropolyether group-containing silane compound having an OCF₂ unit is a compound represented by formula (C1) or (C2).
[11] The surface-treating agent according to the above [9] or [10], wherein PFPE is a group represented by:

   -(OC₄F₈)ₘ₁₃-(OC₃F₆)ₘ₁₄-(OC₂F₄)ₘ₁₅-(OCF₂)ₘ₁₆-

   wherein m13 and ml4 are each an integer of 0 to 30, and m15 and m16 are each an integer of 1 to 200; and the occurrence order of the respective repeating units is not limited.
[12] The surface-treating agent according to any one of the above [1] to [11], further comprising a solvent.
[13] The surface-treating agent according to any one of the above [1] to [12], for use as an antifouling coating agent or a water-proof coating agent.
[14] The surface-treating agent according to any one of the above [1] to [13], which is for vacuum deposition.
[15] A pellet comprising the surface-treating agent according to any one of the above [1] to [14].
[16] An article comprising: a base material; and a layer disposed on a surface of the base material, the layer being formed by the surface-treating agent according to any one of the above [1] to [14].
[17] The article according to the above [16], wherein the article is an optical member.

### Advantageous Effect of Invention

By using the surface-treating agent of the present disclosure, it is possible to form a surface-treating layer having, in addition to excellent water-repellency, weather resistance, surface lubricity, eraser durability, and SW friction durability in good balance.

### Description of Embodiments

Hereinafter, a surface-treating agent of the present disclosure will be specifically described.

The surface-treating agent of the present disclosure comprises
(α) an isocyanuric compound represented by formula (α1) or formula (α2); and
(β) a perfluoropolyether group-containing silane compound having an OCF₂ unit.
(α) Isocyanuric compound represented by formula (α1) or formula (α2) (hereinafter, also referred to as "compound α")

The compound α is a compound represented by formula (α1) or formula (α2): 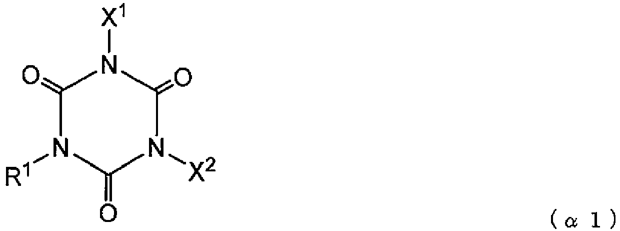 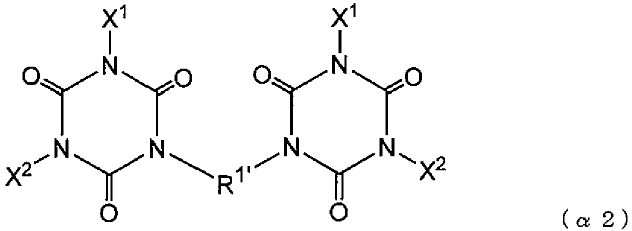 wherein:
R¹ is a monovalent organic group containing a polyether chain;
R^{1'} is a divalent organic group containing a polyether chain;
the polyether chain is a chain represented by formula:

   -(OC₆F₁₂)ₘ₁₁-(OC₅F₁₀)ₘ₁₂-(OC₄F₈)ₘ₁₃-(OC₃X¹⁰₆)ₘ₁₄-(OC₂F₄)ₘ₁₅-(OCF₂)ₘ₁₆-

   wherein m11, m12, m13, m14, m15 and m16 are each independently 0 or an integer of 1 or more;
X¹⁰ is independently H, F or Cl; and
the occurrence order of the respective repeating units is not limited;
X¹ is independently a silane-containing reactive crosslinkable group; and
X² independently represents a monovalent group.
R¹ is preferably a monovalent organic group containing a polyether chain (excluding those containing a urethane bond).
R^{1'} is preferably a divalent organic group containing a polyether chain (excluding those containing a urethane bond).
X¹⁰ is preferably F.
m11 to m16 are each preferably an integer of 0 to 200, and more preferably an integer of 0 to 100. The sum of m11 to m16 are preferably 1 or more, more preferably 5 or more, and further preferably 10 or more. The sum of m11 to m16 are preferably 200 or less, and more preferably 100 or less. The sum of m11 to m16 are preferably 10 to 200, and more preferably 10 to 100.

In the polyether chain, the respective repeating units may be linear or branched, and are preferably linear. For example, - (OC₆F₁₂)- may be - (OCF₂CF₂CF₂CF₂CF₂CF₂)-, - (OCF (CF₃)CF₂CF₂CF₂CF₂)-, - (OCF₂CF(CF₃)CF₂CF₂CF₂)- , - (OCF₂CF₂CF(CF₃)CF₂CF₂)-, - (OCF₂CF₂CF₂CF(CF₃)CF₂)-, - (OCF₂CF₂CF₂CF₂CF(CF₃))- or the like, and is preferably - (OCF₂CF₂CF₂CF₂CF₂CF₂)-. For example, - (OC₅F₁₀)- may be - (OCF₂CF₂CF₂CF₂CF₂)- , - (OCF(CF₃)CF₂CF₂CF₂)- , - (OCF₂CF(CF₃)CF₂CF₂)- , - (OCF₂CF₂CF(CF₃)CF₂)- , - (OCF₂CF₂CF₂CF(CF₃)) - or the like, and is preferably - (OCF₂CF₂CF₂CF₂CF₂)-. For example, - (OC₄F₈)- may be any of - (OCF₂CF₂CF₂CF₂)- , - (OCF(CF₃)CF₂CF₂)- , -(OCF₂CF(CF₃)CF₂)- , - (OCF₂CF₂CF(CF₃)) -, -(OC(CF₃)₂CF₂)-, -(OCF₂C(CF₃)₂)-, - (OCF(CF₃)CF(CF₃))-, -(OCF(C₂F₅)CF₂)- and - (OCF₂CF(C₂F₅))-, and is preferably - (OCF₂CF₂CF₂CF₂)-. For example, - (OC₃F₆)- may be any of -(OCF₂CF₂CF₂)-, - (OCF(CF₃)CF₂)- and - (OCF₂CF(CF₃)) - , and is preferably - (OCF₂CF₂CF₂)-. For example, -(OC₂F₄)- may be any of - (OCF₂CF₂)- and - (OCF(CF₃))-, and is preferably - (OCF₂CF₂)- .

In one embodiment, the polyether chain is a chain represented by - (OC₃F₆)ₘ₁₄- wherein m14 is an integer of 1 to 200. The polyether chain is preferably a chain represented by - (OCF₂CF₂CF₂)ₘ₁₄-, wherein m14 is an integer of 1 to 200, or - (OCF(CF₃)CF₂)ₘ₁₄-, wherein m14 is an integer of 1 to 200. In one embodiment, the polyether chain is a chain represented by - (OCF₂CF₂CF₂)ₘ₁₄-, wherein m14 is an integer of 1 to 200. In another embodiment, the polyether chain is a chain represented by - (OCF(CF₃)CF₂)ₘ₁₄-, wherein m14 is an integer of 1 to 200. ml4 is preferably an integer of 5 to 200, and more preferably an integer of 10 to 200.

In another embodiment, the polyether chain is a chain represented by - (OC₄F₈)ₘ₁₃-(OC₃F₆)ₘ₁₄-(OC₂F₄)ₘ₁₅-(OCF₂)ₘ₁₆-, wherein m13 and m14 are each an integer of 0 to 30, and m15 and m16 are each an integer of 1 to 200, m13 to m16 are 5 or more in total, and the occurrence order of the respective repeating units is not limited. m15 and m16 are each preferably an integer of 5 to 200, and more preferably an integer of 10 to 200. m13 to m16 are preferably 10 or more in total. The polyether chain is preferably - (OCF₂CF₂CF₂CF₂)ₘ₁₃-(OCF₂CF₂CF₂)ₘ₁₄-(OCF₂CF₂)ₘ₁₅-(OCF₂)ₘ₁₆-. In one embodiment, the polyether chain is - (OC₂F₄)ₘ₁₅-(OCF₂)ₘ₁₆-, wherein m15 and m16 are each an integer of 1 to 200, and the occurrence order of the respective repeating units is not limited. m15 and m16 are each preferably an integer of 5 to 200, and more preferably an integer of 10 to 200.

In yet another embodiment, the polyether chain is a group represented by - (R^{m1}-R^{m2})ₘ₁₇-. In the formula, R^{m1} is OCF₂ or OC₂F₄, and preferably OC₂F₄. In the formula, R^{m2} is a group selected from OC₂F₄, OC₃F₆, OC₄F₈, OC₅F₁₀ and OC₆F₁₂, or a combination of two or three groups independently selected from these groups. Preferably, R^{m1} is a group selected from OC₂F₄, OC₃F₆ and OC₄F₈, a group selected from OC₃F₆, OC₄F₈, OC₅F₁₀ and OC₆F₁₂, or a combination of two or three groups independently selected from these groups. The combination of two or three groups independently selected from OC₂F₄, OC₃F₆ and OC₄F₈ is not limited, and examples thereof include -OC₂F₄OC₃F₆-, -OC₂F₄OC₄F₈-, -OC₃F₆OC₂F₄-, -OC₃F₆OC₃F₆-, - OC₃F₆OC₄F₈-, -OC₄F₃OC₄F₈-, -OC₄F₈OC₃F₆-, -OC₄F₈OC₂F₄-, - OC₂F₄OC₂F₄OC₃F₆-, -OC₂F₄OC₂F₄OC₄F₈-, -OC₂F₄OC₃F₆OC₂F₄-, - OC₂F₄OC₃F₆OC₃F₆-, -OC₂F₄OC₄F₈OC₂F₄-, -OC₃F₆OC₂F₄OC₂F₄-, - OC₃F₆OC₂F₄OC₃F₆-, -OC₃F₆OC₃F₆OC₂F₄-, and -OC₄F₈OC₂F₄OC₂F₄-. The m17 is an integer of 2 or more, preferably an integer of 3 or more, and more preferably an integer of 5 or more, and is an integer of 100 or less, and preferably an integer of 50 or less. In the formula, OC₂F₄, OC₃F₆, OC₄F₈, OC₅F_{10.} and OC₆F₁₂ may be each linear or branched, and are each preferably linear. In this embodiment, the polyether chain is preferably - (OC₂F₄-OC₃F₆)ₘ₁₇- or - (OC₂F₄-OC₄F₈)ₘ₁₇-.

In yet another embodiment, the polyether chain is a group represented by -(OC₆F₁₂)ₘ₁₁-(OC₅F₁₀)ₘ₁₂-(OC₄F₈)ₘ₁₃-(OC₃F₆)ₘ₁₄-(OC₂F₄)ₘ₁₅-(OCF₂)ₘ₁₆-, wherein m15 is an integer of 1 or more and 200 or less, m11, m12, m13, m14, and m16 are each independently an integer of 0 or more and 200 or less, the sum of m11, m12, m13, m14, m15 and m16 is at least 1, and the occurrence order of the respective repeating units in parentheses with m11, m12, m13, m14, m15 or m16 is not limited in the formula. m15 is preferably an integer of 1 or more and 100 or less, and more preferably 5 or more and 100 or less. The sum of m11, m12, m13, m14, m15 and m16 is preferably 5 or more, more preferably 10 or more, for example, 10 or more and 100 or less.

In yet another embodiment, the polyether chain is a group represented by - (OC₆F₁₂)m₁₁- (OC₅F₁₀)ₘ₁₂- (OC₄F₈)ₘ₁₃-(OC₃F₆)ₘ₁₄-(OC₂F₄)ₘ₁₅-(OCF₂)ₘ₁₆-, wherein m16 is an integer of 1 or more and 200 or less, m11, m12, m13, m14, and m15 are each independently an integer of 0 or more and 200 or less, the sum of m11, m12, m13, m14, m15 and m16 is at least 1, and the occurrence order of the respective repeating units in parentheses with m11, m12, m13, m14, m15 or m16 is not limited in the formula. m16 is preferably an integer of 1 or more and 100 or less, and more preferably 5 or more and 100 or less. The sum of m11, m12, m13, m14, m15 and m16 is preferably 5 or more, more preferably 10 or more, for example, 10 or more and 100 or less.

In the polyether chain, the ratio of m15 to m16 (hereinafter, referred to as "m15/m16 ratio") is 0.1 to 10, preferably 0.2 to 5, more preferably 0.2 to 2, further preferably 0.2 to 1.5, and still more preferably 0.2 to 0.85. An m15/m16 ratio of 10 or less further enhances lubricity, friction durability and chemical resistance (for example, durability to artificial sweat) of the surface-treating layer. A lower m15/m16 ratio further enhances lubricity and friction durability of the surface-treating layer. On the other hand, an m15/m16 ratio of 0.1 or more can further enhance stability of the compound. A higher m15/m16 ratio further enhances stability of the compound.

The polyether chain may be at least one chain selected from the group consisting of a chain represented by the following formula:

- (OCF₂CF₂CX¹¹2)ₙ₁₁(OCF₂CF(CF₃))ₙ₁₂(OCF₂CF₂)ₙ₁₃(OCF₂)ₙ₁₄(OC₄F₈)ₙ₁₅-

wherein n11, n12, n13, n14 and n15 are each independently 0 or an integer of 1 or more;
X¹¹ is independently H, F or Cl; and
the occurrence order of the respective repeating units is not limited,
   and a chain represented by the following formula:

      - (OCF₂-R¹¹)_{f}-
   wherein R¹¹ is a group selected from OC₂F₄, OC₃F₆, and OC₄F₈, and f is an integer of 2 to 100.
X¹¹ is preferably F.
n11 to n15 are each preferably an integer of 0 to 200. n11 to n15 are preferably 2 or more, more preferably 5 to 300, further preferably 10 to 200, and particularly preferably 10 to 100 in total.
R¹¹ is a group selected from OC₂F₄, OC₃F₆ and OC₄F₈, or a combination of two or three groups independently selected from these groups. The combination of two or three groups independently selected from OC₂F₄, OC₃F₆ and OC₄F₈ is not limited, and examples thereof include -OC₂F₄OC₃F₆-, - OC₂F₄OC₄F₈-, -OC₃F₆OC₂F₄-, -OC₃F₆OC₃F₆-, -OC₃F₆OC₄F₈-, - OC₄F₈OC₄F₈-, -OC₄F₈OC₃F₆-, -OC₄F₈OC₂F₄-, -OC₂F₄OC₂F₄OC₃F₆-, - OC₂F₄OC₂F₄OC₄F₈-, -OC₂F₄OC₃F₆OC₂F₄-, -OC₂F₄OC₃F₆OC₃F₆-, - OC₂F₄OC₄F₈OC₂F₄-, -OC₃F₆OC₂F₄OC₂F₄-, -OC₃F₆OC₂F₄OC₃F₆-, - OC₃F₆OC₃F₆OC₂F₄-, and -OC₄F₈OC₂F₄OC₂F₄-. f is an integer of 2 to 100, and preferably an integer of 2 to 50. In the formula, OC₂F₄, OC₃F₆ and OC₄F₈ may be each linear or branched, and are each preferably linear. In this embodiment, the formula: - (OC₂F₄-R¹¹)_{f}- is preferably the formula: - (OC₂F₄-OC₃F₆)_{f}- or the formula: - (OC₂F₄-OC₄F₈)_{f}-.

The number average molecular weight of the polyether chain portion in the isocyanuric compound is not limited, and is, for example, 500 to 30,000, preferably 1,500 to 30,000, and more preferably 2,000 to 10,000. The number average molecular weight is defined as a value obtained by ¹⁹F-NMR measurement.

In another embodiment, the number average molecular weight of the polyether chain portion may be 500 to 30,000, preferably 1,000 to 20,000, more preferably 2,000 to 15,000, and still more preferably 2,000 to 10,000, for example, 3,000 to 6,000.

In another embodiment, the number average molecular weight of the polyether chain portion may be 4,000 to 30,000, preferably 5,000 to 10,000, and more preferably 6,000 to 10,000.
R¹ is preferably a monovalent organic group represented by the formula:

   R³-(OR²)ₐ-L-

   wherein (OR²)ₐ is the polyether chain described above;
R³ is an alkyl group or a fluorinated alkyl group; and
L is a single bond or a divalent linking group.
R^{1'} is preferably a monovalent organic group represented by the formula:

   -L'-(OR²)ₐ-L-

   wherein (OR²)ₐ is the polyether chain;
L is independently a single bond or a divalent linking group;
L' is independently a single bond or a divalent linking group; and
L is bonded to the right isocyanuric ring of formula (α2), and L' is bonded to the left isocyanuric ring.

The carbon number of R³ is preferably 1 to 16, and preferably 1 to 8.

R³ may be linear or branched, and is preferably a linear or branched alkyl group or a fluorinated alkyl group having 1 to 16 carbon atoms, more preferably a linear or branched chain alkyl group or a fluorinated alkyl group having 1 to 8 carbon atoms, and further preferably a linear or branched alkyl group or a fluorinated alkyl group having 1 to 6 carbon atoms, still more preferably a linear or branched alkyl group or a fluorinated alkyl group having 1 to 3 carbon atoms, and particularly preferably a linear alkyl group or a fluorinated alkyl group having 1 to 3 carbon atoms.

R³ is preferably a fluorinated alkyl group having 1 to 16 carbon atoms, more preferably a CF₂H-C₁₋₁₅ fluoroalkylene group or a perfluoroalkyl group having 1 to 16 carbon atoms, and further preferably a perfluoroalkyl group having 1 to 16 carbon atoms.

The perfluoroalkyl group having 1 to 16 carbon atoms may be linear or branched, and is preferably a linear or branched perfluoroalkyl group having 1 to 6 carbon atoms, particularly 1 to 3 carbon atoms, and more preferably a linear perfluoroalkyl group having 1 to 3 carbon atoms; specifically, -CF₃, -CF2CF3 or -CF2CF2CF3.

L is a single bond or a divalent linking group directly bonded to the isocyanuric ring of formula (α1). L is preferably a single bond, an alkylene group, or a divalent group containing at least one bond selected from the group consisting of an ether bond and an ester bond, and more preferably a single bond, an alkylene group having 1 to 10 carbon atoms, or a divalent hydrocarbon group having 1 to 10 carbon atoms and containing at least one bond selected from the group consisting of an ether bond and an ester bond.

L is further preferably a group represented by the formula:

- (CX¹²¹X¹²²)ₒ-(L¹)ₚ-(CX¹²³X¹²⁴)_{q}-

wherein X¹²¹ to X¹²⁴ are each independently H, F, OH, or - OSi (OR¹²⁵)₃ wherein three R¹²⁵ are each independently an alkyl group having 1 to 4 carbon atoms;
L¹ is -C(=O)NH-, -NHC(=O)-, -O-, -C(=O)O-, -OC(=O)-, - OC(=O)O-, or -NHC(=O)NH-, in which the left side of each bond is bonded to CX¹²¹X¹²²;
o is an integer of 0 to 10;
p is 0 or 1; and
q is an integer of 1 to 10.
L' is further preferably a group represented by the formula:

   - (CX¹²⁶X¹²⁷)ᵣ-(CX¹²¹X¹²²)ₒ-(L¹)ₚ-(CX¹²³X¹²⁴)_{q}-

   wherein X¹²¹ to X¹²⁴, L¹, o, p, and q have the same meanings as defined in L;
X¹²⁶ and X¹²⁷ are each independently H, F or Cl, and preferably F;
r is an integer of 1 to 6; and
-(CX¹²⁶X¹²⁷)ᵣ- is bonded to (OR²)ₐ and (CX¹²³X¹²⁴)_{q} is bonded to the isocyanuric ring.
L¹ is preferably -O- or -C(=O)O-.
L is particularly preferably: a group represented by the formula:

   - (CF₂)ₘ₁₁-(CH₂)ₘ₁₂-O-(CH₂)ₘ₁₃-

   wherein m11 is an integer of 1 to 3, m12 is an integer of 1 to 3, and m13 is an integer of 1 to 3;
   a group represented by the formula:

      - (CF₂)ₘ₁₄-(CH₂)ₘ₁₅-O-CH₂CH(OH)-(CH₂)ₘ₁₆-
   wherein m14 is an integer of 1 to 3, m15 is an integer of 1 to 3, and ml6 is an integer of 1 to 3;
   a group represented by the formula:

      - (CF₂)ₘ₁₇-(CH₂)ₘ₁₈-
   wherein m17 is an integer of 1 to 3 and m18 is an integer of 1 to 3; or
   a group represented by the formula:

      - (CF₂)ₘ₁₉-(CH₂)ₘ₂₀-O-CH₂CH(OSi(OCH₃)₃)-(CH₂)ₘ₂₁-
   wherein m19 is an integer of 1 to 3, m20 is an integer of 1 to 3, and m21 is an integer of 1 to 3.
L is not limited, and specific examples thereof include -C₂H₄-, -C₃H₆-, -C₄H₈-O-CH₂-, -CO-O-CH₂-CH(OH) -CH₂-, - (CF₂)ₙ-, wherein n is an integer of 0 to 4, -CH₂-, -C₄H₈-, - (CF₂)ₙ-(CH₂)ₘ-, wherein n, m are each independently an integer of 0 to 4, -CF₂CF₂CH₂OCH₂CH(OH)CH₂-, and - CF₂CF₂CH₂OCH₂CH(OSi(OCH₃)₃)CH₂-.
X¹ is a monovalent silane-containing reactive crosslinkable group.

The silane-containing reactive crosslinkable group contributes to the adhesiveness with a base material. The crosslinkable group may chemically react with a material of the base material.

In one embodiment, the silane-containing reactive crosslinkable group is preferably a group represented by the formula:

-L²-{Si(R^{a})ₛ(R^{b})ₜ(R^{c})ᵤ(R^{d})ᵥ}ₙ

wherein L² is a single bond or a divalent linking group;
R^{a}, R^{b} and R^{c} are the same or different and are each hydrogen, halogen, an alkoxy group having 1 to 10 carbon atoms, an amino group having 1 to 10 carbon atoms, an acetoxy group having 1 to 10 carbon atoms, an allyl group having 3 to 10 carbon atoms, or a glycidyl group having 3 to 10 carbon atoms;
R^{d} is the same or different and is -O-, -NH-, -C---C-, or a silane bond;
s, t and u are the same or different and are each 0 or 1, v is an integer of 0 to 3, and n is an integer of 1 to 20; in a case where n is 1, s+t+u is 3 and v is 0; and in a case where n is 2 to 20, s+t+u is the same or different and is 0 to 2, and v is the same or different and is 0 to 2, and in a case where v is an integer of 1 or more, at least two Si atoms are bonded to each other via R^{d} in a linear, ladder, cyclic, or polycyclic form.
R^{a}, R^{b} and R^{c} are monovalent groups bonded to a Si atom. R^{d} is a divalent group bonded to two Si atoms.
R^{a}, R^{b} and R^{c} are the same or different and at least one of them is preferably hydrogen, halogen, an alkoxy group having 1 to 10 carbon atoms, or an amino group having 1 to 10 carbon atoms, and the others are each preferably an acetoxy group having 1 to 10 carbon atoms, an allyl group having 3 to 10 carbon atoms, or a glycidyl group having 3 to 10 carbon atoms, and further preferably an alkoxy group having 1 to 4 carbon atoms. In a case where n is 2 to 20, s+t+u is the same or different and is preferably 0 to 2, and v is preferably 0 to 2.

In R^{a}, R^{b} and R^{c}, the halogen is preferably Cl, Br or I, and more preferably Cl.

In R^{a}, R^{b} and R^{c}, the number of carbon atoms of the alkoxy group is preferably 1 to 5. The alkoxy group may be linear, cyclic or branched. Hydrogen atoms thereof are optionally substituted with a fluorine atom or the like. The alkoxy group is preferably a methoxy group, an ethoxy group, a propoxy group or a butoxy group, and more preferably a methoxy group or an ethoxy group.

R^{d} is the same or different and is -O-, -NH-, -C≡C-, or a silane bond. R^{d} is preferably -O-, -NH-, or -C≡C-. R^{d} is a divalent group bonded to two Si atoms, and two or more silicon atoms may be bonded to each other via R^{d} in a linear, ladder, cyclic, or polycyclic form. In a case where n is an integer of 2 or more, silicon atoms may be bonded to each other.

In one embodiment, X¹ is a silane-containing reactive crosslinkable group represented by the formula:

-L²-{Si(Rₐ)ₛ(R^{b})ₜ(R^{c})ᵤ(R^{d}')ᵥ}ₙ

wherein L² is a single bond or a divalent linking group;
R^{a}, R^{b} and R^{c} are the same or different and are each hydrogen, halogen, an alkoxy group having 1 to 10 carbon atoms, an amino group having 1 to 10 carbon atoms, an acetoxy group having 1 to 10 carbon atoms, an allyl group having 3 to 10 carbon atoms, or a glycidyl group having 3 to 10 carbon atoms;
R^{d}' are the same or different, and is a group represented by -Z-SiR^{d1'}_{p'}R^{d2'}_{q'}R^{d3'}_{r'} wherein Z is the same or different and is a single bond or a divalent linking group;
R^{d1'} is the same or different and is R^{d"};
R^{d"} have the same meaning as R^{d'};
the number of Si atoms linearly linked via a Z group in R^{d'} is at most 5;
R^{d2'} is the same or different and is a hydroxyl group or a hydrolyzable group;
R^{d3'} is the same or different and is a hydrogen atom or a lower alkyl group;
p' is the same or different and is an integer of 0 to 3;
q' is the same or different and is an integer of 0 to 3; and
r' is the same or different and is an integer of 0 to 3;
provided that the sum of p', q' and r' is 3;
s, t and u are the same or different and are each 0 or 1;
v is an integer of 0 to 3; and
n is an integer of 1 to 20.

In the formula, Z is the same or different and represents a single bond or a divalent linking group.

Specific examples of Z include -C₂H₄-, -C₃H₆-, -CO-O-CH₂-CH(OH)-CH₂-, -CH₂-, and -C₄H₈-.

In the formula, R^{d1} is the same or different and represents R^{d"}. R^{d"} has the same meaning as R^{d'}.

The number of Si atoms linearly linked via a Z group in R^{d'} is at most 5. That is, in the case where at least one R^{d1'} is present in R^{d'}, two or more Si atoms linearly linked via a Z group are present in R^{d'}, and the number of such Si atoms linearly linked via a Z group is at most 5. Herein, "the number of Si atoms linearly linked via a Z group in R^{d'} is equal to the number of repeating units -Z-Si- linearly linked in R^{d'}.

One example is represented below, where Si atoms are linked via a Z group in R^{d'}.

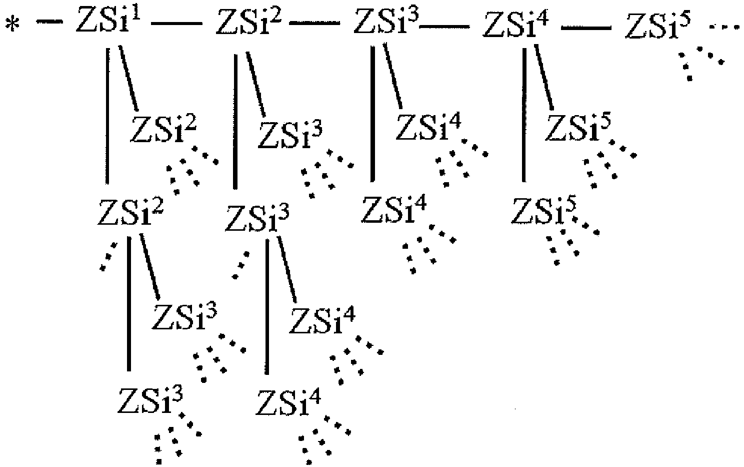

In the formula, "*" means a site bonded to Si in a main chain, and "···" means that a predetermined group other than ZSi is bonded, namely, "···" means a position at which repeating of ZSi is terminated in the case where all three bonds of a Si atom are "···". The superscript number in Si means the number of occurrence of Si linearly linked via a Z group when counted from "*". That is, a chain where repeating of ZSi is terminated at Si² is a chain where the "number of Si atoms linearly linked via a Z group in R^{d'}" is 2, and similarly, respective chains where repeating of ZSi is terminated at Si³, Si⁴ and Si⁵ mean respective chains where the "number of Si atoms linearly linked via a Z group in R^{d'}" is 3, 4 and 5. As clear from the formula, a plurality of ZSi chains are present in R^{d'}, and all the chains do not necessarily have the same length and, may each have any length.

In a preferable embodiment, the "number of Si atoms linearly linked via a Z group in R^{d'}" is 1 (left formula) or 2 (right formula) in all chains, as represented below.

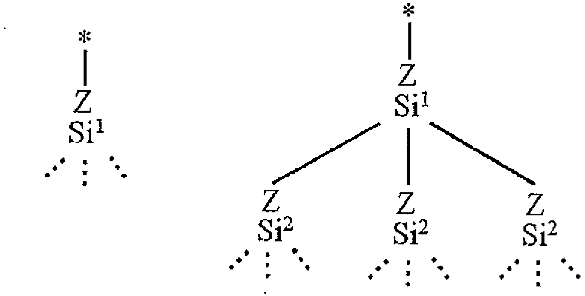

In one embodiment, the number of Si atoms linearly linked via a Z group in R^{d'} is 1 or 2, preferably 1.

In the formula, R^{d2'} is the same or different and represents a hydroxyl group or a hydrolyzable group. The hydroxyl group is not limited, and for example, may be generated by hydrolyzing the hydrolyzable group.

Preferably, R^{d2'} is -OR, wherein R represents a substituted or unsubstituted C₁₋₃ alkyl group, and more preferably a methyl group.

In the formula, R^{d3'} is the same or different and represents a hydrogen atom or a lower alkyl group. The lower alkyl group is preferably an alkyl group having 1 to 20 carbon atoms, more preferably an alkyl group having 1 to 5 carbon atoms, further preferably a methyl group.

In the formula, p' is the same or different and is an integer of 0 to 3; q' is the same or different and is an integer of 0 to 3; and r' is the same or different and is an integer of 0 to 3, provided that the sum of p', q' and r' is 3.

In a preferable embodiment, q' in R^{d'} (R^{d} in the case where no R^{d'} is present) at an end of R^{d} is preferably 2 or more, for example, 2 or 3, more preferably 3.

In a preferable embodiment, R^{d} may have at least one - Si(-Z-SiR^{d2'}_{q'}R^{d3'}_{r'})₂ or -Si(-Z-SiR^{d2'}_{q'}R^{d3'}_{r'})₃ at an end, preferably -Si(-Z-SiR^{d2'}_{q'}R^{d3'}_{r'})₃. In such a formula, a (-Z-SiR^{d2'}_{q'}R^{d3'}_{r'}) unit is preferably (-Z-SiR^{d2'}₃). In a further preferable embodiment, all ends of R^{d} may be each preferably -Si (-Z-SiR^{d2'}_{q'}R^{d3'}_{r'})₃, more preferably -Si(-Z-SiR^{d2'}₃)₃. The adhesion to the base material increases as the number of R^{d2'} bonded to each Si at the ends increases, and excellent durability can be obtained.

In a preferable embodiment, in the formulae, the number of Si atoms having a hydroxyl group or a hydrolyzable group may be preferably 1 to 6, more preferably 2 to 4, and further preferably 3 in formula (α1), and may be preferably 2 to 12, more preferably 4 to 8, and further preferably 6 in formula (α2).

In a preferable embodiment, v is 3 and each R^{d} is independently -Z-SiR^{d2'}_{q'}R^{d3'}_{r'}.

L² is a single bond or a divalent linking group directly bonded to the ring of formula (α1) or formula (α2). L² is preferably a single bond, an alkylene group, or a divalent group containing at least one bond selected from the group consisting of an ether bond and an ester bond, and more preferably a single bond, an alkylene group having 1 to 10 carbon atoms, or a divalent hydrocarbon group having 1 to 10 carbon atoms and containing at least one bond selected from the group consisting of an ether bond and an ester bond.

Specific examples of L² include -C₂H₄-, -C₃H₆-, -C₄H₈-O-CH₂-, -CO-O-CH₂-CH(OH)-CH₂-, -CH₂-, and -C₄H₈-.

Examples of the silane-containing reactive crosslinkable group include -L²-SiR⁵₃, -L²-Si(OR⁶)₃, -L²-Si(NR⁶₂)₃, and -L²-Si(OCOR⁶)₃, wherein L² is as described above, R⁵ is a halogen atom, and R⁶ is independently an alkyl group having 1 to 4 carbon atoms.

In one embodiment, the silane-containing reactive crosslinkable group is preferably a group represented by the formula:

-L⁶-{C(R^{a6})ₛ₆(R^{b6})ₜ₆(R^{c6})ᵤ₆(R^{d6})ᵥ₆}ₙ₆

wherein L⁶ is a single bond or a divalent linking group;
R^{a6}, R^{b6} and R^{c6} are the same or different and are each hydrogen, halogen, an alkoxy group having 1 to 10 carbon atoms, an amino group having 1 to 10 carbon atoms, an acetoxy group having 1 to 10 carbon atoms, an allyl group having 3 to 10 carbon atoms, a glycidyl group having 3 to 10 carbon atoms, OCOR⁶⁷, wherein R⁶⁷ is an alkyl group having 1 to 6 carbon atoms, OH or -Y⁶-SiR⁶⁵ⱼ₆R⁶⁶₃₋ⱼ₆;
R^{d6} is the same or different and is -O-, -NH-, -C=C-, or -Z⁶-CR⁶¹ₚ₆R⁶²_{q6}R⁶³ᵣ₆;
Z⁶ is the same or different and is an oxygen atom or a divalent organic group;
In the formula, R⁶¹ is the same or different and represents R^{d6'};
R^{d6}' has the same meaning as R^{d6};
the number of C atoms linearly linked via a Z⁶ group in R^{d6} is at most 5;
R⁶² is the same or different and is -Y⁶-SiR⁶⁵ⱼ₆R⁶⁶₃₋ⱼ₆;
Y⁶ is the same or different and is a divalent organic group;
R⁶⁵ is the same or different and is a hydroxyl group or a hydrolyzable group;
R⁶⁶ is the same or different and is a hydrogen atom or a lower alkyl group;
j6 with respect to each (-Y⁶-SiR⁶⁵ⱼ₆R⁶⁶₃₋ⱼ₆) unit is independently an integer of 1 to 3;
R⁶³ is the same or different and is a hydrogen atom or a lower alkyl group;
p6 is the same or different and is an integer of 0 to 3;
q6 is the same or different and is an integer of 0 to 3;
r6 is the same or different and is an integer of 0 to 3; and
s6, t6 and u6 are the same or different and are each 0 or 1, v6 is an integer of 0 to 3, and n6 is an integer of 1 to 20,
provided that in the formula, at least two -Y⁶-SiR⁶⁵ⱼ₆R⁶⁶₃₋ⱼ₆ are present.

L⁶ is a single bond or a divalent linking group directly bonded to the ring of formula (α1) or formula (α2). L⁶ is preferably a single bond, an alkylene group, or a divalent group containing at least one bond selected from the group consisting of an ether bond and an ester bond, and more preferably a single bond, an alkylene group having 1 to 10 carbon atoms, or a divalent hydrocarbon group having 1 to 10 carbon atoms and containing at least one bond selected from the group consisting of an ether bond and an ester bond.

Specific examples of L⁶ include -C₂H₄-, -C₃H₆-, -C₄H₈-O-CH₂-, -CO-O-CH₂-CH(OH)-CH₂-, -CH₂-, and -C₄H₈-.

In R^{a}, R^{b}, R^{c}, R^{a6}, R^{b6} and R^{c6}, the halogen is preferably Cl, Br or I, and more preferably Cl.

In R^{a}, R^{b}, R^{c}, R^{a6}, R^{b6} and R^{c6}, the number of carbon atoms of the alkoxy group is preferably 1 to 5. The alkoxy group may be linear, cyclic or branched. Hydrogen atoms thereof are optionally substituted with a fluorine atom or the like. The alkoxy group is preferably a methoxy group, an ethoxy group, a propoxy group or a butoxy group, and more preferably a methoxy group or an ethoxy group.

Z⁶ is preferably a C₁₋₆ alkylene group, - (CH₂)_{g}-O-(CH₂)ₕ-, wherein g is an integer of 0 to 6, for example, an integer of 1 to 6, and h is an integer of 0 to 6, for example, an integer of 1 to 6, or -phenylene- (CH₂)ᵢ-, wherein i is an integer of 0 to 6, and more preferably a C₁₋₃ alkylene group. Such a group is optionally substituted with one or more substituents selected from, for example, a fluorine atom, a C₁₋₆ alkyl group, a C₂₋₆ alkenyl group, and a C₂₋₆ alkynyl group.

In the formulae, each R⁶¹, at each occurrence, independently represents R^{d6'}. R^{d6}' has the same meaning as R^{d6}.

The number of C atoms linearly linked via a Z⁶ group in R^{d6} is at most 5. That is, in the case where at least one R⁶¹ is present in R^{d6}, two or more Si atoms linearly linked via a Z⁶ group are present in R^{d6}, and the number of such C atoms linearly linked via a Z⁶ group is at most 5. Herein, the "number of C atoms linearly linked via a Z⁶ group in R^{d6}" is equal to the number of repeating units -Z⁶-C- linearly linked in R^{d6}.

In a preferable embodiment, the "number of C atoms linearly linked via a Z⁶ group in R^{d6}" is 1 (left formula) or 2 (right formula) in all chains, as represented below.

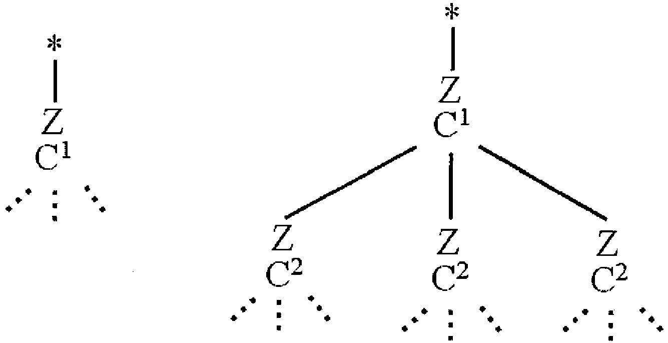

In one embodiment, the number of C atoms linearly linked via a Z⁶ group in R^{d6} is 1 or 2, preferably 1.

In the formula, R⁶² represents -Y⁶-SiR⁶⁵ⱼ₆R⁶⁶₃₋ⱼ₆.

Each Y⁶, at each occurrence, independently represents a divalent organic group.

In a preferable embodiment, Y⁶ is a C₁₋₆ alkylene group, -(CH₂)_{g'}-O-(CH₂)_{h'}-, wherein g' is an integer of 0 to 6, for example, an integer of 1 to 6, and h' is an integer of 0 to 6, for example, an integer of 1 to 6, or -phenylene-(CH₂)_{i'}-, wherein i' is an integer of 0 to 6. Such a group is optionally substituted with one or more substituents selected from, for example, a fluorine atom, a C₁₋₆ alkyl group, a C₂₋₆ alkenyl group, and a C₂₋₆ alkynyl group.

In one embodiment, Y⁶ may be a C₁₋₆ alkylene group or - phenylene-(CH₂)_{i'}-. In the case where Y is any of the groups as described above, light resistance, in particular, ultraviolet resistance can be more enhanced.

Each R⁶⁵, at each occurrence, independently represents a hydroxyl group or a hydrolyzable group. Examples of the "hydrolyzable group" are the same as those mentioned above.

Preferably, R⁶⁵ is -OR, wherein R represents a substituted or unsubstituted C₁₋₃ alkyl group, more preferably an ethyl group or a methyl group, in particular, a methyl group.

Each R⁶⁶, at each occurrence, independently represents a hydrogen atom or a lower alkyl group. The lower alkyl group is preferably an alkyl group having 1 to 20 carbon atoms, more preferably an alkyl group having 1 to 6 carbon atoms, further preferably a methyl group.

j6 with respect to a (-Y-SiR⁶⁵ⱼ₆R⁶⁶₃₋ⱼ₆) unit independently represents an integer of 1 to 3, preferably 2 or 3, more preferably 3.

Each R⁶³, at each occurrence, independently represents a hydrogen atom or a lower alkyl group. The lower alkyl group is preferably an alkyl group having 1 to 20 carbon atoms, more preferably an alkyl group having 1 to 5 carbon atoms, further preferably a methyl group.

In the formulae, each p6, at each occurrence, is independently an integer of 0 to 3; each q6, at each occurrence, is independently an integer of 0 to 3; and each r6, at each occurrence, is independently an integer of 0 to 3, provided that the sum of p6, q6 and r6 is 3.

In a preferable embodiment, q6 in R^{d6}' (R^{d6} itself in the case where no R^{d6}' is present) at an end of R^{d6} is preferably 2 or more, for example, 2 or 3, more preferably 3.

In one embodiment, X¹ is a group represented by the formula:
- L²-{Si(R^{a})ₛ(R^{b})ₜ(R^{c})ᵤ(R^{d})ᵥ}ₙ, or
- L⁶-{C(R^{a6})ₛ₆(R^{b6})ₜ₆(R^{c6})ᵤ₆(R^{d6})ᵥ₆}ₙ₆
wherein each symbol has the same meaning as described above.

In one embodiment, X² may be independently a monovalent organic group containing the polyether chain. Groups suitable for the organic groups are the same as for R¹.

In another embodiment, X² may be independently the silane-containing reactive crosslinkable group.

In another embodiment, X² may be independently at least one group selected from the group consisting of a silicone residue, a silsesquioxane residue and a silazane group.

Examples of the silicone residue include the following groups:

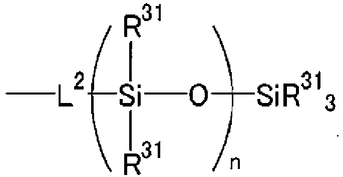

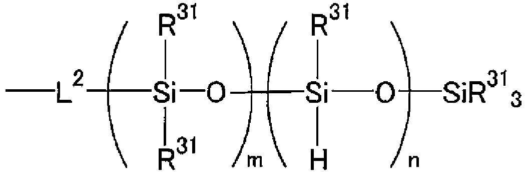

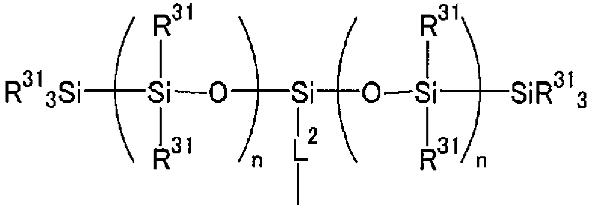

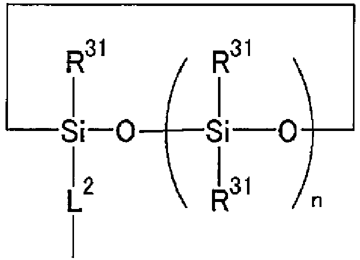

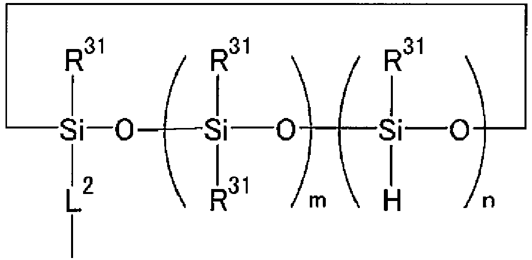

In each formula, L² is a single bond or a divalent linking group, n is an integer of 1 to 20, m is an integer of 0 to 10, each R³¹ is independently a monovalent group, and at least one of R³¹ contained in each group is a reactive group.

Each of the plurality of R³¹ contained in each group is independently a monovalent group, and may be the reactive group or a group other than the reactive group, provided that at least one of the plurality of R³¹ contained in each group is the reactive group.

The reactive group is preferably at least one selected from the group consisting of H, a halogen atom, -OR³² where R³² is an alkyl group having 1 to 4 carbon atoms or an aryl group having 6 to 20 carbon atoms, -L³-SiR⁵₃ where L³ is a single bond or an alkylene group having 1 to 10 carbon atoms, and R⁵ is a halogen atom, -L³-Si(OR⁶)₃ where L³ is as described above, R⁶ is independently an alkyl group having 1 to 4 carbon atoms, -L³-Si(NR⁶₂)₃ where L³ and R⁶ are as described above, -L³-Si(OCOR⁶)₃ where L³ and R⁶ are as described above, and a group containing any of these groups.

The group other than the reactive group is preferably at least one selected from the group consisting of an alkyl group, a halogenated alkyl group, an alkyl ester group, a halogenated alkyl ester group, an alkyl ether group, a halogenated alkyl ether group, an alkylamide group, a halogenated alkylamide group, an uril group, a halogenated uril group, a urea group, a halogenated urea group, - CONR^{k}COR^{l} where R^{k} and R^{l} are each independently H, an alkyl group or a halogenated alkyl group, a group containing a sugar chain, an alkylene polyether group, an arene group, a halogenated arene group, a group containing a heterocycle, an aryl group, and a halogenated aryl group.

L² is a single bond or a divalent linking group directly bonded to the ring of formula (α1) or formula (α2). Groups suitable for L² are as described above.

Examples of the silicone residue further include the following groups:

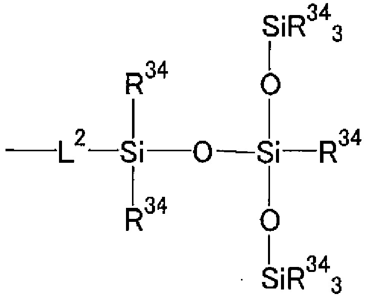

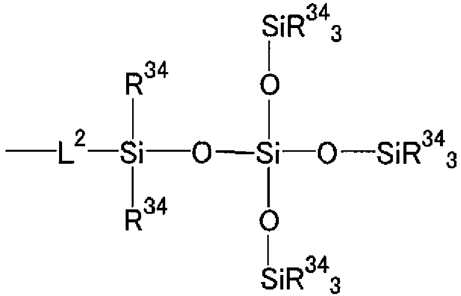

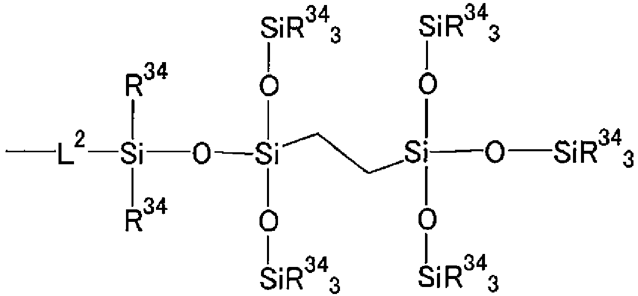

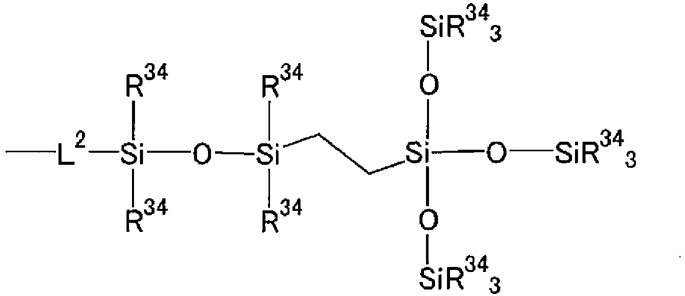

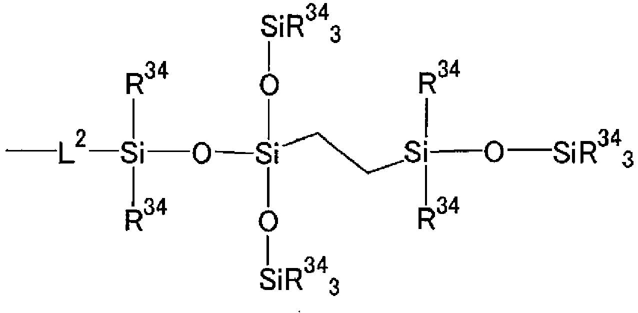

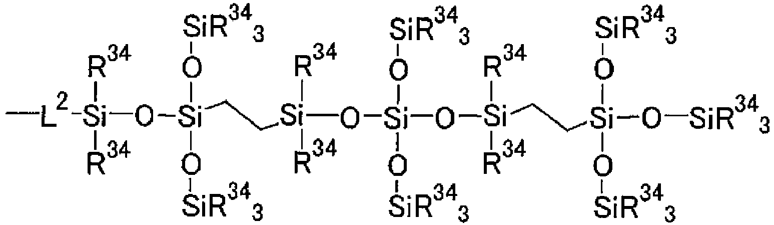

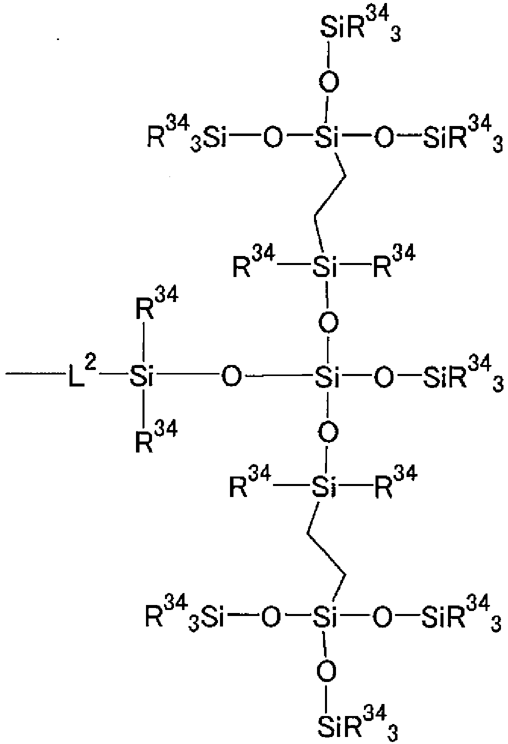

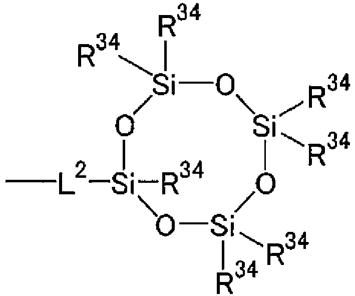

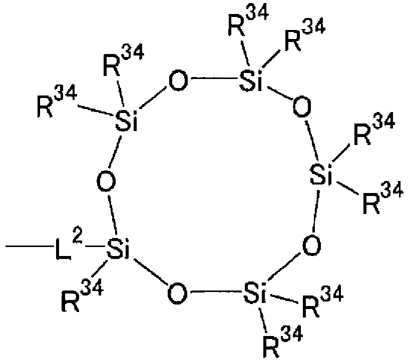

In each formula, L² is a single bond or a divalent linking group, R³⁴ is independently a monovalent group, and at least one of R³⁴ contained in each group is a reactive group.

Each of the plurality of R³⁴ contained in each group is independently a monovalent group, and may be the reactive group or a group other than the reactive group, provided that at least one of the plurality of R³⁴ contained in each group is the reactive group.

The reactive group is preferably at least one selected from the group consisting of -H, -OR³⁵ where R³⁵ is an alkyl group having 1 to 4 carbon atoms, a halogen atom, -OH, -O-CR³⁵=CH₂ where R³⁵ is as described above, -OCOR³⁵ where R³⁵ is as described above, -OCOOR^{j} where R^{j} is an alkyl group or a halogenated alkyl group, -NR³⁵₂ where R³⁵ is as described above, and a group containing any of these groups.

The group other than the reactive group is preferably at least one selected from the group consisting of an alkyl group, a halogenated alkyl group, an alkyl ester group, a halogenated alkyl ester group, an alkyl ether group, a halogenated alkyl ether group, an alkylamide group, a halogenated alkylamide group, an uril group, a halogenated uril group, a urea group, a halogenated urea group, - CONR^{k}COR^{l} where R^{k} and R^{l} are each independently H, an alkyl group or a halogenated alkyl group, a group containing a sugar chain, an alkylene polyether group, an arene group, a halogenated arene group, a group containing a heterocycle, an aryl group, and a halogenated aryl group.

L² is a single bond or a divalent linking group directly bonded to the ring of formula (α1) or formula (α2). Groups suitable for L² are as described above.

Examples of the silsesquioxane residue include the following groups:

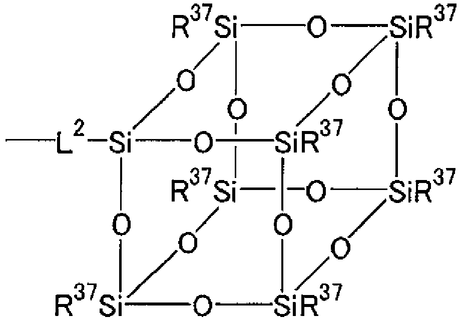

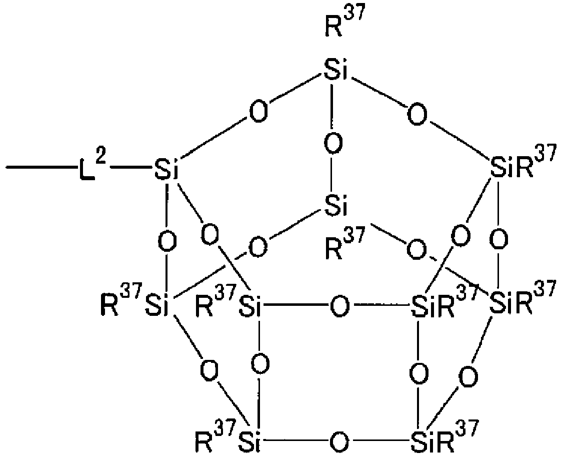

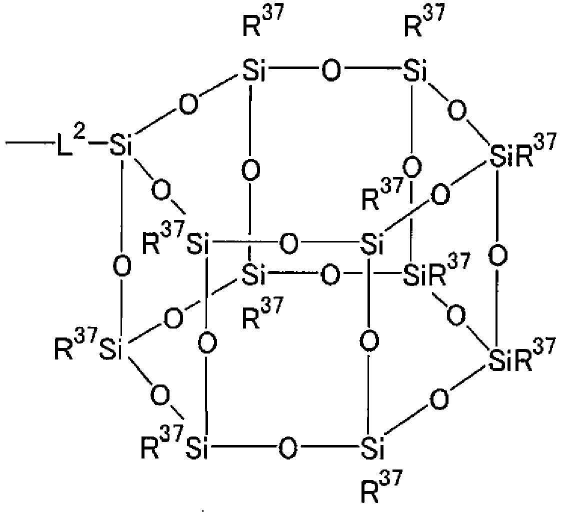

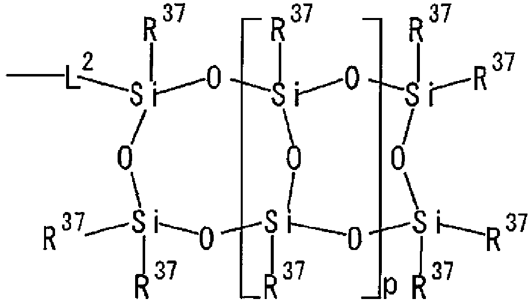

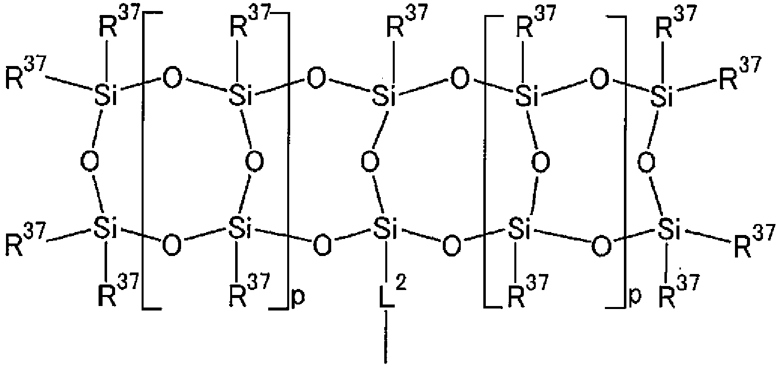

In each formula, L² is a single bond or a divalent linking group, R³⁷ is independently a monovalent group, at least one of R³⁷ contained in each group is a reactive group, and each p is independently an integer of 0 to 5000.

Each of the plurality of R³⁷ contained in each group is independently a monovalent group, and may be the reactive group or a group other than the reactive group, provided that at least one of the plurality of R³⁷ contained in each group is the reactive group.

The reactive group is preferably at least one selected from the group consisting of -H, -OR³⁵ where R³⁵ is an alkyl group having 1 to 4 carbon atoms, a halogen atom, -OH, -O-CR³⁵=CH₂ where R³⁵ is as described above, -OCOR³⁵ where R³⁵ is as described above, -OCOOR^{j} where R^{j} is an alkyl group or a halogenated alkyl group, -NR³⁵₂ where R³⁵ is as described above, and a group containing any of these groups.

The group other than the reactive group is preferably at least one selected from the group consisting of an alkyl group, a halogenated alkyl group, an alkyl ester group, a halogenated alkyl ester group, an alkyl ether group, a halogenated alkyl ether group, an alkylamide group, a halogenated alkylamide group, an uril group, a halogenated uril group, a urea group, a halogenated urea group, - CONR^{k}COR^{l} where R^{k} and R^{l} are each independently H, an alkyl group or a halogenated alkyl group, a group containing a sugar chain, an alkylene polyether group, an arene group, a halogenated arene group, a group containing a heterocycle, an aryl group, and a halogenated aryl group.

L² is a single bond or a divalent linking group directly bonded to the ring of formula (α1) or formula (α2). Groups suitable for L² are as described above.

X² may be a group different from the monovalent organic group containing a polyether chain, the silane-containing reactive crosslinkable group, the silicone residue, the silsesquioxane residue and the silazane group described above.

That is, X² may be independently at least one selected from the group consisting of H, an alkyl group, a halogenated alkyl group, an alkyl ester group, a halogenated alkyl ester group, an alkyl ether group, a halogenated alkyl ether group, an alkylamide group, a halogenated alkylamide group, an uril group, a halogenated uril group, a urea group, a halogenated urea group, -OCOOR^{j} where R^{j} is an alkyl group or a halogenated alkyl group, -CONR^{k}COR^{l} where R^{k} and R^{l} are each independently H, an alkyl group or a halogenated alkyl group, a group containing a sugar chain, an alkylene polyether group, an arene group, a halogenated arene group, a group containing a heterocycle, an aryl group, a halogenated aryl group, a silicone residue (excluding those having a reactive group), and a silsesquioxane residue (excluding those having a reactive group).

Examples of the silicone residue (excluding those having a reactive group) include the following groups, provided that the reactive group herein refers to any of the reactive groups exemplified as those that can constitute R³⁷:

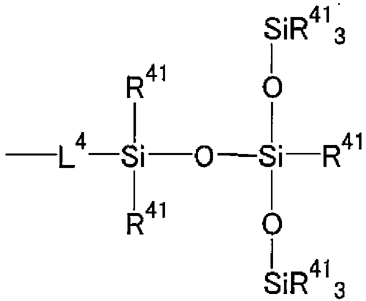

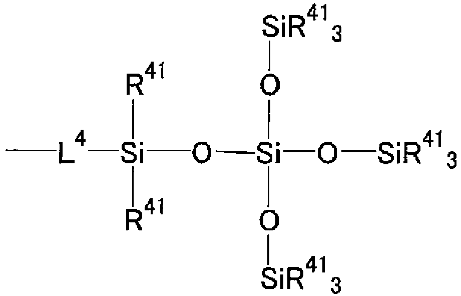

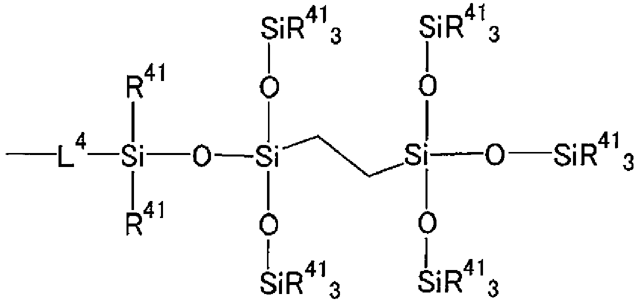

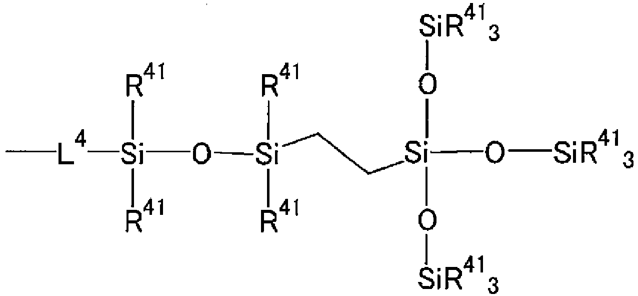

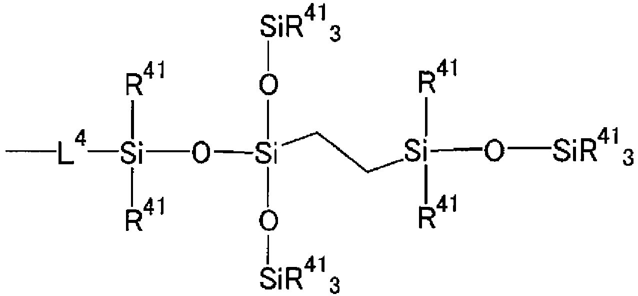

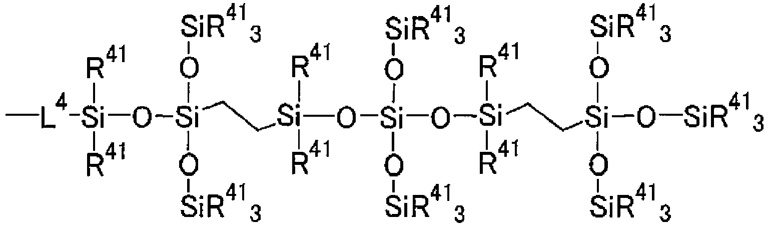

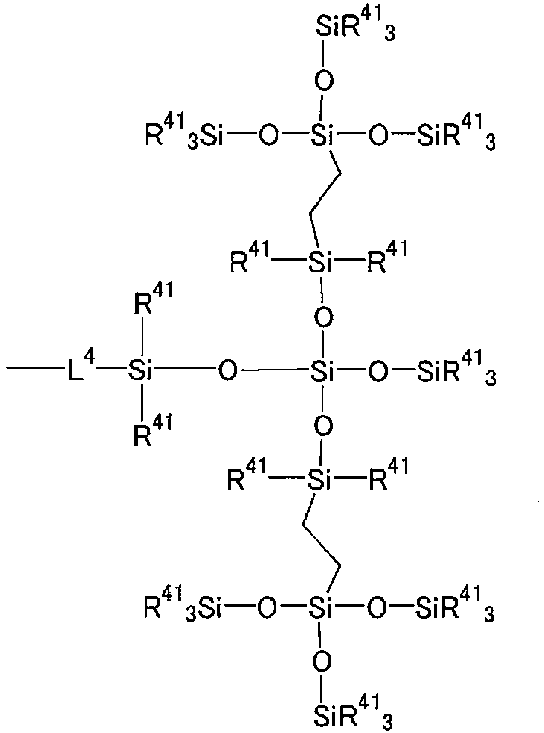

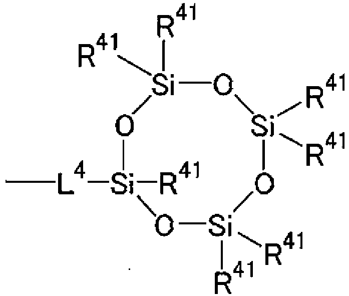

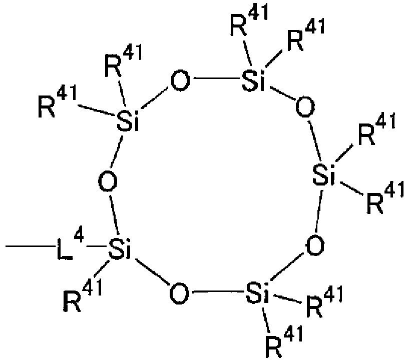

In each formula, L⁴ is a single bond or a divalent linking group, and each R⁴¹ is independently a monovalent group other than the reactive group.

The group other than the reactive group is preferably at least one selected from the group consisting of an alkyl group, a halogenated alkyl group, an alkyl ester group, a halogenated alkyl ester group, an alkyl ether group, a halogenated alkyl ether group, an alkylamide group, a halogenated alkylamide group, an uril group, a halogenated uril group, a urea group, a halogenated urea group, - CONR^{k}COR^{l} where R^{k} and R^{l} are each independently H, an alkyl group or a halogenated alkyl group, a group containing a sugar chain, an alkylene polyether group, an arene group, a halogenated arene group, a group containing a heterocycle, an aryl group, and a halogenated aryl group.

L⁴ is a single bond or a divalent linking group directly bonded to the ring of formula (α1) or formula (α2). L⁴ is preferably a single bond, an alkylene group, or a divalent group containing at least one bond selected from the group consisting of an ether bond and an ester bond, and more preferably a single bond, an alkylene group having 1 to 10 carbon atoms, or a divalent hydrocarbon group having 1 to 10 carbon atoms and containing at least one bond selected from the group consisting of an ether bond and an ester bond.

Specific examples of L⁴ include -C₂H₄-, -C₃H₆-, -C₄H₈-O-CH₂-, and -CO-O-CH₂-CH(OH)-CH₂.

Examples of the silsesquioxane residue (excluding those having a reactive group) include the following groups, provided that the reactive group herein refers to any of the reactive groups exemplified as those that can constitute R³⁷:

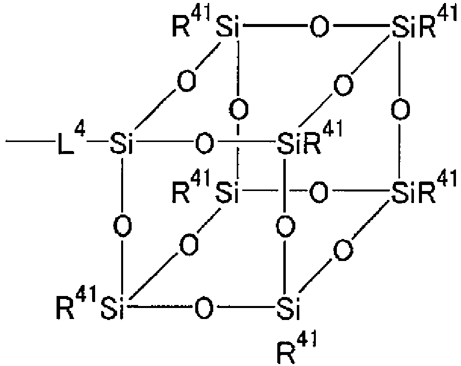

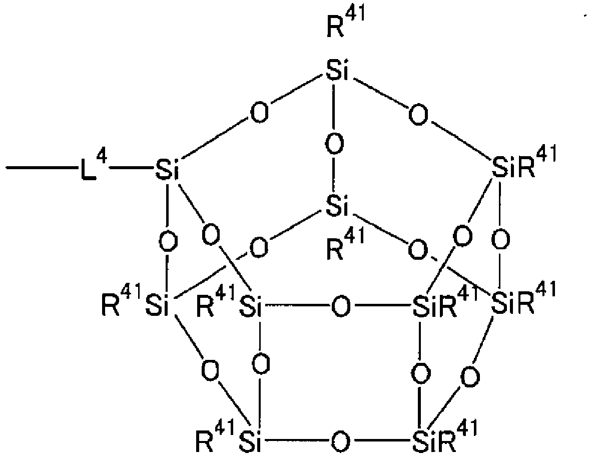

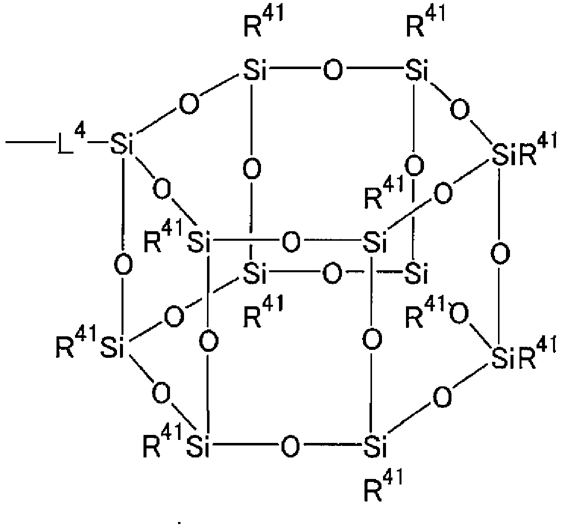

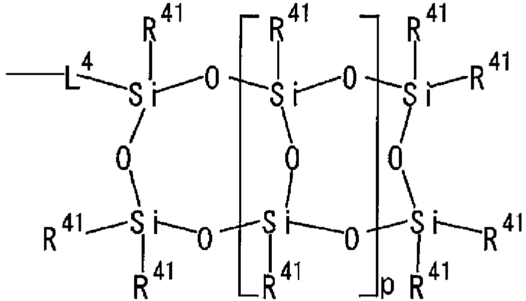

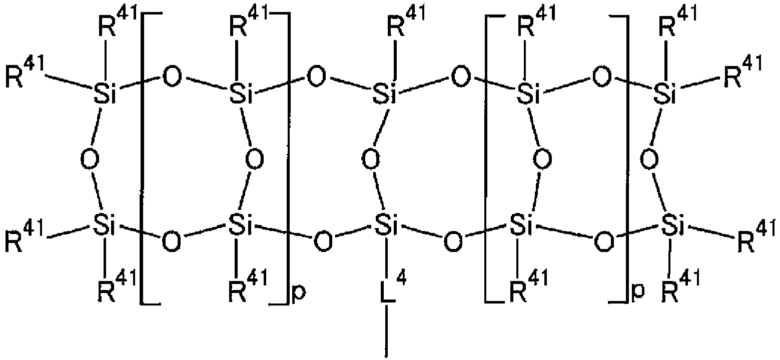

In each formula, L⁴ is a single bond or a divalent linking group, each R⁴¹ is independently a monovalent group other than the reactive group, and each p is an integer of 0 to 5000.

The group other than the reactive group is preferably at least one selected from the group consisting of an alkyl group, a halogenated alkyl group, an alkyl ester group, a halogenated alkyl ester group, an alkyl ether group, a halogenated alkyl ether group, an alkylamide group, a halogenated alkylamide group, an uril group, a halogenated uril group, a urea group, a halogenated urea group,-CONR^{k}COR^{l} where R^{k} and R^{l} are each independently H, an alkyl group or a halogenated alkyl group, a group containing a sugar chain, an alkylene polyether group, an arene group, a halogenated arene group, a group containing a heterocycle, an aryl group, and a halogenated aryl group.

L⁴ is a single bond or a divalent linking group directly bonded to the ring of formula (α1) or formula (α2). Groups suitable for L⁴ are as described above.

Examples of the silazane group include the following groups:

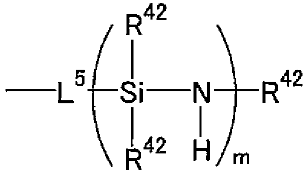

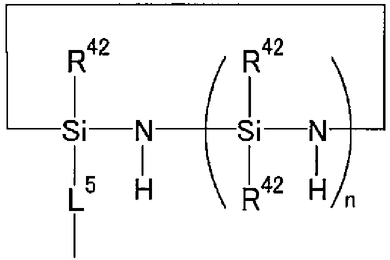

In each formula, L⁵ is a single bond or a divalent linking group, m is an integer of 2 to 100, n is an integer of 100 or less, and each R⁴² is independently H, an alkyl group having 1 to 10 carbon atoms, an alkenyl group, a cycloalkyl group having 5 to 12 carbon atoms, an aryl group having 6 to 10 carbon atoms, an alkylsilyl group, an alkylcyano group, or an alkoxy group having 1 to 4 carbon atoms.

L⁵ is a single bond or a divalent linking group directly bonded to the ring of formula (α1) or formula (α2). L⁵ is preferably a single bond, an alkylene group, or a divalent group containing at least one bond selected from the group consisting of an ether bond and an ester bond, and more preferably a single bond, an alkylene group having 1 to 10 carbon atoms, or a divalent hydrocarbon group having 1 to 10 carbon atoms and containing at least one bond selected from the group consisting of an ether bond and an ester bond.

Specific examples of L⁵ include -C₂H₄-, -C₃H₆-, -C₄H_{B}-O-CH₂-, and -CO-O-CH₂-CH(OH)-CH₂.

Specific examples of the silazane group include the following groups:

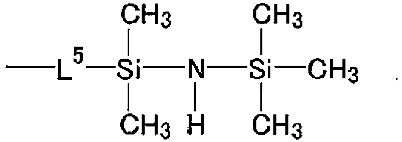

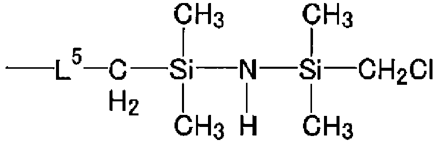

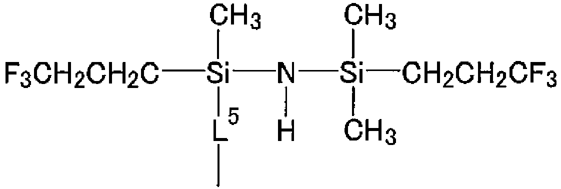

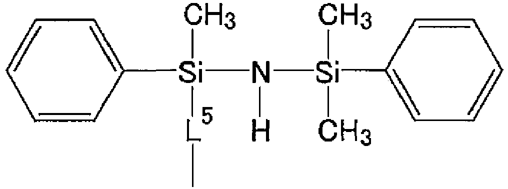

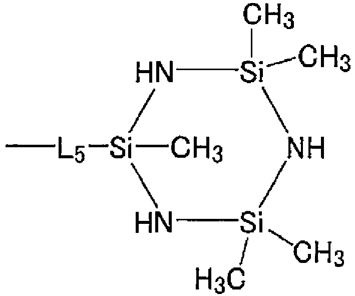

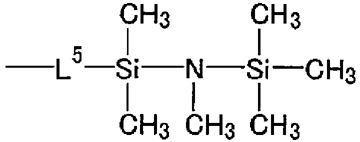

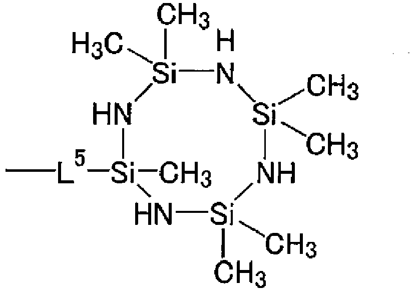

The number average molecular weight of R¹ in the compounds is not limited, and is 500 to 30,000, preferably 1,500 to 30,000, more preferably 2,000 to 10,000.

The compound may have an average molecular weight of 5×10² to 1×10⁵, without any limitation. In particular, the compound preferably has an average molecular weight of 2,000 to 30,000, more preferably 2,500 to 12,000, from the viewpoint of UV resistance and friction durability. In the present disclosure, the "average molecular weight" refers to the number average molecular weight, and the "average molecular weight" is defined as a value obtained by ¹⁹F-NMR measurement.

In one embodiment, the compound α is a compound represented by formula (α1).

In another embodiment, the compound α may be a mixture of the compound represented by formula (α1) and the compound represented by formula (α2). In the mixture, the compound represented by formula (α1) may be preferably 1 mol% or more, more preferably 10 mol% or more, further preferably 50 mol% or more, still more preferably 80 mol% or more, for example 90 mol% or more, 95 mol% or more or 99 mol% or more, and the upper limit thereof is not limited, and is less than 100 mol%, for example, 99 mol% or less, 95 mol% or less, 90 mol% or less, 85 mol% or less or 80 mol% or less, based on the compound represented by formula (α1) and the compound represented by formula (α2) in total.

In the surface-treating agent of the present disclosure, the compound α is 0.01% by mass to 99.9% by mass, preferably 0.1% by mass to 50% by mass, more preferably 0.1% by mass to 30% by mass, further preferably 0.1% by mass to 20% by mass, for example 1% by mass to 30% by mass or 5% by mass to 20% by mass. In the surface-treating agent of the present disclosure, the compound α may be 100 mol% (that is, including only the compound α), or may be 1 mol% to 99.9 mol%, preferably 10 mol% to 99 mol%, more preferably 30 mol% to 99 mol%, further preferably 50 mol% to 98 mol%, for example 60 mol% to 95 mol%, 70 mol% to 95 mol%, or 80 mol% to 95 mol% based on the component excluding the solvent (including the compound α).

The isocyanuric compound can be produced by the methods described in Patent Literature 1 and 2.

(β) Perfluoropolyether group-containing silane compound having OCF₂ unit (hereinafter, also referred to as "compound β")

The compound β has a perfluoropolyether group having an OCF₂ unit and Si having a hydroxyl group or a hydrolyzable group, provided that the compound β excludes compounds corresponding to the compound α.

In the compound β, the perfluoropolyether group has at least one OCF₂ unit, preferably 5 or more, and more preferably 10 or more.

In one embodiment, the perfluoropolyether group is a group represented by the formula:

- (OC₆F₁₂)ₐ₁-(OC₅F₁₀)_{b1}-(OC₄F₈)_{c1}-(OC₃F₆)_{d1}-(OC₂F₄)ₑ₁-(OCF₂)_{f1}-

wherein a1, b1, c1, d1 and e1 are each independently an integer of 0 or more and 200 or less, f1 is an integer of 1 or more and 200 or less, and the occurrence order of the respective repeating units in parenthesis with a1, b1, c1, d1, e1 or f1, is not limited in the formula.

In a preferable embodiment, a1, b1, c1, d1 and e1 are each independently an integer of 0 or more and 100 or less, and f1 is an integer of 1 or more and 200 or less. Preferably, the sum of a1, b1, c1, d1, e1 and f1 is 5 or more, more preferably 10 or more, for example 10 or more and 100 or less.

The repeating unit in the perfluoropolyether group may be linear or branched, and is preferably linear. For example, - (OC₆F₁₂)- may be - (OCF₂CF₂CF₂CF₂CF₂CF₂)-, - (OCF (CF₃)CF₂CF₂CF₂CF₂)-, - (OCF₂CF(CF₃) CF₂CF₂CF₂)- , - (OCF₂CF₂CF(CF₃)CF₂CF₂)- , - (OCF₂CF₂CF₂CF(CF₃)CF₂)- ,-(OCF₂CF₂CF₂CF₂CF(CF₃)) - or the like, and is preferably - (OCF₂CF₂CF₂CF₂CF₂CF₂)-. For example, - (OC₅F₁₀)- may be - (OCF₂CF₂CF₂CF₂CF₂)-, - (OCF (CF₃)CF₂CF₂CF₂)- , - (OCF₂CF(CF₃)CF₂CF₂)-, -(OCF₂CF₂CF(CF₃)CF₂)-, - (OCF₂CF₂CF₂CF(CF₃)) - or the like, and is preferably - (OCF₂CF₂CF₂CF₂CF₂)-. For example, - (OC₄F₈)- may be any of - (OCF₂CF₂CF₂CF₂)- , - (OCF (CF₃)CF₂CF₂)- , - (OCF₂CF(CF₃)CF₂)- , - (OCF₂CF₂CF(CF₃)) -, - (OC(CF₃)₂CF₂)-, - (OCF₂C(CF₃)₂)-,-(OCF(CF₃)CF(CF₃))-, -(OCF(C₂F₅)CF₂)- and -(4CF₂CF(C₂F₅))-, and is preferably - (OCF₂CF₂CF₂CF₂)-. For example, - (OC₃F₆) - may be any of - (OCF2CF2CF2) -, - (OCF (CF₃)CF₂)- and -(OCF₂CF(CF₃))-, and is preferably - (OCF₂CF₂CF₂)- . For example, - (OC₂F₄)- may be any of - (OCF₂CF₂)- and -(OCF(CF₃))-, and is preferably - (OCF₂CF₂)- .

In another embodiment, each perfluoropolyether group is independently - (OC₄F₈)_{c2}-(OC₃F₆)_{d2}-(OC₂F₄)ₑ₂-(OCF₂)_{f2}-, wherein c2 and d2 are each independently an integer of 0 or more and 30 or less, e2 and f2 are each independently an integer of 1 or more and 200 or less, preferably 5 or more and 200 or less, more preferably 10 or more and 200 or less, and the occurrence order of the respective repeating units in parentheses with the subscript c2, d2, e2 or f2 is not limited in the formulae. Preferably, each perfluoropolyether group is independently - (OCF₂CF₂CF₂CF₂)_{c2}-(OCF₂CF₂CF₂)_{d2}-(OCF₂CF₂)ₑ₂-(OCF₂)_{f}-. In one embodiment, each PFPE may be independently - (OC₂F₄)ₑ₂-(OCF₂)_{f2}-, wherein e2 and f2 are each independently an integer of 1 or more and 200 or less, preferably 5 or more and 200 or less, more preferably 10 or more and 200 or less, and the occurrence order of the respective repeating units in parentheses with the subscript e2 or f2 is not limited in the formulae.

In yet another embodiment, each perfluoropolyether group is independently a group represented by - (R^{10e}-R¹⁰⁷)_{q1}-. In the formula, R¹⁰⁶ is OCF₂. In the formula, R¹⁰⁷ is a group selected from OC₂F₄, OC₃F₆, OC₄F₈, OC₅F₁₀ and OC₆F₁₂, or a combination of two or three groups independently selected from these groups. Preferably, R¹⁰⁷ is a group selected from OC₂F₄, OC₃F₆ and OC₄F₈, or a combination of two or three groups independently selected from these groups. The combination of two or three groups independently selected from OC₂F₄, OC₃F₆ and OC₄F₈ is not limited, and examples thereof include -OC₂F₄OC₃F₆-, -OC₂F₄OC₄F₈-, -OC₃F₆OC₂F₄-, -OC₃F₆OC₃F₆-, - OC₃F₆OC₄F₈-, -OC₄F₈OC₄F₈-, -OC₄F₈OC₃F₆-, -OC₄F₈OC₂F₄-, - OC₂F₄OC₂F₄OC₃F₆-, -OC₂F₄OC₂F₄OC₄F₈-, -OC₂F₄OC₃F₆OC₂F₄-, - OC₂F₄OC₃F₆OC₃F₆-, -OC₂F₄OC₄F₈OC₂F₄-, -OC₃F₆OC₂F₄OC₂F₄-, - OC₃F₆OC₂F₄OC₃F₆-, -OC₃F₆OC₃F₆OC₂F₄-, and -OC₄F₈OC₂F₄OC₂F₄-. q1 is an integer of 2 to 100, and preferably an integer of 2 to 50. In the formula, OC₂F₄, OC₃F₆, OC₄F₈, OC₅F₁₀ and OC₆F₁₂ may be each linear or branched, and are each preferably linear. In this embodiment, preferably, each perfluoropolyether group is independently - (OCF₂-OC₃F₆)_{q1}- or - (OCF₂-OC₄F₃)_{q1}-.

The "hydrolyzable group" in Si having a hydroxyl group or a hydrolyzable group means a group which can be removed from a main backbone of the compound by a hydrolysis reaction. Examples of the hydrolyzable group include -OR, -OCOR, -ON=CR₂, -NR₂, -NHR, and halogen, wherein R represents a substituted or unsubstituted alkyl group having 1 to 4 carbon atoms, and -OR (namely, an alkoxy group) is preferable. Examples of R include unsubstituted alkyl groups such as a methyl group, an ethyl group, a propyl group, an isopropyl group, a n-butyl group and an isobutyl group; and substituted alkyl groups such as a chloromethyl group. Among them, an alkyl group, in particular, an unsubstituted alkyl group is preferable, and a methyl group or an ethyl group is more preferable. The hydroxyl group is not limited, and for example, may be generated by hydrolyzing the hydrolyzable group.

In one embodiment, the compound (β) may be a compound represented by the following formula (A1), (A2), (B1), (B2), (C1), (C2), (D1), (D2), or (E1) :

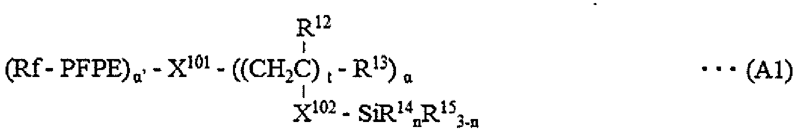

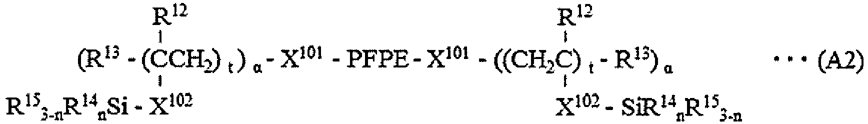

(Rf- PFPE)_{β'}-X¹⁰⁵-(SiR¹⁴ₙR¹⁵₃₋ₙ)_{β} ... (B1)

(R¹⁵₃₋ₙR¹⁴ₙSi)_{β}-X¹⁰⁵-PFPE-X¹⁰⁵-(SiR¹⁴ₙR¹⁵₃₋ₙ)_{β} ··· (B2)

(Rf-PFPE)_{γ'}-X¹⁰⁷-(SiR^{a3}ₖR^{b3}ₗR^{c3}ₘ)_{γ} ··· (C1)

(R^{c3}ₘR^{b3}ₗR^{a3}ₖSi)_{γ}-X¹⁰⁷-PFPE-X¹⁰⁷-(SiR^{a3}ₖR^{b3}₁R^{c3}ₘ)_{γ} ... (C2)

(Rf-PFPE)_{δ'}-X¹⁰⁹-(CR^{d3}_{k'}R^{e3}_{l'}R^{f3}_{m'})_{δ} ··· (D1)

(R^{f3}_{m'}R^{e3}_{l'}R^{d3}_{k'}C)_{δ}-X¹⁰⁹-PFPE-X¹⁰⁹-(CR^{d3}_{k'}R^{e3}_{l'}R^{f3}_{m'})_{δ} ··· (D2)

(Rf-PFPE-G⁵)ₐ₅-Z⁵-((O-R¹⁶)_{c5}-SiR¹⁴ₙR¹⁵₃₋ₙ)_{b5} ··· (E1)

In the above formulae, each Rf independently represents an alkyl group having 1 to 16 carbon atoms optionally substituted with one or more fluorine atoms.

The "alkyl group having 1 to 16 carbon atoms" in the alkyl group having 1 to 16 carbon atoms optionally substituted with one or more fluorine atoms may be linear or branched, and is preferably a linear or branched alkyl group having 1 to 6 carbon atoms, in particular, having 1 to 3 carbon atoms, more preferably a linear alkyl group having 1 to 3 carbon atoms.

Rf is preferably an alkyl group having 1 to 16 carbon atoms substituted with one or more fluorine atoms, more preferably a CF₂H-C₁₋₁₅ fluoroalkylene group or a perfluoroalkyl group having 1 to 16 carbon atoms, further preferably a perfluoroalkyl group having 1 to 16 carbon atoms.

The perfluoroalkyl group having 1 to 16 carbon atoms may be linear or branched, and is preferably a linear or branched perfluoroalkyl group having 1 to 6 carbon atoms, particularly 1 to 3 carbon atoms, and more preferably a linear perfluoroalkyl group having 1 to 3 carbon atoms; specifically, -CF₃, -CF2CF3 or -CF2CF2CF3.

In the formula, PFPE represents a perfluoropolyether group. The perfluoropolyether group is as described above.

In the formulae, each R¹⁴, at each occurrence, independently represents a hydrogen atom or an alkyl group having 1 to 22 carbon atoms, preferably an alkyl group having 1 to 4 carbon atoms.

In the formulae, each R¹⁵, at each occurrence, independently represents a hydroxyl group or a hydrolyzable group.

The "hydrolyzable group", as used herein, means a group which can be removed from a main backbone of the compound by a hydrolysis reaction. Examples of the hydrolyzable group include -OR, -OCOR, -O-N=CR₂, -NR₂, -NHR, and halogen, wherein R represents a substituted or unsubstituted alkyl group having 1 to 4 carbon atoms, and -OR (namely, an alkoxy group) is preferable. Examples of R include unsubstituted alkyl groups such as a methyl group, an ethyl group, a propyl group, an isopropyl group, a n-butyl group and an isobutyl group; and substituted alkyl groups such as a chloromethyl group. Among them, an alkyl group, in particular, an unsubstituted alkyl group is preferable, and a methyl group or an ethyl group is more preferable. The hydroxyl group is not limited, and for example, may be generated by hydrolyzing the hydrolyzable group.

In the formulae, each R¹³, at each occurrence, independently represents a hydrogen atom or a halogen atom. The halogen atom is preferably an iodine atom, a chlorine atom or a fluorine atom, more preferably a fluorine atom.

In the formulae, each R¹², at each occurrence, independently represents a hydrogen atom or a lower alkyl group. The lower alkyl group is preferably an alkyl group having 1 to 20 carbon atoms, more preferably an alkyl group having 1 to 6 carbon atoms, and examples thereof include a methyl group, an ethyl group and a propyl group.

In the formulae, n with respect to each (-SiR¹⁴ₙR¹⁵₃₋ₙ) unit is independently an integer of 0 to 3, preferably 0 to 2, more preferably 0, provided that in the formulae, there is no case where all n(s) are simultaneously 0. In other words, at least one R¹⁵ is present in the formulae.

In the formulae, each t is independently an integer of 1 to 10. In a preferable embodiment, t is an integer of 1 to 6. In another preferable embodiment, t is an integer of 2 to 10, preferably an integer of 2 to 6.

In the formulae, each X¹⁰², at each occurrence, independently represents a single bond or a divalent organic group. X¹⁰² is preferably an alkylene group having 1 to 20 carbon atoms, more preferably -(CH₂)ᵤ-, wherein u is an integer of 0 to 2.

In the formulae, each R^{a3}, at each occurrence, independently represents -Z³-SiR⁷¹ₚR⁷²_{q}R⁷³ᵣ.

Z³ is preferably a divalent organic group. In a preferable embodiment, Z³ does not encompass any group which is taken together with a Si atom at an end of a molecular backbone in formula (C1) or formula (C2) (Si atom to which R^{a3} is bonded) to form a siloxane bond.

Z³ is preferably a C₁₋₆ alkylene group, - (CH₂)_{g}-O- (CH₂)ₕ-, wherein g is an integer of 1 to 6, and h is an integer of 1 to 6, or -phenylene-(CH₂)ᵢ-, wherein i is an integer of 0 to 6, more preferably a C₁₋₃ alkylene group, particularly preferably a C₂₋₃ alkylene group, for example -CH₂CH₂-. Such a group is optionally substituted with one or more substituents selected from, for example, a fluorine atom, a C₁₋₆ alkyl group, a C₂₋₆ alkenyl group, and a C₂₋₆ alkynyl group.

In the formulae, each R⁷¹, at each occurrence, independently represents R^{a'}. R^{a'} has the same meaning as Ra3.

The number of Si atoms linearly linked via a Z³ group is at most 5 in R^{a3}. That is, in the case where at least one R⁷¹ is present in R^{a3}, two or more Si atoms linearly linked via a Z group are present in R^{a3}, and the number of such Si atoms linearly linked via a Z³ group is at most 5. Herein, "the number of Si atoms linearly linked via a Z³ group in R^{a3}" is equal to the number of repeating units -Z³-Si-linearly linked in R^{a3}.

In one embodiment, "the number of Si atoms linearly linked via a Z³ group in R^{a3"} is 1 (left formula) or 2 (right formula), preferably 1. In other words, in the -Si-R^{a3} portion containing Si atoms bonded to X¹⁰⁷ in formulae (C1) and (C2), two Si atoms are linked in the left formula and three Si atoms are linked in the right formula.

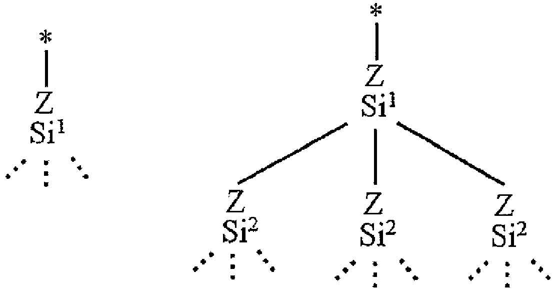

In a preferable embodiment, the "number of Si atoms linearly linked via a Z³ group in R^{a3}" is 1 or 2, and preferably 1 in all chains.

In a preferable embodiment, k is 3 and the "number of Si atoms linearly linked via a Z³ group in R^{a3}" is 1 in all chains.

In the formulae, each R⁷², at each occurrence, independently represents a hydroxyl group or a hydrolyzable group.

Preferably, R⁷² is -OR, wherein R represents a substituted or unsubstituted C₁₋₃ alkyl group, more preferably a methyl group.

In the formulae, each R⁷³, at each occurrence, independently represents a hydrogen atom or a lower alkyl group. The lower alkyl group is preferably an alkyl group having 1 to 20 carbon atoms, more preferably an alkyl group having 1 to 6 carbon atoms, further preferably a methyl group.

In the formulae, each p, at each occurrence, is independently an integer of 0 to 3; each q, at each occurrence, is independently an integer of 0 to 3; and each r, at each occurrence, is independently an integer of 0 to 3, provided that the sum of p, q and r is 3.

In a preferable embodiment, q in R^{a3}' (R^{a3} itself in the case where no R^{a3}' is present) at an end of R^{a3} is preferably 2 or more, for example, 2 or 3, more preferably 3.

In a preferable embodiment, R^{a3} may have at least one of -Si (-Z³-SiR⁷²_{q}R⁷³ᵣ)₂ or -Si (-Z³-SiR⁷²_{q}R⁷³ᵣ)₃, preferably -Si (-Z³-SiR⁷²_{q}R⁷³ᵣ)₃, at an end. In such a formula, a (-Z³-SiR⁷²_{q}R⁷³ᵣ) unit is preferably (-Z³-SiR⁷²₃). In a further preferable embodiment, all ends of R^{a} may be each -Si (-Z³-SiR⁷²_{q}R⁷³ᵣ)₃, preferably -Si (-Z³-SiR⁷²₃)₃.

In formulae (C1) and (C2), at least one R⁷² is present.

In the formulae, each R^{b3}, at each occurrence, independently represents a hydroxyl group or a hydrolyzable group.

R^{b3} preferably represents a hydroxyl group, -OR, -OCOR, -O-N=C(R)₂, -N(R)₂, -NHR, or halogen, wherein R represents a substituted or unsubstituted alkyl group having 1 to 4 carbon atoms, and each R^{b3} is preferably -OR. Examples of R include unsubstituted alkyl groups such as a methyl group, an ethyl group, a propyl group, an isopropyl group, a n-butyl group and an isobutyl group; and substituted alkyl groups such as a chloromethyl group. Among them, an alkyl group, in particular, an unsubstituted alkyl group is preferable, and a methyl group or an ethyl group is more preferable. The hydroxyl group is not limited, and for example, may be generated by hydrolyzing the hydrolyzable group. More preferably, R^{c} is -OR, wherein R represents a substituted or unsubstituted C₁₋₃ alkyl group, more preferably a methyl group.

In the formulae, each R^{c3}, at each occurrence, independently represents a hydrogen atom or a lower alkyl group. The lower alkyl group is preferably an alkyl group having 1 to 20 carbon atoms, more preferably an alkyl group having 1 to 6 carbon atoms, further preferably a methyl group.

In the formulae, each k, at each occurrence, independently represents an integer of 0 to 3; each 1, at each occurrence, is independently an integer of 0 to 3; and each m, at each occurrence, is independently an integer of 0 to 3, provided that the sum of k, 1 and m is 3.

In the formulae, each R^{d3}, at each occurrence, independently represents -Z³'-CR⁸¹_{p'}R⁸²_{q'}R⁸³_{r'}.

In the formulae, each Z³', at each occurrence, independently represents an oxygen atom or a divalent organic group.

Z³' is preferably a C₁₋₆ alkylene group, - (CH₂)_{g}-O-(CH₂)ₕ-, wherein g is an integer of 0 to 6, for example an integer of 1 to 6, and h is an integer of 0 to 6, for example an integer of 1 to 6, or -phenylene-(CH₂)ᵢ-, wherein i is an integer of 0 to 6, more preferably a C₁₋₃ alkylene group, further preferably a C₂₋₃ alkylene group, for example CH₂CH₂. Such a group is optionally substituted with one or more substituents selected from, for example, a fluorine atom, a C₁₋₆ alkyl group, a C₂₋₆ alkenyl group, and a C₂₋₆ alkynyl group.

In the formulae, each R⁸¹, at each occurrence, independently represents R^{d3"}. R^{d3}" has the same meaning as R^{d3}.

The number of C atoms linearly linked via a Z^{3'} group in R^{d3} is at most 5. That is, in the case where at least one R⁸¹ is present in R^{d3}, two or more Si atoms linearly linked via a Z³' group are present in R^{d3}, and the number of such C atoms linearly linked via a Z^{3'} group is at most 5. Herein, the "number of C atoms linearly linked via a Z^{3'} group in R^{d3}" is equal to the number of repeating units -Z³'-C-linearly linked in R^{d3}.

In a preferable embodiment, the "number of C atoms linearly linked via a Z³' group in R^{d3}" is 1 (left formula) or 2 (right formula) in all chains, as represented below.

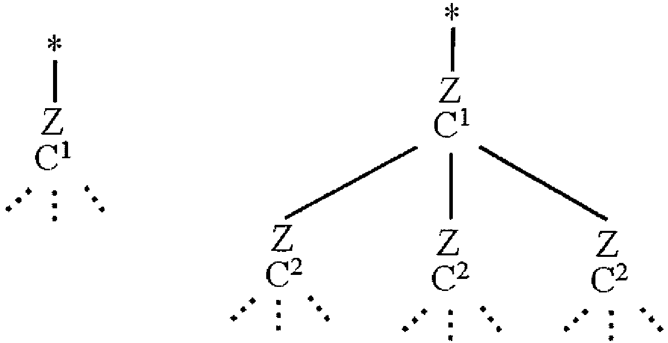

In one embodiment, the number of C atoms linearly linked via a Z³' group in R^{d3} is 1 or 2, preferably 1.

In the formula, R⁸² represents -Y³-SiR⁸⁵ⱼR⁸⁶₃₋ⱼ.

Each Y³, at each occurrence, independently represents a divalent organic group.

In a preferable embodiment, Y³ is a C₁₋₆ alkylene group, - (CH₂)_{g'}-O- (CH₂)_{h'}-, wherein g' is an integer of 0 to 6, for example, an integer of 1 to 6, and h' is an integer of 0 to 6, for example, an integer of 1 to 6, or -phenylene-(CH₂)_{i'}-, wherein i' is an integer of 0 to 6. Such a group is optionally substituted with one or more substituents selected from, for example, a fluorine atom, a C₁₋₆ alkyl group, a C₂₋₆ alkenyl group, and a C₂₋₆ alkynyl group.

In one embodiment, Y³ may be a C₁₋₆ alkylene group or - phenylene- (CH₂)_{i'}-. In the case where Y³ is any of the groups, light resistance, in particular, ultraviolet resistance can be more enhanced.

Each R⁸⁵, at each occurrence, independently represents a hydroxyl group or a hydrolyzable group. Examples of the "hydrolyzable group" are the same as those mentioned above.

Preferably, R⁸⁵ is -OR, wherein R represents a substituted or unsubstituted C₁₋₃ alkyl group, more preferably an ethyl group or a methyl group, in particular, a methyl group.

Each R⁸⁶, at each occurrence, independently represents a hydrogen atom or a lower alkyl group. The lower alkyl group is preferably an alkyl group having 1 to 20 carbon atoms, more preferably an alkyl group having 1 to 6 carbon atoms, further preferably a methyl group.

j with respect to a (-Y³-SiR⁸⁵ⱼR⁸⁶₃₋ⱼ) unit independently represents an integer of 1 to 3, preferably 2 or 3, more preferably 3.

Each R⁸³, at each occurrence, independently represents a hydrogen atom, a hydroxyl group, or a lower alkyl group. Preferably, each R⁸³, at each occurrence, independently represents a hydrogen atom or a lower alkyl group. The lower alkyl group is preferably an alkyl group having 1 to 20 carbon atoms, more preferably an alkyl group having 1 to 6 carbon atoms, further preferably a methyl group.

In the formulae, each p', at each occurrence, is independently an integer of 0 to 3; each q', at each occurrence, is independently an integer of 0 to 3; and each r', at each occurrence, is independently an integer of 0 to 3, provided that the sum of p', q' and r' is 3.

In a preferable embodiment, q' in R^{d3}" (R^{d3} itself in the case where no R^{d3}" is present) at an end of R^{d3} is preferably 2 or more, for example, 2 or 3, more preferably 3.

In the formulae, each R^{e3}, at each occurrence, independently represents -Y³-SiR⁸⁵ⱼR⁸⁶₃₋ⱼ. Herein, Y³, R⁸⁵, R⁸⁶ and j have the same meanings as in R⁸² above.

In the formulae, each R^{f3}, at each occurrence, independently represents a hydrogen atom, a hydroxyl group or a lower alkyl group. Preferably, each R^{f3}, at each occurrence, independently represents a hydrogen atom or a lower alkyl group. The lower alkyl group is preferably an alkyl group having 1 to 20 carbon atoms, more preferably an alkyl group having 1 to 6 carbon atoms, further preferably a methyl group.

In the formulae, each k', at each occurrence, is independently an integer of 0 to 3; each l', at each occurrence, is independently an integer of 0 to 3; and each m', at each occurrence, is independently an integer of 0 to 3, provided that the sum of k', l' and m' is 3.

In one embodiment, at least one k' is 2 or 3, preferably 3.

In one embodiment, k' is 2 or 3, preferably 3.

In one embodiment, l' is 2 or 3, preferably 3.

In formulae (D1) and (D2), at least one q' is 2 or 3, or at least one l' is 2 or 3. That is, in the formulae, at least two -Y³-SiR⁸⁵ⱼR⁸⁶₃₋ⱼ groups are present in the formulae.

In the formulae, G⁵ is -R¹⁷-O-, -R¹⁷-CONH-, -CONH-, or a single bond. G⁵ is preferably -R¹⁷-CONH- or -CONH- from the viewpoint of excellent light resistance, and is preferably -R¹⁷-O-, from the viewpoint of excellent chemical resistance.

R¹⁷ is an alkylene group. R¹⁷ is preferably an alkylene group having 1 to 4 carbon atoms, particularly preferably - CH₂- from the viewpoint of ease of production.

In the formulae, Z⁵ is an (a5+b5)-valent hydrocarbon group or an (a5+b5)-valent group having 2 or more carbon atoms and having at least one etheric oxygen atom between carbon atoms in the hydrocarbon group. Z⁵ is a residue obtained by removing hydroxyl groups from a polyhydric alcohol having (a5+b5) hydroxyl groups in the case where G⁵ is -R¹⁷-O- and c5 is 1.

In one embodiment, Z⁵ may be the following groups:

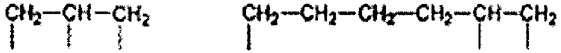

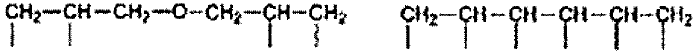

Z⁵ is preferably a residue obtained by removing hydroxyl groups from a polyhydric alcohol having primary hydroxyl groups, from the viewpoint of excellent reactivity of the hydroxyl group. Z⁵ is particularly preferably a group represented by the following formula (Z-1), a group represented by the following formula (Z-2), a group represented by the following formula (Z-3), a group represented by the following formula (Z-4) or a group represented by the following formula (Z-5) from the viewpoint of the availability of raw materials, provided that R⁴ is an alkyl group, preferably a methyl group or an ethyl group.

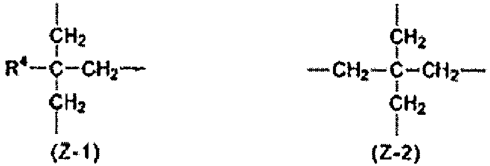

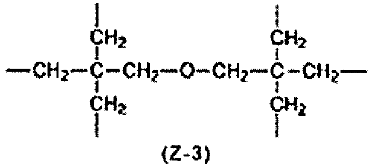

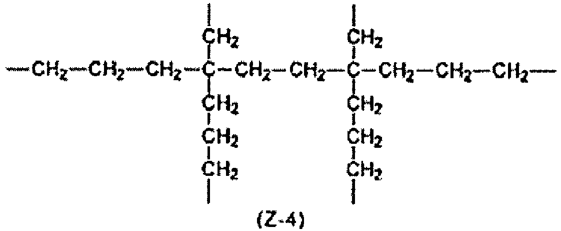

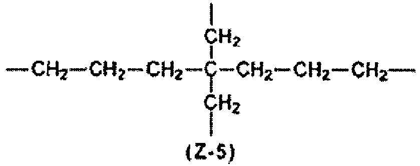

In the formulae, R¹⁶ is an alkylene group. R¹⁶ is preferably an alkylene group having 4 to 14 carbon atoms from the viewpoint of ease of production. Furthermore, particularly preferred is an alkylene group having 4 to 10 carbon atoms from the viewpoint that a by-product in which some or all of the allyl groups (-CH₂CH=CH₂) are isomerized to inner olefin (-CH=CHCH₃) is hardly produced in hydrosilylation in the production.

In the formulae, a5 is an integer of 1 or more. b5 is an integer of 1 or more. (a5+b5) is 3 or more. When a5 is 1, b5 is 4 or more, and when a5 is 2 or more, b5 is 1 or more. When a5 is 2 or more, a5 pieces of [Rf-PFPE-G⁵] may be the same or different. When b5 is 2 or more, b(5) pieces of [(O-R¹⁶)_{c5}-SiR¹⁴ₙR¹⁵₃₋ₙ] may be the same or different. c5 is 0 or 1.

a5 is preferably 1 to 10, particularly preferably 1 to 4. When a5 is the lower limit value or more, the water- and oil-repellency of the surface-treating layer, frictional durability, fingerprint stain removability and lubricity are excellent. When a5 is the upper limit value or less, the appearance of the surface-treating layer is excellent. (a5+b5) is preferably 3 to 15, particularly preferably 3 to 12.

When a5 is 1, b5 is 4 or more, preferably 4 to 10, particularly preferably 4 to 5. When a5 is 1 and b5 is not 4 or more, the frictional durability of the surface-treating layer may be insufficient. When b5 is the upper limit value or less, the appearance of the surface-treating layer and the stability of the compound are excellent.

When a5 is an integer of 2 or more, b5 is an integer of 1 or more, preferably an integer of 1 to 10, particularly preferably an integer of 1 to 4. When a5 is an integer of 2 or more, the lubricity of the surface-treating layer is excellent, and thus the friction force is not easily applied to the surface-treating layer. Therefore, even when b5 is 1, the frictional durability of the surface-treating layer is excellent. When b5 is the upper limit value or less, the appearance of the surface-treating layer and the stability of the compound are excellent.

c5 is 0 or 1. c5 is preferably 0 from the viewpoint of excellent light resistance of the compound, and is preferably 1 from the viewpoint of ease of production of the compound.

In the formulae, each X¹⁰¹ independently represents a single bond or a di- to decavalent organic group. X¹⁰¹ is understood to be a linker which links a perfluoropolyether portion (namely, Rf-PFPE portion or -PFPE- portion) mainly providing water-repellency, surface lubricity, and the like, and a silane portion (namely, group in parentheses with α) providing a binding ability to the base material, in any compound represented by formulae (A1) and (A2). Accordingly, X¹⁰¹ may be a single bond or any organic group as long as such any compound represented by formulae (A1) and (A2) can be stably present.

In the formulae, α is an integer of 1 to 9, and α' is an integer of 1 to 9. Such α and α' may be varied depending on the valence of X¹⁰¹. The sum of α and α' in formula (A1) is the same as the valence of X¹⁰¹. For example, in the case where X¹⁰¹ is a decavalent organic group, the sum of α and α' is 10, and for example, α may be 9 and α' may be 1, α may be 5 and α' may be 5, or α may be 1 and α' may be 9. In the case where X¹⁰¹ is a single bond or a divalent organic group, α and α' are each 1. In formula (A2), α corresponds to a value obtained by subtracting 1 from the valence of X¹⁰¹.

X¹⁰¹ is preferably a di- to heptavalent, more preferably di- to tetravalent, further preferably divalent organic group.

In one embodiment, X¹⁰¹ is a di- to tetravalent organic group, α is 1 to 3, and α' is 1.

In another embodiment, X¹⁰¹ is a divalent organic group, α is 1, and α' is 1. In such a case, formulae (A1) and (A2) are represented by the following formulae (A1') and (A2'), respectively.

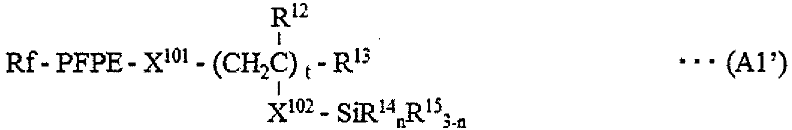

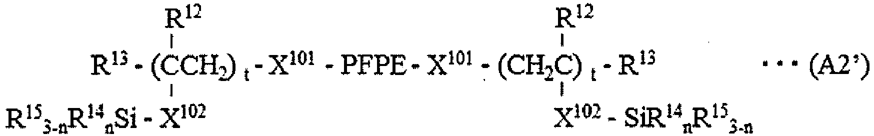

In the formulae, each X¹⁰⁵ independently represents a single bond or a di- to decavalent organic group. X¹⁰⁵ is understood to be a linker which links a perfluoropolyether portion (Rf-PFPE portion or -PFPE- portion) mainly providing water-repellency, surface lubricity, and the like, and a silane portion (specifically, -SiR¹⁴ₙR¹⁵₃₋ₙ) providing a binding ability to the base material, in any compound represented by formulae (B1) and (B2). Accordingly, X¹⁰⁵ may be a single bond or any organic group as long as such any compound represented by formulae (B1) and (B2) can be stably present.

In the formulae, β is an integer of 1 to 9 and β' is an integer of 1 to 9. The integers represented by β and β' are determined in accordance with the valence of X¹⁰⁵, and in formula (B1), the sum of β and P' is the same as the valence of X¹⁰⁵. For example, in the case where X¹⁰⁵ is a decavalent organic group, the sum of β and β' is 10, and for example, β may be 9 and β' may be 1, β may be 5 and β' may be 5, or β may be 1 and β' may be 9. In the case where X¹⁰⁵ is a single bond or a divalent organic group, β and β' are each 1. In formula (B2), β corresponds to a value obtained by subtracting 1 from the valence of X¹⁰⁵.

X¹⁰⁵ is preferably a di- to heptavalent, more preferably di- to tetravalent, further preferably divalent organic group.

In one embodiment, X¹⁰⁵ is a di- to tetravalent organic group, β is 1 to 3, and β' is 1.

In another embodiment, X¹⁰⁵ is a divalent organic group, β is 1, and β' is 1. In such a case, formulae (B1) and (B2) are represented by the following formulae (B1') and (B2'), respectively:

Rf-PFPE-X¹⁰⁵ -SiR¹⁴ₙR¹⁵₃₋ₙ ··· (B1')

R¹⁵₃₋ₙR¹⁴ₙSi- X¹⁰⁵ - PFPE- X¹⁰⁵ - SiR¹⁴ₙR¹⁵₃₋ₙ ··· (B2')

In the formulae, each X¹⁰⁷ independently represents a single bond or a di- to decavalent organic group. X¹⁰⁷ is understood to be a linker which links a perfluoropolyether portion (Rf-PFPE portion or -PFPE- portion) mainly providing water-repellency, surface lubricity, and the like, and a silane portion (specifically, -SiR^{a3}ₖR^{b3}ₗR^{c3}ₘ group) providing a binding ability to the base material, in any compound represented by formulae (C1) and (C2) . Accordingly, X¹⁰⁷ may be a single bond or any organic group as long as such any compound represented by formulae (C1) and (C2) can be stably present.

In the formulae, γ is an integer of 1 to 9 and γ' is an integer of 1 to 9. The integers represented by γ and γ' are determined in accordance with the valence of X¹⁰⁷, and in formula (C1), the sum of γ and γ' is the same as the valence of X¹⁰⁷. For example, in the case where X¹⁰⁷ is a decavalent organic group, the sum of γ and γ' is 10, and for example, γ may be 9 and γ' may be 1, γ may be 5 and γ' may be 5, or γ may be 1 and γ' may be 9. In the case where X¹⁰⁷ is a single bond or a divalent organic group, γ and γ' are each 1. In formula (C2), γ corresponds to a value obtained by subtracting 1 from the valence of X¹⁰⁷.

X¹⁰⁷ is preferably a di- to heptavalent, more preferably di- to tetravalent, further preferably divalent organic group.

In one embodiment, X¹⁰⁷ is a di- to tetravalent organic group, γ is 1 to 3, and γ' is 1.

In another embodiment, X¹⁰⁷ is a divalent organic group, γ is 1, and γ' is 1. In such a case, formulae (C1) and (C2) are represented by the following formulae (Cl') and (C2'), respectively.

Rf-PFPE-X¹⁰⁷ - SiR^{a3}ₖR^{b3}ₗR^{c3}ₘ ··· (Cl')

R^{c3}ₘR^{b3}ₗR^{a3}ₖSi- X¹⁰⁷ -PFPE-X¹⁰⁷ -SiR^{a3}ₖR^{b3}ₗR^{c3}ₘ ··· (C2')

In the formulae, each X¹⁰⁹independently represents a single bond or a di- to decavalent organic group. X¹⁰⁹is understood to be a linker which links a perfluoropolyether portion (namely, Rf-PFPE portion or -PFPE- portion) mainly providing water-repellency, surface lubricity, and the like, and a portion (namely, group in parentheses with δ) providing a binding ability to the base material, in any compound represented by formulae (D1) and (D2). Accordingly, X¹⁰⁹ may be a single bond or any organic group as long as such any compound represented by formulae (D1) and (D2) can be stably present.

In the formulae, δ is an integer of 1 to 9 and δ' is an integer of 1 to 9. These δ and δ' may change depending on the valence of X¹⁰⁹. In formula (D1), the sum of δ and δ' is the same as the valence of X¹⁰⁹. For example, in the case where X¹⁰⁹ is a decavalent organic group, the sum of δ and δ' is 10, and for example, δ may be 9 and δ' may be 1, δ may be 5 and δ' may be 5, or δ may be 1 and δ' may be 9. In the case where X¹⁰⁹ is a single bond or a divalent organic group, δ and δ' are each 1. In formula (D2), δ corresponds to a value obtained by subtracting 1 from the valence of X¹⁰⁹.

X¹⁰⁹ is preferably a di- to heptavalent, more preferably di- to tetravalent, further preferably divalent organic group.

In one embodiment, X¹⁰⁹ is a di- to tetravalent organic group, δ is 1 to 3, and δ' is 1.

In another embodiment, X¹⁰⁹ is a divalent organic group, δ is 1, and δ' is 1. In such a case, formulae (D1) and (D2) are represented by the following formulae (D1') and (D2'), respectively.

Rf-PFPE-X¹⁰⁹-CR^{d5}_{k'}R^{e3}_{l'}R^{f3}_{m'} ··· (D1')

R^{f3}_{m'}R^{e3}_{l'}R^{d3}_{k'}C-X¹⁰⁹-PFPE-X¹⁰⁹-CR^{d3}_{k'}R^{e3}_{l'}R^{f3}_{m'} ··· (D2')

In a preferable embodiment, X¹⁰¹, X¹⁰⁵, X¹⁰⁷, and X¹⁰⁹, may each independently be, but not limited to, a divalent group represented by the following formula:

- (R³¹)ₚ₁-(X^{a})_{q1}-

wherein:
R³¹ represents a single bond, -(CH₂)_{s'}- or o-, m- or p-phenylene group and preferably -(CH₂)_{s'}-,
s' is an integer of 1 to 20, preferably an integer of 1 to 6, more preferably an integer of 1 to 3 and still more preferably 1 or 2,
X^{a} represents - (X^{b})_{l'}-,
each X^{b}, at each occurrence, independently represents a group selected from the group consisting of -O-, -S-, an o-, m- or p-phenylene group, -C(O)O-, -Si(R³³)₂-, - (Si(R³³)₂O)_{m"}-Si(R³³)₂-, -CONR³⁴-, -O-CONR³⁴-, -NR³⁴- and -(CH₂)_{n'}-,
each R³³, at each occurrence, independently represents a phenyl group, a C₁₋₆ alkyl group or a C₁₋₆ alkoxy group, preferably a phenyl group or a C₁₋₆ alkyl group, more preferably a methyl group,
each R³⁴, at each occurrence, independently represents a hydrogen atom, a phenyl group or a C₁₋₆ alkyl group (preferably a methyl group),
m", at each occurrence, is independently an integer of 1 to 100, preferably an integer of 1 to 20,
n', at each occurrence, is independently an integer of 1 to 20, preferably an integer of 1 to 6, more preferably an integer of 1 to 3,
l' is an integer of 1 to 10, preferably an integer of 1 to 5, more preferably an integer of 1 to 3,
p1 is 0 or 1, and
q1 is 0 or 1,
provided that at least one of p1 and q1 is 1, and the occurrence order of the respective repeating units in parentheses with pl or q1 is not limited.

Here, R³¹ and X^{a} (typically, any hydrogen atom in R³¹ and X^{a}) are each optionally substituted with one or more substituents selected from a fluorine atom, a C₁₋₃ alkyl group and a C₁₋₃ fluoroalkyl group.

In one embodiment, X¹⁰¹, X¹⁰⁵, X¹⁰⁷, and X¹⁰⁹ may be each independently a divalent group represented by:

- (R³¹)ₚ₁-(X^{a})_{q1}-

wherein:
R³¹ represents -(CH₂)_{s'}-,
s' is an integer of 1 to 20,
X^{a} represents - (X^{b})_{l'}-,
each X^{b}, at each occurrence, independently represents a group selected from the group consisting of -O-, -CONR³⁴-, - O-CONR³⁴- and -(CH₂)_{n'}-,
each R³⁴, at each occurrence, independently represents a hydrogen atom, a phenyl group or a C₁₋₆ alkyl group,
each n' , at each occurrence, is independently an integer of 1 to 20,
l' is an integer of 1 to 10,
p1 is 0 or 1, and
q1. is 0 or 1,
provided that at least one of p1 and q1 is 1, and the occurrence order of the respective repeating units in parentheses with pl or q1 is not limited.

Here, R³¹ and X^{a} (typically, any hydrogen atom in R³¹ and X^{a}) are each optionally substituted with one or more substituents selected from a fluorine atom, a C₁₋₃ alkyl group and a C₁₋₃ fluoroalkyl group.

Preferably, X¹⁰¹, X¹⁰⁵, X¹⁰⁷, and X¹⁰⁹ are each independently -(R³¹)ₚ₁-(X^{a})_{q1}-R³²-. R³² represents a single bond, -(CH₂)_{t'}- or an o-, m- or p-phenylene group, preferably -(CH₂)_{t'}-. Here, t' is an integer of 1 to 20, preferably an integer of 2 to 6, more preferably an integer of 2 to 3. Here, R³² (typically, any hydrogen atom in R³²) is optionally substituted with one or more substituents selected from a fluorine atom, a C₁₋₃ alkyl group and a C₁₋₃ fluoroalkyl group.

Preferably, X¹⁰¹, X¹⁰⁵, X¹⁰⁷, and X¹⁰⁹ may be each independently
a single bond,
-X^{f}-C₁₋₂₀ alkylene group,
-X^{f}-R³¹-X^{c}-R³²-, or
-X^{f}-X^{d}-R³²-
wherein R³¹ and R³² have the same meaning as described above, and
X^{f} is a single bond or a perfluoroalkylene group having 1 to 6 carbon atoms, preferably 1 to 4 carbon atoms, more preferably 1 to 2 carbon atoms, for example, a difluoromethylene group.

More preferably, X¹⁰¹, X¹⁰⁵, X¹⁰⁷, and X¹⁰⁹ may be each independently
a single bond,
-X^{f}-C₁₋₂₀ alkylene group,
-X^{f}-(CH₂)_{s'}-X^{c}-,
-X^{f}(CH₂)_{s'}-X^{c}-(CH₂)_{t'}-,
-X^{f}-X^{d}-, or
-X^{f}-X^{d}- (CH₂)_{t'}-
wherein X^{f}, s' and t' have the same meaning as described above.

In the formulae, X^{c} represents
-O-,
-S-,
-C(O)O-,
-CONR³⁴-,
-O-CONR³⁴-,
-Si(R³³)₂-,
- (Si(R³³)₂O)_{m"}-Si(R³³)₂-,
-O-(CH₂)_{u'}-(Si (R³³)₂O)_{m"}-Si (R³³)₂-,
-O-(CH₂)_{u'}-S'₁(R³³)₂-O-Si(R³³)₂-CH₂CH₂-Si(R³³)₂-O-Si(R³³)₂-,
-O-(CH₂)_{u'}-Si(OCH₃)₂OSi(OCH₃)₂-,
-CONR³⁴-(CH₂)_{u'}-(Si(R³³)₂O)_{m"}-Si(R³³)₂-,
-CONR³⁴-(CH₂)_{u'}-N(R³⁴)-, or
-CONR³⁴-(o-, m- or p-phenylene) -Si (R³³)₂-,
wherein R³³, R³⁴ and m' have the same meaning as described above, and
u' is an integer of 1 to 20, preferably an integer of 2 to 6, more preferably an integer of 2 to 3. X^{c} is preferably -O-.

In the formulae, X^{d} represents -S-,
-C(O)O-,
-CONR³⁴- ,
-O-CONR³⁴- ,
-CONR³⁴-(CH₂)_{u'}-(Si(R³³)₂O)_{m"}-Si(R³³)₂-,
-CONR³⁴-(CH₂)_{u'}-N(R³⁴)-, or
-CONR³⁴- (o-, m- or p-phenylene) -Si (R³³)₂-,
wherein each symbol has the same meaning as described above.

More preferably, X¹⁰¹, X¹⁰⁵, X¹⁰⁷, and X¹⁰⁹ may be each independently
a single bond,
a C₁₋₂₀ alkylene group,
- (CH₂)_{s'}-X^{c}-(CH₂)_{t'}-, or
-X^{d}-(CH₂)_{t'}-,
wherein each symbol has the same meaning as described above.

In a preferable embodiment, the above X¹⁰¹, X¹⁰⁵, X¹⁰⁷, and X¹⁰⁹ are each independently
a single bond,
a C₁₋₂₀ alkylene group,
- (CH₂)_{s'}-X^{c}-, or
- (CH₂)_{s'}-X^{c}-(CH₂)_{t'}-,
wherein
X^{c} is -O-, -CONR³⁴-, or -O-CONR³⁴-,
each R³⁴, at each occurrence, independently represents a hydrogen atom, a phenyl group or a C₁₋₆ alkyl group,
s' is an integer of 1 to 20, and
t' is an integer of 1 to 20.

In one embodiment, X¹⁰¹, X¹⁰⁵, X¹⁰⁷, and X¹⁰⁹ are each independently:
a single bond,
a C₁₋₂₀ alkylene group,
- (CH₂)_{s'}-O-(CH₂)_{t'}- ,
- (CH₂)_{s'}-(Si(R³³)₂O)_{m"}-Si (R³³)₂-(CH₂)_{t'}- ,
- (CH₂)_{s'}-O-(CH₂)_{u'}-(Si(R³³)₂O)_{m"}-Si(R³³)₂-(CH₂)_{t'}-, or
- (CH₂)_{s'}-O-(CH₂)_{t'}-Si(R³³)₂-(CH₂)_{u'}-Si(R³³)₂-(CᵥH₂ᵥ)-
wherein R³³, m", s', t' and u' have the same meaning as described above, and v is an integer of 1 to 20, preferably an integer of 2 to 6, more preferably an integer of 2 to 3.

In the formula, -(CᵥH₂ᵥ)- may be linear or branched, and may be, for example, -CH₂CH₂-, -CH₂CH₂CH₂-, -CH(CH₃) -, or - CH (CH₃) CH₂-.

The X¹⁰¹, X¹⁰⁵, X¹⁰⁷, and X¹⁰⁹ groups are each independently and optionally substituted with one or more substituents selected from a fluorine atom, a C₁₋₃ alkyl group and a C₁₋₃ fluoroalkyl group (preferably, C₁₋₃ perfluoroalkyl group).

The left side of each formula of X¹⁰¹, X¹⁰⁵, X¹⁰⁷, and X¹⁰⁹ is bonded to the PFPE group.

In the above formulae, X^{f} is preferably a single bond for formulae (A1), (B1), (C1) and (D1), and a perfluoroalkylene group having 1 to 6 a carbon atoms, preferably 1 to 4 carbon atoms, and more preferably 1 to 2 carbon atoms, for example, a difluoromethylene group for formulae (A2), (B2), (C2) and (D2).

In one embodiment, the X¹⁰¹, X¹⁰⁵, X¹⁰⁷, and X¹⁰⁹ groups may each be independently other than a -O-C₁₋₆ alkylene group.

In another embodiment, examples of the X¹⁰¹, X¹⁰⁵, X¹⁰⁷, and X¹⁰⁹ groups include the following groups: 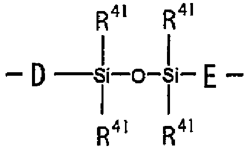 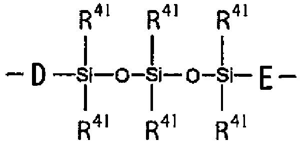 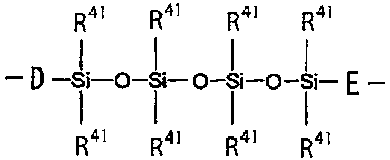 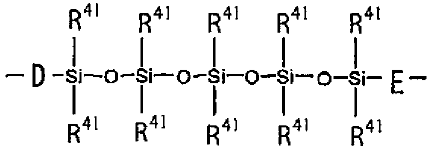 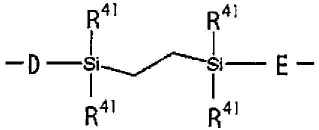 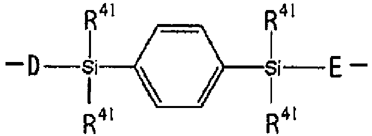 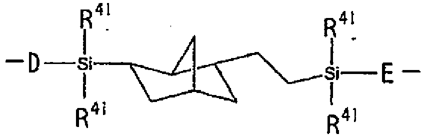 wherein each R⁴¹ is independently a hydrogen atom, a phenyl group, an alkyl group having 1 to 6 carbon atoms, or a C₁₋₆ alkoxy group, preferably a methyl group;
D is a group selected from
   -CH₂O(CH₂)₂-,
   -CH₂O(CH₂)₃-,
   -CF₂O(CH₂)₃-,
   -(CH₂)₂-,
   -(CH₂)₃-,
   - (CH₂)₄-,
   -CONH-(CH₂)₃-,
   -CON(CH₃)-(CH₂)_{3-,}
   -CON (Ph) - (CH₂)₃- wherein Ph means phenyl, and 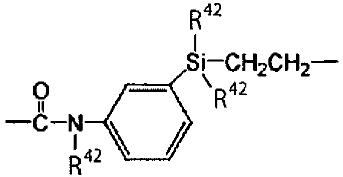
   wherein each R⁴² independently represents a hydrogen atom, a C₁₋₆ alkyl group or a C₁₋₆ alkoxy group, preferably a methyl group or a methoxy group, more preferably a methyl group,
E is -(CH₂)ₙ-, wherein n is an integer of 2 to 6, and
D is bonded to PFPE as a molecular backbone, and E is bonded to an opposite group to PFPE.

Specific examples of X¹⁰¹, X¹⁰⁵, X¹⁰⁷, and X¹⁰⁹ include, for example:
a single bond,
-CH₂OCH₂-,
-CH₂O(CH₂)₂-,
-CH₂O(CH₂)₃-,
-CH₂O(CH₂)₆-,
-CF₂-CH₂-O-CH₂-,
-CF₂-CH₂-O-(CH₂)₂-,
-CF₂-CH₂-O-(CH₂)₃-,
-CF₂-CH₂-O-(CH₂)₆-,
-CH₂O(CH₂)₃Si(CH₃)₂OSi(CH₃)₂(CH₂)₂-,
-CH₂O(CH₂)₃Si(CH₃)₂OSi(CH₃)₂OSi(CH₃)₂(CH₂)₂-,
-CH₂O(CH₂)₃Si(CH₃)₂O(Si(CH₃)₂O)₂Si(CH₃)₂(CH₂)₂-,
-CH₂O(CH₂)₃Si(CH₃)₂O(Si(CH₃)₂O)₃Si(CH₃)₂(CH₂)₂-,
-CH₂O(CH₂)₃Si(CH₃)₂O(Si(CH₃)₂O)₁₀Si(CH₃)₂(CH₂)₂-,
-CH₂O(CH₂)₃Si(CH₃)₂O(Si(CH₃)₂O)₂₀Si(CH₃)₂(CH₂)₂-,
-CH₂OCF₂CHFOCF₂-,
-CH₂OCF₂CHFOCF₂CF₂-,
-CH₂OCF₂CHFOCF₂CF₂CF₂-,
-CH₂OCH₂CF₂CF₂OCF₂-,
-CH₂OCH₂CF₂CF₂OCF₂CF₂-,
-CH₂OCH₂CF₂CF₂OCF₂CF₂CF₂-,
-CH₂OCH₂CF₂CF₂OCF(CF₃)CF₂OCF₂-,
-CH₂OCH₂CF₂CF₂OCF(CF₃)CF₂OCF₂CF₂-,
-CH₂OCH₂CF₂CF₂OCF(CF₃)CF₂OCF₂CF₂CF₂-,
-CH₂OCH₂CHFCF₂OCF₂-,
-CH₂OCH₂CHFCF₂OCF₂CF₂-,
-CH₂OCH₂CHFCF₂OCF₂CF₂CF₂-,
-CH₂OCH₂CHFCF₂OCF(CF₃)CF₂OCF₂-,
-CH₂OCH₂CHFCF₂OCF(CF₃)CF₂OCF₂CF₂-,
-CH₂OCH₂CHFCF₂OCF(CF₃)CF₂OCF₂CF₂CF₂-,
-CH₂OCF₂CHFOCF₂CF₂CF₂-C(O)NH-CH₂-,
CH₂OCH₂(CH₂)₇CH₂Si(OCH₃)₂OSi(OCH₃)₂(CH₂)₂Si(OCH₃)₂OSi(OCH₃)₂(CH₂ )₂-,
-CH₂OCH₂CH₂CH₂Si(OCH₃)₂OSi(OCH₃)₂(CH₂)₃-,
-CH₂OCH₂CH₂CH₂Si(OCH₂CH₃)₂OSi(OCH₂CH₃)₂(CH₂)₃-,
-CH₂OCH₂CH₂CH₂Si(OCH₃)₂OSi(OCH₃)₂(CH₂)₂-,
-CH₂OCH₂CH₂CH₂Si(OCH₂CH₃)₂OSi(OCH₂CH₃)₂(CH₂)₂-,
-(CH₂)₂-Si(CH₃)₂(CH₂)₂-,
-CH₂-,
-(CH₂)₂-,
-(CH₂)₃-,
-(CH₂)₄-,
-(CH₂)₅-,
-(CH₂)₆-,
-CF₂-CH₂-,
-CF₂-(CH₂)₂-,
-CF₂-(CH₂)₃-,
-CF₂-(CH₂)₄-,
-CF₂-(CH₂)₅-,
-CF₂-(CH₂)₆-,
-CO-,
-CONH-,
-CONH-CH₂-,
-CONH-(CH₂)₂-,
-CONH-(CH₂)₃-,
-CONH-(CH₂)₆-,
-CF₂CONHCH₂-,
-CF₂CONH(CH₂)₂-,
-CF₂CONH(CH₂)₃-,
-CF₂CONH(CH₂)₆-,
-CON(CH₃)-(CH₂)₃-,
-CON(Ph)-(CH₂)₃- wherein Ph means phenyl;
-CON(CH₃)-(CH₂)₆-,
-CON(Ph)-(CH₂)₆- wherein Ph means phenyl;
-CF₂-CON(CH₃)-(CH₂)₃-,
-CF₂-CON(Ph)-(CH₂)₃- wherein Ph means phenyl;
-CF₂-CON(CH₃)-(CH₂)₆-,
-CF₂-CON(Ph)-(CH₂)₆- wherein Ph means phenyl;
-CONH-(CH₂)₂NH(CH₂)₃-,
-CONH-(CH₂)₆NH(CH₂)₃-,
-CH₂O-CONH-(CH₂)₃-,
-CH₂O-CONH-(CH₂)₆-,
-S-(CH₂)₃-,
-(CH₂)₂S(CH₂)₃-,
-CONH-(CH₂)₃Si(CH₃)₂OSi(CH₃)₂(CH₂)₂-,
-CONH-(CH₂)₃Si(CH₃)₂OSi(CH₃)₂OSi(CH₃)₂(CH₂)₂
-CONH-(CH₂)₃Si(CH₃)₂O(Si(CH₃)₂O)₂Si(CH₃)₂(CH₂)₂-,
-CONH-(CH₂)₃Si(CH₃)₂O(Si(CH₃)₂O)₃Si(CH₃)₂(CH₂)₂-,
-CONH-(CH₂)₃Si(CH₃)₂O(Si(CH₃)₂O)₁₀Si(CH₃)₂(CH₂)₂-,
-CONH-(CH₂)₃Si(CH₃)₂O(Si(CH₃)₂O)₂₀Si(CH₃)₂(CH₂)₂-,
-C(O)O-(CH₂)₃-,
-C(O)O-(CH₂)₆-,
-CH₂-O-(CH₂)₃-Si(CE₃)₂-(CH₂)₂-Si(CH₃)₂-(CH₂)₂-,
-CH₂-O-(CH₂)₃-Si(CH₃)₂-(CH₂)₂-Si(CH₃)₂-CH(CH₃)-,
-CH₂-O-(CH₂)₃-Si(CH₃)₂-(CH₂)₂-Si(CH₃)₂-(CH₂)₃-,
-CH₂-O-(CH₂)₃-Si(CH₃)₂-(CH₂)₂-Si(CH₃)₂-CH(CH₃)-CH₂-,
-OCH₂-,
-O(CH₂)₃-,
-OCFHCF₂-, and

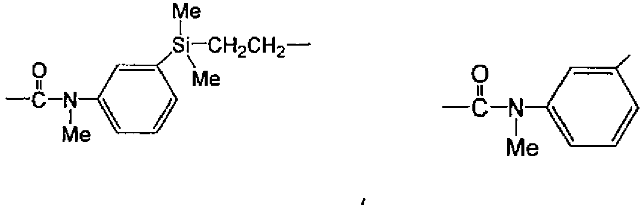

In yet another embodiment, X¹⁰¹, X¹⁰⁵ , X¹⁰⁷ , and X¹⁰⁹ are each independently a group represented by the formula: - (R¹⁸)ₓ-(CFR¹⁷)_{y}-(CH₂)_{z}-. In the formula, x, y and z are each independently an integer of 0 to 10, the sum of x, y and z is 1 or more, and the occurrence order of the respective repeating units in parentheses is not limited in the formulae.

In the formulae, each R¹⁸, at each occurrence, independently represents an oxygen atom, phenylene, carbazolylene, -NR²⁶-, wherein R²⁶ represents a hydrogen atom or an organic group, or a divalent organic group. Preferably, R¹⁰ represents an oxygen atom or a divalent polar group.

The "divalent polar group" is not limited, and examples thereof include -C(O) -, -C(=NR²⁷)-, and -C(O)NR²⁷-, wherein R²⁷ represents a hydrogen atom or a lower alkyl group. The "lower alkyl group" is, for example, an alkyl group having 1 to 6 carbon atoms, such as methyl, ethyl, or n-propyl, and such a group is optionally substituted with one or more fluorine atoms.

In the formulae, each R¹⁷, at each occurrence, is independently a hydrogen atom, a fluorine atom or a lower fluoroalkyl group, preferably a fluorine atom. The "lower fluoroalkyl group" is, for example, a fluoroalkyl group having 1 to 6 carbon atoms, preferably having 1 to 3 carbon atoms, preferably a perfluoroalkyl group having 1 to 3 carbon atoms, more preferably a trifluoromethyl group or a pentafluoroethyl group, further preferably a trifluoromethyl group.

In yet another embodiment, examples of the X¹⁰¹, X¹⁰⁵, X¹⁰⁷, and X¹⁰⁹ groups include the following groups: 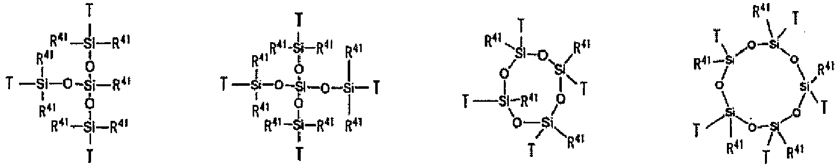 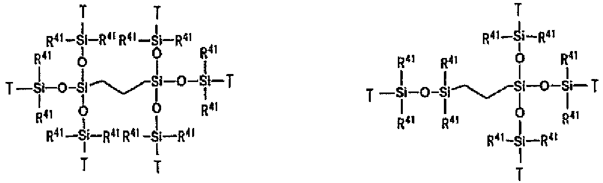 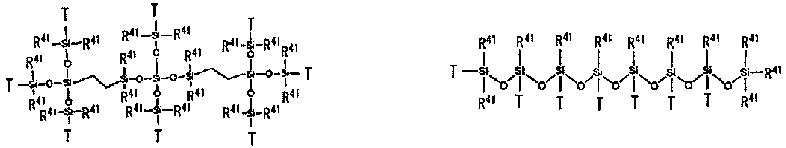 wherein
each R⁴¹ is independently a hydrogen atom, a phenyl group, an alkyl group having 1 to 6 carbon atoms, or a C₁₋₆ alkoxy group, preferably a methyl group; and
any number of the Ts in each X¹⁰¹ group is the following group bonded to PFPE as a molecular backbone:
   -CH₂O(CH₂)₂-,
   -CH₂O(CH₂)₃-,
   -CF₂O(CH₂)₃-,
   -(CH₂)₂-,
   -(CH₂)₃-,
   -(CH₂)₄-,
   -CONH-(CH₂)₃-,
   -CON(CH₃)-(CH₂)₃-,
   -CON(Ph)-(CH₂)₃- wherein Ph means phenyl; or 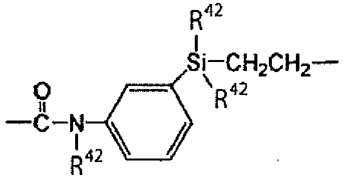 wherein each R⁴² independently represents a hydrogen atom, a C₁₋₆ alkyl group or a C₁₋₆ alkoxy group, preferably a methyl group or a methoxy group, more preferably a methyl group,
some other of the Ts is a carbon atom in groups opposite to PFPE as the molecular backbone (that is, in formula (A1), (A2), (D1) and (D2), and a Si atom in groups of the following formulae (B1), (B2), (C1) and (C2); and the remaining of the Ts, if present, is each independently a methyl group, a phenyl group, a C₁₋₆ alkoxy group, or a radical scavenging group or an UV absorbing group.

The radical scavenging group is not limited as long as it can scavenge a radical generated by light irradiation, and examples thereof include a residue of benzophenones, benzotriazoles, benzoates, phenyl salicylates, crotonic acids, malonates, organoacrylates, hindered amines, hindered phenols, or triazines.

The UV absorbing group is not limited as long as it can absorb ultraviolet light, and examples thereof include a residue of benzotriazoles, hydroxybenzophenones, esters of substituted and unsubstituted benzoic acid or salicylic acid compounds, acrylates or alkoxy cinnamates, oxamides, oxanilides, benzoxazinones, and benzoxazoles.

In a preferable embodiment, examples of a preferable radical scavenging group or UV absorbing group include:

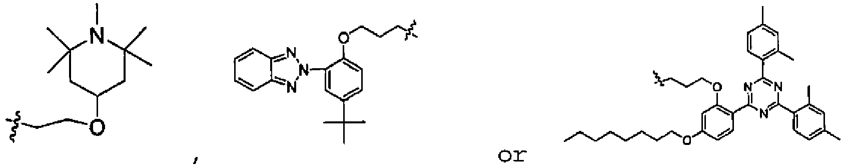

In this embodiment, X¹⁰¹, X¹⁰⁵, X¹⁰⁷, and X¹⁰⁹ may each be independently a tri- to decavalent organic group.

In the surface-treating agent of the present disclosure, the compounds represented by formulae (A2), (B2), (C2) and (D2) are 0.1 mol% or more and 35 mol% or less, based on the compounds represented by formulae (A1), (B1), (C1), (D1) and (E1) (hereinafter, also referred to as component (1)") and the compounds represented by formulae (A2), (B2), (C2) and (D2) (hereinafter, also referred to as "component (2)") in total. The lower limit of the content of the compounds represented by formulae (A2), (B2), (C2), and (D2) with respect to the component (2) may be preferably 0.1 mol%, more preferably 0.2 mol%, further preferably 0.5 mol%, still more preferably 1 mol%, particularly preferably 2 mol%, especially 5 mol%. The upper limit of the content of the compounds represented by formulae (A2), (B2), (C2), and (D2) relative to the component (2) may be preferably 35 mol%, more preferably 30 mol%, further preferably 20 mol%, still more preferably 15 mol% or 10 mol%. The compounds represented by formulae (A2), (B2), (C2), and (D2) with respect to the component (2) are preferably 0.1 mol% or more and 30 mol% or less, more preferably 0.1 mol% or more and 20 mol% or less, further preferably 0.2 mol% or more and 10 mol% or less, still more preferably 0.5 mol% or more and 10 mol% or less, particularly preferably 1 mol% or more and 10 mol% or less, for example 2 mol% or more and 10 mol% or less, or 5 mol% or more and 10 mol% or less. The friction durability can be further improved by setting the component (2) in such a range.

The combination of the components (1) and (2) in the surface-treating agent is preferably a combination of the compound represented by formula (A1) and the compound represented by formula (A2), a combination of the compound represented by formula (B1) and the compound represented by formula (B2), a combination of the compound represented by formula (C1) and the compound represented by formula (C2), or a combination of the compound represented by formula (D1) and the compound represented by formula (D2).

In the compounds represented by formula (A1) and formula (A2), t is preferably 2 or more, more preferably an integer of 2 to 10, and further preferably an integer of 2 to 6. By setting t to 2 or more, a plurality of Si atoms having R¹⁵ are present, and higher durability can be obtained.

In the compounds represented by formula (C1) and formula (C2), k is preferably 2 or 3, and more preferably 3.

In a preferable embodiment, the compounds represented by formula (C1) and formula (C2) have a -Si-(Z-SiR⁷²₃)₂ or - Si-(Z-SiR⁷²₃)₃ structure, and further preferably have a -Si-(Z-SiR⁷²₃)₃ structure, at an end. The compound can have such a structure at the end, thereby allowing high durability to be obtained.

In the compounds represented by formula (D1) and formula (D2), 1' is preferably 2 or 3, and more preferably 3.

In a preferable embodiment, the compounds represented by formula (D1) and formula (D2) have a -C-(Y-SiR⁸⁵₃)₂ or - Si-(Y-SiR⁸⁵)₃ structure, and further preferably has a -Si-(Y-SiR⁸⁵)₃ structure, at an end. The compound can have such a structure at the end, thereby allowing high durability to be obtained.

In one embodiment, the compound (β) is a compound represented by formula (A1), (B1), (C1), (D1), or (E1).

In one embodiment, the compound (β) is a compound represented by formula (A2), (B2), (C2), or (D2).

In one embodiment, the compound (β) is a compound represented by formula (A1), (A2), (C1), (C2), (D1), (D2), or (E1). Since these compounds may have a plurality of Si atoms having a hydroxyl group or a hydrolyzable group at the end, higher friction durability can be obtained.

In one embodiment, the compound (β) is a compound represented by the above (C1), (C2), (D1), (D2), or (E1).

In one embodiment, the compound (β) is a compound represented by the above (C1), (C2), (D1), or (D2).

In one embodiment, the compound (β) is compounds represented by formulae (A1) and (A2).

In one embodiment, the compound (β) is compounds represented by formulae (B1) and (B2).

In one embodiment, the compound (β) is compounds represented by formulae (C1) and (C2). By using the compounds represented by formulae (C1) and (C2) as the compound (β), friction durability and surface lubricity are improved. Furthermore, the miscibility with a compound having an isocyanuric skeleton such as the compound (α) is improved.

In one embodiment, the compound (β) is a compound represented by formulae (D1) and (D2).

In one embodiment, the compound (β) is a compound represented by formula (E1).

Examples of preferred compound (E1) include compounds (1-1) to (1-8) of the following formulae. These compounds are preferable because they are easy to produce industrially, easy to handle, and provide excellent water- and oil-repellency, frictional resistance, fingerprint stain removability, lubricity, and appearance of the surface-treating layer.

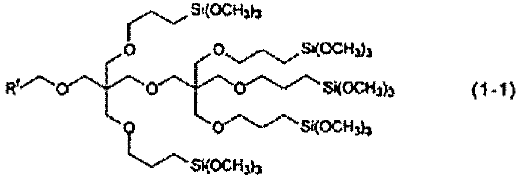

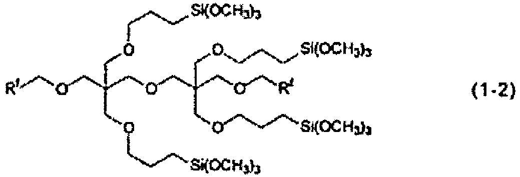

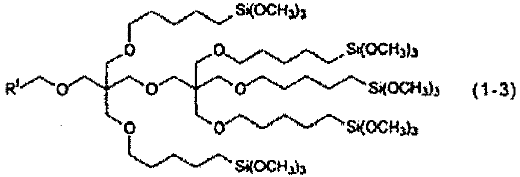

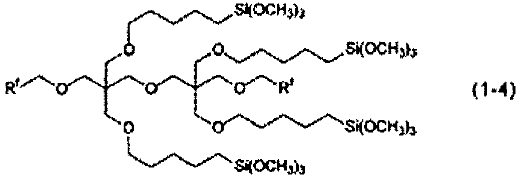

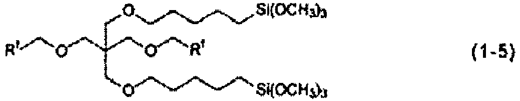

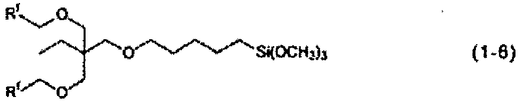

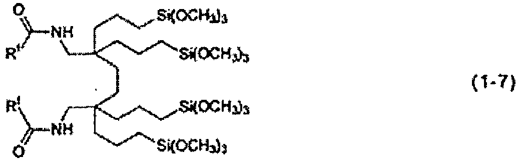

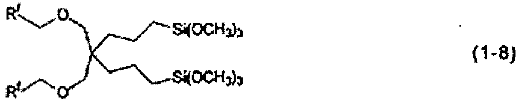

The number average molecular weight of the compound (β) used in the present disclosure is preferably 1,000 to 30,000, more preferably 1,500 to 30,000, further preferably 2,000 to 10,000.

In the surface-treating agent of the present disclosure, the weight ratio of the compound (α) to the compound (β) may be preferably 1:99 to 99:1, more preferably 5:95 to 90:10, further preferably 30:70 to 90:10, still more preferably 30:70 to 70:30. By setting the weight ratio of the compound (α) to the compound (β) within such a range, excellent UV durability and surface lubricity, abrasion durability such as eraser durability and steel wool durability can be achieved at the same time.

In one embodiment, the ratio of the number average molecular weight of the compound (α) and the number average molecular weight of the compound (β) may be preferably 9:1 to 1:9, more preferably 7:3 to 3:7, further preferably 6:4 to 4:6.

In one embodiment, the number average molecular weight of compound (α) is larger than the number average molecular weight of compound (β). In the case where the number average molecular weight of the compound (α) is larger than the number average molecular weight of the compound (β), preferably when the number average molecular weight ratio is in a relationship of 7:3 to 6:4 (compound (α) :compound (β)), the dynamic friction coefficient decreases, and thus the surface lubricity can be improved.

In another embodiment, the number average molecular weight of the compound (α) is less than or equal to the number average molecular weight of the compound (β). In the case where the number average molecular weight of the compound (α) is less than or equal to the number average molecular weight of the compound (β), preferably when the number average molecular weight ratio is 5:5 to 2:8 (compound (α) :compound (β)), not only can the dynamic friction coefficient be decreased to improve the surface lubricity, but also the abrasion resistance can be improved.

The compounds represented by formulae (A1), (A2), (B1), (B2), (C1), (C2), (D1), (D2), and (E1) can be produced by a method known in the art.

The surface-treating agent of the present disclosure may contain another silane compound in addition to the compound (α) and the compound (β).

Examples of the other silane compound include a compound represented by formula (α1') and a compound represented by formula (α2') in which the isocyanuric rings of the compound represented by formula (α1) and the compound represented by formula (α2) are opened, respectively: 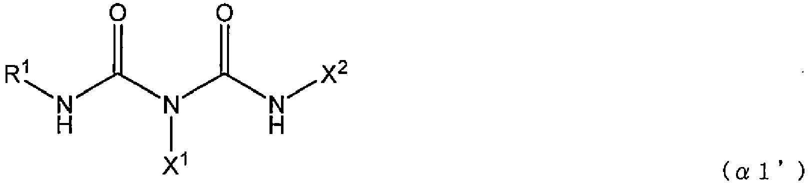 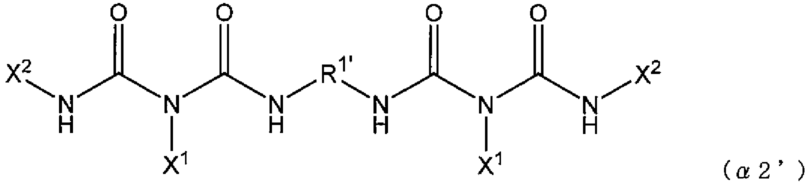 wherein each symbol has the same meaning as in formula (α1) and formula (a2); and
silane compounds having the same structure as formulae (A1), (A2), (B1), (B2), (C1), (C2), (D1), (D2), and (E1), except that the perfluoropolyether group does not have an OCF₂ unit.

Examples of the perfluoropolyether group not having an OCF₂ unit include

- (OC₆F₁₂)ₘ₁₁-(OC₅F₁₀)ₘ₁₂-(OC₄F₈)ₘ₁₃-(OC₃X¹⁰₆)ₘ₁₄-(OC₂F₄)ₘ₁₅-

wherein each symbol has the same meaning as the polyether chain.

The perfluoropolyether group not having an OCF₂ unit may also be a group represented by the following formula:

- (OC₃X¹⁰₆)ₘ₁₄-

wherein m14 and X¹¹ are the same meaning as described above, preferably X¹¹ is F, and
a group represented by the following formula:

   - (OC₂F₄-R¹¹)_{f}-
wherein R¹¹ is a group selected from OC₂F₄, OC₃F₆, and OC₄F₈, and f is an integer of 2 to 100.

-(OC₃X¹⁰₆)ₘ₁₄- is preferably -(OC₃F₆)ₘ₁₄-, more preferably -(OCF(CF₃)CF₂)ₘ₁₄- or -(OCF₂CF₂CF₂)ₘ₁₄-, particularly preferably -(OCF₂CF₂CF₂)ₘ₁₄-.

These other silane compounds may or may not be contained in the surface-treating agent, and in the case where they are contained, they may be preferably added 0.01 to 20 parts by mole, more preferably 0.1 to 15 parts by mole, for example, 1 to 10 parts by mole or 3 to 5 parts by mole, based on 100 parts by mole in total of the compound (α).

In addition to the compound (α) and the compound (β), the surface-treating agent of the present disclosure may contain compounds derived from the synthesis of the compound, for example, a compound represented by R¹-OSO₂CF₃ or CF₃SO₂OR^{1'}-OSO₂CF₃.

The surface-treating agent of the present disclosure may contain a (unreactive) fluoropolyether compound which can be understood as a fluorine-containing oil, preferably a perfluoro (poly) ether compound (hereinafter, referred to as "fluorine-containing oil") . In the case where such a fluorine-containing oil is contained, the surface lubricity of the surface-treating layer formed by using the surface-treating agent can be further improved.

The fluorine-containing oil is not limited, and examples thereof include a compound (perfluoropolyether compound) represented by the following general formula (3):

Rf¹-(OC₄F₈)_{a'}-(OC₃F₆)_{b'}-(OC₂F₄)_{c'}-(OCF₂)_{d'}-Rf² ... (3)

wherein Rf¹ represents a C₁₋₁₆ alkyl group optionally substituted with one or more fluorine atoms (preferably, C₁₋₁₆ perfluoroalkyl group), Rf² represents a C₁₋₁₆ alkyl group optionally substituted with one or more fluorine atoms (preferably, C₁₋₁₆ perfluoroalkyl group), a fluorine atom or a hydrogen atom, and Rf¹ and Rf² are each independently, more preferably, a C₁₋₃ perfluoroalkyl group,
a', b', c' and d' represent the respective four numbers of repeating units in perfluoropolyether constituting a main backbone of the polymer and are mutually independently an integer of 0 or more and 300 or less, the sum of a', b', c' and d' is at least 1, preferably 1 to 300, more preferably 20 to 300, the occurrence order of the respective repeating units in parentheses with the subscript a', b', c' or d' is not limited in the formula, and, among such repeating units, for example, -(OC₄F₈)- may be any of -(OCF₂CF₂CF₂CF₂)-, - (OCF(CF₃)CF₂CF₂)-, -(OCF₂CF(CF₃)CF₂)-, -(OCF₂CF₂CF(CF₃))-, - (OC(CF₃)₂CF₂)-, -(OCF₂C(CF₃)₂)-, -(OCF(CF₃)CF(CF₃)) -, - (OCF(C₂F₅)CF₂)- and -(OCF₂CF(C₂F₅))-, and is preferably - (OCF₂CF₂CF₂CF₂)-, -(OC3F₆)- may be any of - (OCF₂CF₂CF₂)-, - (OCF(CF₃)CF₂)- and -(OCF₂CF(CF₃))-, and is preferably - (OCF₂CF₂CF₂)-, and -(OC₂F₄)- may be any of -(OCF₂CF₂)- and - (OCF(CF₃))-, and is preferably -(OCF₂CF₂)-.

Examples of the perfluoropolyether compound represented by general formula (3) include a compound represented by any of the following general formulae (3a) and (3b) (which may be adopted singly or as a mixture of two or more kinds thereof).

Rf¹-(OCF₂CF₂CF₂)_{b"}-Rf² ... (3a)

Rf¹-(OCF₂CF₂CF₂CF₂)_{a"}-(OCF₂CF₂CF₂)_{b"}-(OCF₂CF₂)_{c"}-(OCF₂)_{d"}-Rf² ··· (3b)

In such formulae, Rf¹ and Rf² are as described above; in formula (3a), b" is an integer of 1 or more and 100 or less; and, in formula (3b), a" and b" are each independently an integer of 0 or more and 30 or less, for example, an integer of 1 or more and 30 or less, c" and d'' are each independently an integer of 1 or more and 300 or less. The occurrence order of the respective repeating units in parentheses with the subscript a", b", c" or d" is not limited in the formula.

The fluorine-containing oil may have a number average molecular weight of 1,000 to 30,000. This allows high surface lubricity to be obtained.

The surface-treating agent in the present disclosure may or may not contain the fluorine-containing oil, and in the case of containing the fluorine-containing oil, may contain, for example, 0.1 to 500 parts by mass, preferably 1 to 400 parts by mass, and more preferably 5 to 300 parts by mass of such fluorine-containing oil based on 100 parts by mass in total of the perfluoropolyether group-containing compounds (in the case of two or more kinds, the total thereof, much the same is true on the following).

The compound represented by general formula (3a) and the compound represented by general formula (3b) may be used alone or in combination. It is preferable to use the compound represented by general formula (3b) rather than the compound represented by general formula (3a), as it provides higher surface lubricity. In the case where these are used in combination, the mass ratio of the compound represented by general formula (3a) and the compound represented by general formula (3b) is preferably 1:1 to 1:30, more preferably 1:1 to 1:10. With such a mass ratio, a surface-treating layer with an excellent balance between surface lubricity and frictional durability can be obtained.

In one embodiment, the fluorine-containing oil contains one or more of the compounds represented by general formula (3b). In such an embodiment, the mass ratio between the fluoro(poly)ether group-containing compounds in total and the compound represented by formula (3b) in the surface-treating agent is preferably 10:1 to 1:10, more preferably 4:1 to 1:4.

In one embodiment, the average molecular weight of the compound represented by formula (3a) is preferably 2,000 to 8,000.

In one embodiment, the average molecular weight of the compound represented by formula (3b) is preferably 8,000 to 30,000.

In another embodiment, the average molecular weight of the compound represented by formula (3b) is preferably 3,000 to 8,000.

In a preferable embodiment, in the case where the surface-treating layer is formed by the vacuum deposition method, the average molecular weight of the fluorine-containing oil may be larger than the average molecular weight of the compound (α) and the average molecular weight of the compound (β). The compound may have such a number average molecular weight, thereby allowing more excellent friction durability and surface lubricity to be obtained.

The fluorine-containing oil may be a compound represented by general formula Rf³-F, wherein Rf³ is a C₅₋₁₆ perfluoroalkyl group, from another viewpoint. It may also be a chlorotrifluoroethylene oligomer. The compound represented by Rf³-F and the chlorotrifluoroethylene oligomer are preferable in that high affinity with the fluorine-containing compound having a carbon-carbon unsaturated bond where an end thereof is a C₁₋₁₆ perfluoroalkyl group is obtained.

In the case where the surface-treating agent of the present disclosure contains a (unreactive) silicone compound that can be understood as (d) the silicone oil (hereinafter referred to as "silicone oil"), the surface lubricity of the surface-treating layer formed by using the surface-treating agent can be further improved.

For example, a linear or cyclic silicone oil having 2,000 or less siloxane bonds can be used as the silicone oil. The linear silicone oil may be so-called straight silicone oil and modified silicone oil. Examples of the straight silicone oil include dimethyl silicone oil, methylphenyl silicone oil and methylhydrogen silicone oil. Examples of the modified silicone oil include straight silicone oil modified with alkyl, aralkyl, polyether, higher fatty acid ester, fluoroalkyl, amino, epoxy, carboxyl, alcohol and the like. Examples of the cyclic silicone oil include cyclic dimethylsiloxane oil.

The surface-treating agent in the present disclosure may contain, for example, 0 to 300 parts by mass, preferably 0 to 200 parts by mass of such silicone oil based on 100 parts by mass in total of the compound (α) and the compound (β) (in the case of two or more kinds, the total thereof, much the same is true on the following).

The surface-treating agent of the present disclosure may include any catalyst, solvent, alcohol, transition metal, halide ion, compound containing an atom having an unshared electron pair in a molecular structure, or the like, as described above.

Examples of the catalyst include acids (for example, acetic acid and trifluoroacetic acid), bases (for example, ammonia, triethylamine, and diethylamine), and transition metals (for example, Ti, Ni, and Sn).

The catalyst promotes hydrolysis and dehydration condensation of the silane compound to accelerate formation of the coating layer.

Examples of the transition metal include platinum, ruthenium and rhodium.

Examples of the halide ion include chloride ion.

The compound containing an atom having an unshared electron pair in the molecular structure preferably contains at least one atom selected from the group consisting of a nitrogen atom, an oxygen atom, a phosphorus atom and a sulfur atom, more preferably a sulfur atom or a nitrogen atom.

The compound containing an atom having an unshared electron pair in the molecular structure preferably contains at least one functional group selected from the group consisting of an amino group, an amide group, a sulfinyl group, a P=O group, an S=O group and a sulfonyl group, and more preferably contains at least one functional group selected from the group consisting of a P=O group and an S=O groups, in the molecular structure.

The compound containing an atom having an unshared electron pair in the molecular structure is preferably at least one compound selected from the group consisting of an aliphatic amine compound, an aromatic amine compound, a phosphoric acid amide compound, an amide compound, a urea compound and a sulfoxide compound, more preferably at least one compound selected from the group consisting of an aliphatic amine compound, aromatic amines, phosphoric acid amide, an urea compound and a sulfoxide compounds, particularly preferably a sulfoxide compound, an aliphatic amine compound and an aromatic amine compound, further preferably a sulfoxide compound.

Examples of the aliphatic amine compound include diethylamine and triethylamine. Examples of the aromatic amine compound include aniline and pyridine. Examples of the phosphoric acid amide compound include hexamethylphosphoramide. Examples of the amide compound include N,N-diethylacetamide, N,N-diethylformamide, N,N-dimethylacetamide, N-methylformamide, N,N-dimethylformamide, and N-methylpyrrolidone. Examples of the urea compound include tetramethylurea. Examples of the sulfoxide compound include dimethyl sulfoxide (DMSO), tetramethylene sulfoxide, methylphenyl sulfoxide, and diphenyl sulfoxide. Among such compounds, dimethyl sulfoxide or tetramethylene sulfoxide is preferably used.

Examples of the alcohol include alcohol compounds having 1 to 6 carbon atoms.

Examples of the solvent include a C₅₋₁₂ perfluoroaliphatic hydrocarbon (for example, perfluorohexane, perfluoromethylcyclohexane and perfluoro-1,3-dimethylcyclohexane); a polyfluoroaromatic hydrocarbon (for example, bis(trifluoromethyl)benzene); a polyfluoroaliphatic hydrocarbon (for example, C₆F₁₃CH₂CH₃ (for example, ASAHI KLIN (R) AC-6000, manufactured by Asahi Glass Co., Ltd., and 1,1,2,2,3,3,4-heptafluorocyclopentane (for example, ZEORORA-H (R) manufactured by ZEON CORPORATION)); a hydrofluorocarbon (HFC) (for example, 1, 1, 1, 3, 3-pentafluorobutane (HFC-365mfc)); a hydrochlorofluorocarbon (for example, HCFC-225 (ASAHI KLIN (R) AK225)); and a hydrofluoroether (HFE) (for example, an alkyl perfluoroalkylether (a perfluoroalkyl group and an alkyl group may be linear or branched) such as perfluoropropyl methyl ether (C₃F₇OCH₃) (for example, Novec (trade name) 7000, manufactured by SUMITOMO 3M), perfluorobutyl methyl ether (C₄F₉OCH₃) (for example, Novec (trade name) 7100, manufactured by SUMITOMO 3M), perfluorobutyl ethyl ether (C₄F₉OC₂H₅) (for example, Novec (trade name) 7200, manufactured by SUMITOMO 3M), perfluorohexyl methyl ether (C₂F₅CF(OCH₃)C₃F₇) (for example, Novec (trade name) 7300 manufactured by SUMITOMO 3M) or CF₃CH₂OCF₂CHF₂ (for example, ASAHI KLIN (R) AE-3000, manufactured by Asahi Glass Co., Ltd.), 1,2-dichloro-1, 3, 3, 3-tetrafluoro--1--propene (for example, Vertrel (R) Sion, manufactured by Du Pont-Mitsui Fluorochemicals Co., Ltd.). Such a solvent may be used singly or as a mixture prepared by mixing two or more solvents in combination. To control, e.g., solubility of the perfluoropolyether group-containing silane compound, another solvent may be mixed.

In addition to the above, examples of other components include tetraethoxysilane, methyltrimethoxysilane, 3-aminopropyltrimethoxysilane, 3-glycidoxypropyltrimethoxysilane, and methyltriacetoxysilane.

In the surface-treating agent of the present disclosure, the total concentration of the compound (α) and the compound (β) is preferably 0.001 to 1% by mass, more preferably 0.005 to 0.5% by mass, further preferably from 0.01 to 0.2% by mass.

The surface-treating agent of the present disclosure can be formed into a pellet by impregnating a porous material, for example, a porous ceramic material or a metal fiber for example that obtained by solidifying a steel wool, therewith. The pellet may be used for vacuum deposition, for example.

The present disclosure also provides an article having a surface-treating layer formed by the surface-treating agent of the present disclosure.

The article of the present disclosure comprises: a base material; and a layer disposed on a surface of the base material, the layer being formed by the above-described surface-treating agent (a surface-treating layer, for example, a stain-proof coating layer).

The base material may be any suitable material such as glass, a resin (which may be a natural or synthetic resin, for example, a common plastic material, and may be in the form of a plate, a film, or the like), a metal (which may be a single substance of a metal such as aluminum, copper, iron, zinc, titanium or zirconium, or a composite such as an alloy thereof), ceramics, a semiconductor (silicon, germanium, or the like), a fiber (woven cloth, unwoven cloth, or the like), fur, leather, a wood material, a ceramic material, a stone material, or a building material.

The glass is preferably sapphire glass, soda-lime glass, alkali aluminosilicate glass, borosilicate glass, alkali-free glass, crystal glass, or quartz glass, particularly preferably chemically strengthened soda-lime glass, chemically strengthened alkali aluminosilicate glass, and chemically bonded borosilicate glass.

The resin is preferably acrylic resin or polycarbonate.

In one embodiment, in a case where the article to be produced is an optical member, the material constituting the surface of the base material may be a material for optical members, such as glass or transparent plastic. In a case where the article to be produced is an optical member, some layer (or film) such as a hard coat layer or an antireflection layer may be formed on the surface (outermost layer) of the base material. Either a single layer or a multi-layered antireflection layer may be used for the antireflection layer. Examples of inorganic materials that may be used for the antireflection layer are SiO₂, SiO, ZrO₂, TiO₂, TiO, Ti₂O₃, Ti₂O₅, Al₂O₃, Ta₂O₅, CeO₂, MgO, Y₂O₃, SnO₂, MgF₂, WO₃, and SiN. Such an inorganic substance may be used alone or in combination of two or more thereof (for example, as a mixture) . In the case of a multi-layered antireflection layer, it is preferable to use SiO₂ and/or SiO as the outermost layer. In the case where the article to be produced is an optical glass component for a touch panel, a thin film using a transparent electrode, such as indium tin oxide (ITO) or indium zinc oxide, may be provided on a portion of the surface of the base material (glass) . The base material may have an insulating layer, an adhesive layer, a protecting layer, a decorated frame layer (I-CON), an atomizing film layer, a hard coating layer, a polarizing film, a phase difference film, a liquid crystal display module, or the like, depending on the specific specifications and the like.

For example, such a base material may include any material originally having a hydroxyl group at least on a surface portion thereof. Examples of such any material include glass, as well as a metal (in particular, base metal) where a natural oxidized film or a thermal oxidized film is to be formed on the surface, ceramics and a semiconductor. Alternatively, when the base material has a hydroxyl group but insufficiently or when the base material originally does not have any hydroxyl group, as in a resin and the like, the base material may be subjected to any pre-treatment to thereby introduce or increase a hydroxyl group onto the surface of the base material. Examples of such a pre-treatment include a plasma treatment (for example, corona discharge) and ion beam irradiation. Such a plasma treatment may be suitably utilized to not only introduce or increase a hydroxyl group onto the surface of the base material, but also clean the surface of the base material (removal of foreign substances and the like). Another example of such a pre-treatment includes a method involving forming an interface adsorbent having a carbon-carbon unsaturated bonding group, in the form of a monomolecular film, on the surface of the base material in advance according to a LB method (Langmuir-Blodgett method), a chemical adsorption method, or the like, and thereafter cleaving an unsaturated bond under an atmosphere containing oxygen, nitrogen, and the like.

Alternatively, for example, the base material may include, at least on a surface portion thereof, a silicone compound having at least another reactive group, such as a Si-H group, or a material including alkoxysilane.

The shape of the base material is not limited. Further, the surface region of the base material on which the surface-treating layer is to be formed may be at least a part of the surface of the base material, and can be appropriately determined depending on the applications and specific specifications of the article to be produced.

Next, a method of forming a surface-treating layer on a surface of such a base material will be described. The method of forming the surface-treating layer includes a step of supplying the surface-treating agent to the surface of the base material to form the surface-treating layer on the surface of the base material. More specifically, a film of the surface-treating agent is formed, and this film is post-treated as necessary, thereby forming a surface-treating layer from the surface-treating agent of the present disclosure.

The method of forming a film of the surface-treating agent is not limited. For example, a wet coating method and a dry coating method may be used.

Examples of the wet coating method include dip coating, spin coating, flow coating, spray coating, roll coating, gravure coating, and similar methods.

Examples of the dry coating method include deposition (usually, vacuum deposition), sputtering, CVD, and similar methods. Specific examples of the deposition method (usually, vacuum deposition method) include resistive heating, highfrequency heating using electron beam, microwave or the like, ion beam, and similar methods. Specific examples of the CVD method include plasma-CVD, optical CVD, thermal CVD, and similar methods.

Furthermore, coating according to an atmospheric pressure plasma method may also be made.

In the case of using the dry coating method, the surface-treating agent may be subjected to the dry coating method as-is, or may be diluted with the solvent exemplified for the wet coating method before being subjected to the dry coating method. For example, the surface-treating agent may be deposited as-is (usually by vacuum deposition) or may be deposited (usually by vacuum deposition) using a pellet-like substance impregnated with the surface-treating agent on a metal porous body or a ceramic porous body such as iron or copper.

In a preferable embodiment, a deposition method is used to form the film of the surface-treating agent, more preferably at least one of CVD and radio frequency heating (in particular, resistive heating, electron beam), particularly preferably an electron beam.

Examples of the post-treatment include heat treatment. The temperature of the heat treatment is not limited, and may be, for example, 60 to 250°C, preferably 100°C to 180°C. The time of the heat treatment time is not limited, and may be, for example, 30 minutes to 5 hours, preferably 1 to 3 hours.

The thickness of the surface-treating layer is not limited. In the case of an optical member, the thickness of the surface-treating layer is in the range of 1 to 50 nm, preferably 1 to 30 nm, more preferably 1 to 15 nm, from the viewpoint of the optical performance, surface lubricity, friction durability and antifouling property.

As described above, a surface-treating layer is formed on the surface of the base material by using the surface-treating agent.

In one embodiment, the article of the present disclosure is an optical material having a surface-treating layer as the outermost layer.

Example of the optical material, in addition to the optical material for the display and the like, preferably include a wide variety of optical materials: a display such as a cathode ray tube (CRT; for example, a personal computer monitor), a liquid crystal display, a plasma display, an organic EL display, an inorganic thin-film EL dot matrix display, a rear projection display, a vacuum fluorescent display (VFD), a field emission display (FED), or a protective plate of such a display, or those having a surface treated with an antireflection film.

The article having the surface-treating layer is not limited, and may be an optical member. Examples of the optical member include the following: lenses such as eyeglasses; front surface protective plates for displays such as PDPs and LCDs, antireflection plates, polarizing plates, anti-glare plates; touch panel sheets for devices such as mobile phones and personal digital assistants; disc surfaces of optical disc such as Blu-ray (R) disc, DVD disc, CD-R, MO; optical fibers; and clock display surfaces.

Further, the article having the surface-treating layer may be a medical equipment or a medical material.

The articles obtained by using the surface-treating agent of the present disclosure have been described above in detail. It should be noted that the application, usage and production method of the surface-treating agent of the present disclosure are not limited to those exemplified above.

### Examples

The present disclosure will be described by way of Examples, but the present disclosure is not limited to such Examples. In the present Examples, all of the chemical formulae shown below represent average compositions, and the occurrence order of the repeating unit constituting the perfluoropolyether ((CF₂CF₂CF₂O), (CF₂CF₂O), (CF₂O), etc.) is not limited.

### Synthesis Example 1

The following compound (A) was synthesized according to the method disclosed in Patent Literature 1. A product (A) obtained by the synthesis contained the following compounds (B) to (I):

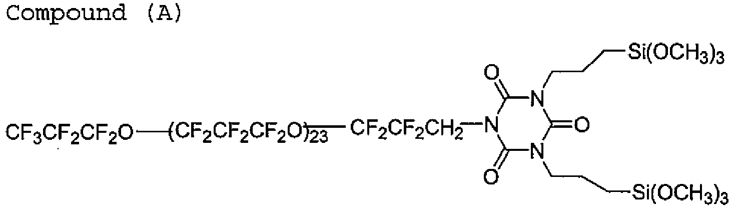

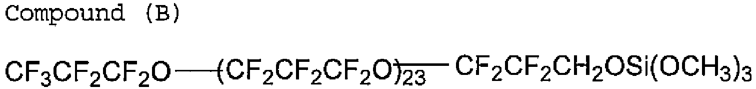

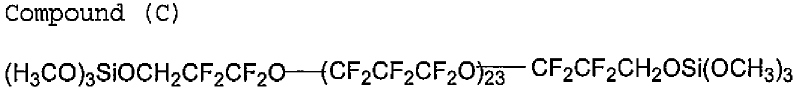

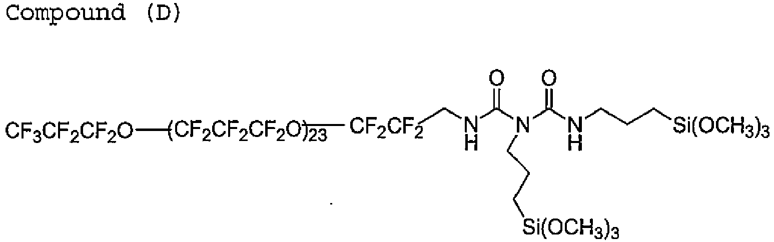

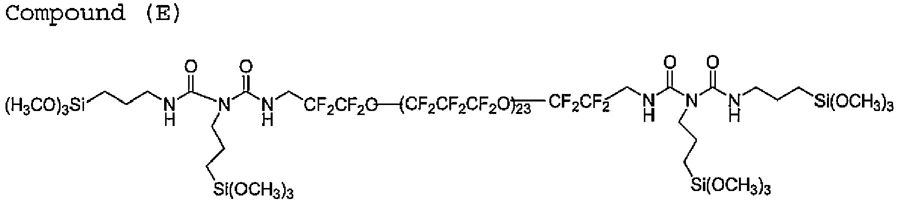

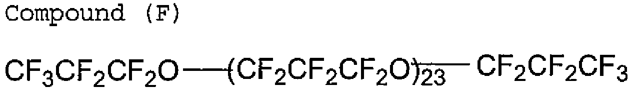

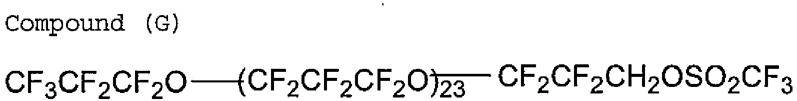

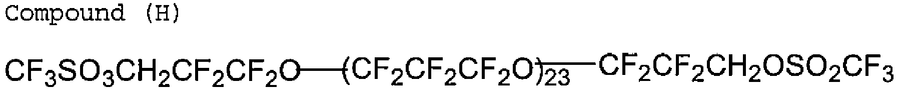

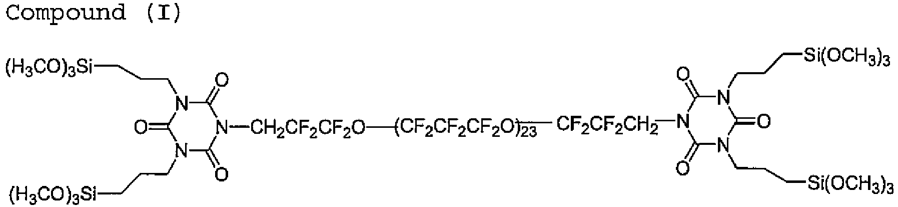

The composition (molar ratio) of the product (A) was 61% for the compound (A), 2% for the compound (B), 2% for the compound (D), 2% for the compound (E), and 20% for the compound (F), and 13% for the compound (I).

The product (A) obtained in Synthesis Example 1 was dissolved in hydrofluoroether (Novec HFE 7200, manufactured by 3M Company) so that the concentration of the product (A) was 20 wt% thereby preparing a chemical solution (A).

### Synthesis Example 2

Next, according to the method disclosed in Patent Literature 1, the compound (A) was synthesized and purified to obtain a product (B). The composition (molar ratio) of the product (B) obtained by the synthesis was 91% for the compound (A), 4% for the compound (B), and 5% for the compound (D).

The product (B) obtained in Synthesis Example 2 was dissolved in hydrofluoroether (Novec HFE 7200, manufactured by 3M Company) so that the concentration of the product (B) was 20 wt% thereby preparing a chemical solution (B).

### Example 1-(1)

A mixture containing the following compound (J) (91.0 mol%) and compound (K) (9.0 mol%) was dissolved in hydrofluoroether (Novec HFE 7200, manufactured by 3M Company) so that the concentration thereof was 20 wt% thereby preparing a chemical solution (C).

Compound (J) CF₃O-(CF₂CF₂O)ₘ(CF₂O)ₙCF₂CH₂OCH₂CH₂CH₂Si(CH₂CH₂CH₂Si(OCH₃)₃)₃ (m = 22, n = 19)

Compound (K) ((H₃CO)₃SiCH₂CH₂CH₂)₃SiCH₂CH₂CH₂OCH₂CF₂O-(CF₂CF₂O)m(CF₂O)ₙCF₂CH₂OCH₂CH₂CH₂Si(CH₂CH₂CH₂Si(OCH₃)₃)₃ (m = 22, n = 19)

The chemical solution (A) and the chemical solution (C) were sufficiently mixed at a weight ratio of 8:2 to obtain a surface treatment liquid (A). Then, it was vacuum-deposited on a chemically strengthened glass ("Gorilla" glass manufactured by Corning, thickness 0.7 mm) . The vacuum deposition was performed at a pressure of 3.0 × 10⁻³ Pa, and silicon dioxide was first deposited at a thickness of 7 nm on the surface of the chemically strengthened glass to form a silicon dioxide film, and then 2 mg of the surface-treating agent (A) was deposited per sheet of chemically strengthened glass (55 mm × 100 mm). Then, the chemically strengthened glass with a vapor deposition film was heated at 140°C for 30 minutes in a thermostatic chamber in the air. Thereby, the vapor deposition film was cured and a base material (1) having a surface-treating layer was obtained.

### Example 1-(2)

A base material (2) was obtained in the same manner as in the production of the base material (1) of Example 1-(1), except that the chemical solution (A) and the chemical solution (C) were sufficiently mixed at a weight ratio of 5:5.

### Example 2-(1)

A base material (3) was obtained in the same manner as in the production of the base material (1) of Example 1-(1), except that the chemical solution (B) and the chemical solution (C) were sufficiently mixed at a weight ratio of 9:1.

### Example 2-(2)

A base material (4) was obtained in the same manner as in the production of the base material (1) of Example 1-(1), except that the chemical solution (B) and the chemical solution (C) were sufficiently mixed at a weight ratio of 8:2.

### Example 2-(3)

A base material (5) was obtained in the same manner as in the production of the base material (1) of Example 1-(1), except that the chemical solution (B) and the chemical solution (C) were sufficiently mixed at a weight ratio of 7:3.

### Example 2-(4)

A base material (6) was obtained in the same manner as in the production of the base material (1) of Example 1-(1), except that the chemical solution (B) and the chemical solution (C) were sufficiently mixed at a weight ratio of 5:5.

### Example 2-(5)

A base material (7) was obtained in the same manner as in the production of the base material (1) of Example 1-(1), except that the chemical solution (B) and the chemical solution (C) were sufficiently mixed at a weight ratio of 3:7.

### Example 3-(1)

A mixture containing the following compound (L) (91.0 mol%) and compound (M) (9.0 mol%) was dissolved in hydrofluoroether (Novec HFE 7200, manufactured by 3M Company) so that the concentration thereof was 20 wt% thereby preparing a chemical solution (D).

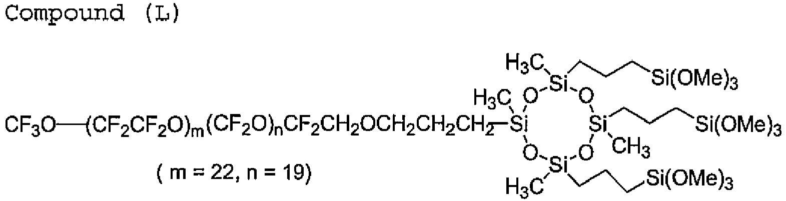

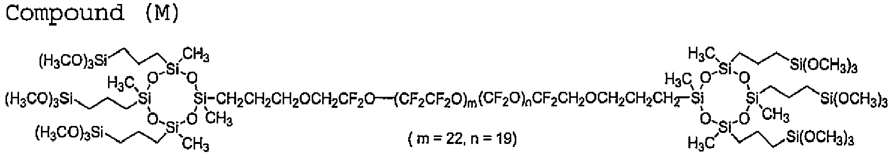

A base material (8) was obtained in the same manner as in the production of the base material (1) of Example 1-(1), except that the chemical solution (B) and the chemical solution (D) were sufficiently mixed at a weight ratio of 8:2.

### Example 3-(2)

A base material (9) was obtained in the same manner as in the production of the base material (1) of Example 1-(1), except that the chemical solution (B) and the chemical solution (D) were sufficiently mixed at a weight ratio of 7:3.

### Example 3-(3)

A base material (10) was obtained in the same manner as in the production of the base material (1) of Example 1-(1), except that the chemical solution (B) and the chemical solution (D) were sufficiently mixed at a weight ratio of 5:5.

### Example 4-(1)

A mixture of the compound (J), the compound (K), and the compound (N) having a composition ratio (molar ratio) of 82%, 8%, and 10%, respectively, was dissolved in hydrofluoroether (Novec HFE 7200, manufactured by 3M Company) so that the concentration thereof was 20 wt% thereby preparing a chemical solution (E).

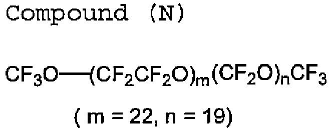

A base material (11) was obtained in the same manner as in the production of the base material (1) of Example 1-(1), except that the chemical solution (B) and the chemical solution (E) were sufficiently mixed at a weight ratio of 5:5.

### Example 4-(2)

A base material (12) was obtained in the same manner as in the production of the base material (1) of Example 1-(1), except that the chemical solution (B) and the chemical solution (E) were sufficiently mixed at a weight ratio of 4:6.

### Example 4-(3)

A base material (13) was obtained in the same manner as in the production of the base material (1) of Example 1-(1), except that the chemical solution (B) and the chemical solution (E) were sufficiently mixed at a weight ratio of 3:7.

### Example 4-(4)

A base material (14) was obtained in the same manner as in the production of the base material (1) of Example 1-(1), except that the chemical solution (B) and the chemical solution (E) were sufficiently mixed at a weight ratio of 2:8.

### Comparative Example 1-(1)

The following compound (O) was dissolved in hydrofluoroether (Novec HFE 7200, manufactured by 3M Company) so that the concentration was 20 wt% thereby preparing a chemical solution (F).

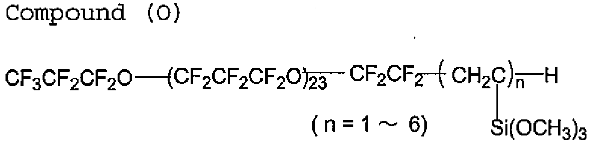

A base material (15) was obtained in the same manner as in the production of the base material (1) of Example 1-(1), except that the chemical solution (A) and the chemical solution (F) were sufficiently mixed at a weight ratio of 8:2.

### Comparative Example 1-(2)

A base material (16) was obtained in the same manner as in the production of the base material (1) of Example 1-(1), except that the chemical solution (A) and the chemical solution (F) were sufficiently mixed at a weight ratio of 5:5.

### Comparative Example 2-(1)

The following compound (P) was dissolved in hydrofluoroether (Novec HFE 7200, manufactured by 3M Company) so that the concentration was 20 wt% thereby preparing a chemical solution (G).

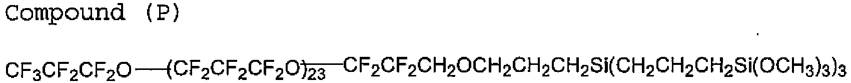

A base material (17) was obtained in the same manner as in the production of the base material (1) of Example 1-(1), except that the chemical solution (A) and the chemical solution (G) were sufficiently mixed at a weight ratio of 8:2.

### Comparative Example 2-(2)

A base material (18) was obtained in the same manner as in the production of the base material (1) of Example 1-(1), except that the chemical solution (A) and the chemical solution (G) were sufficiently mixed at a weight ratio of 5:5.

### Comparative Example 3-(1)

The following compound (Q) was dissolved in hydrofluoroether (Novec HFE 7200, manufactured by 3M Company) so that the concentration was 20 wt% thereby preparing a chemical solution (H).

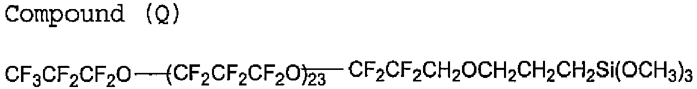

A base material (19) was obtained in the same manner as in the production of the base material (1) of Example 1-(1), except that the chemical solution (B) and the chemical solution (H) were sufficiently mixed at a weight ratio of 8:2.

### Comparative Example 3-(2)

A base material (20) was obtained in the same manner as in the production of the base material (1) of Example 1-(1), except that the chemical solution (B) and the chemical solution (H) were sufficiently mixed at a weight ratio of 5:5.

### Comparative Example 4-(1)

The following compound (R) was dissolved in hydrofluoroether (Novec HFE 7200, manufactured by 3M Company) so that the concentration was 20 wt% thereby preparing a chemical solution (I).

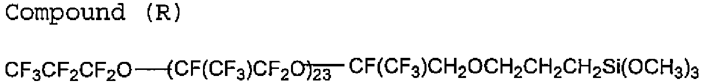

A base material (21) was obtained in the same manner as in the production of the base material (1) of Example 1-(1), except that the chemical solution (B) and the chemical solution (I) were sufficiently mixed at a weight ratio of 8:2.

### Comparative Example 4-(2)

A base material (22) was obtained in the same manner as in the production of the base material (1) of Example 1-(1), except that the chemical solution (B) and the chemical solution (I) were sufficiently mixed at a weight ratio of 5:5.

### Comparative Example 5-(1)

A base material (23) was obtained in the same manner as in the production of the base material (1) of Example 1-(1) using only the chemical solution (D).

Table 1 below shows the chemical solutions used in the respective Examples and Comparative Examples and their weight ratios.

**[Table 1]**

| | Base material | Chemical solution (weight ratio) | | | | | | | | |
|---|---|---|---|---|---|---|---|---|---|---|
| | | A | B | C | D | E | F | G | H | I |
| Example 1-1 | (1) | 8 | | 2 | | | | | | |
| Example 1-2 | (2) | 5 | | 5 | | | | | | |
| Example 2-1 | (3) | | 9 | 1 | | | | | | |
| Example 2-2 | (4) | | 8 | 2 | | | | | | |
| Example 2-3 | (5) | | 7 | 3 | | | | | | |
| Example 2-4 | (6) | | 5 | 5 | | | | | | |
| Example 2-5 | (7) | | 3 | 7 | | | | | | |
| Example 3-1 | (8) | | 8 | | 2 | | | | | |
| Example 3-2 | (9) | | 7 | | 3 | | | | | |
| Example 3-3 | (10) | | 5 | | 5 | | | | | |
| Example 4-1 | (11) | | 5 | | | 5 | | | | |
| Example 4-2 | (12) | | 4 | | | 6 | | | | |
| Example 4-3 | (13) | | 3 | | | 7 | | | | |
| Example 4-4 | (14) | | 2 | | | 8 | | | | |
| Comparative Example 1-1 | (15) | 8 | | | | | 2 | | | |
| Comparative Example 1-2 | (16) | 5 | | | | | 5 | | | |
| Comparative Example 2-1 | (17) | 8 | | | | | | 2 | | |
| Comparative Example 2-2 | (18) | 5 | | | | | | 5 | | |
| Comparative Example 3-1 | (19) | | 8 | | | | | | 2 | |
| Comparative Example 3-2 | (20) | | 5 | | | | | | 5 | |
| Comparative Example 4-1 | (21) | | 8 | | | | | | | 2 |
| Comparative Example 4-2 | (22) | | 5 | | | | | | | 5 |
| Comparative | (23) | | | | 10 | | | | | |
| Example 5-1 | | | | | | | | | | |

### (Test Example 1)

### • Method of measuring static contact angle of water

The static contact angle of water was measured by the following method using a fully automatic contact angle meter DropMaster700 (manufactured by Kyowa Interface Science Co., Ltd.). It was determined by dropping 2 µL of water from a microsyringe onto a horizontally placed base material, and photographing a still image 1 second after the dropwise addition with a video microscope. The static contact angle of water was measured at five different points in the surface-treating layer of the base material, and the average value thereof was calculated and used. Initial values were measured for the base materials (1) to (23). The results are shown in Table 2 below. The measurement was carried out in the same manner in Test Examples 3 to 5.

### (Test example 2)

### • Evaluation of surface lubricity (measurement of dynamic friction coefficient (COF))

The dynamic friction coefficient was measured for each of the base materials (1) to (23). Specifically, a dynamic friction coefficient (-) was measured using paper as friction block using a surface tester (FPT-1 manufactured by Labthink) in accordance with ASTM D4917. Specifically, the base material on which the surface-treating layer is formed was placed horizontally, friction paper (2 cm×2 cm) was brought into contact with the exposed upper surface of the surface-treating layer, a load of 200 gf was applied thereon, and then the friction paper was moved in equilibrium at a speed of 500 mm/sec under the condition where the load was applied, and the dynamic friction coefficient was measured. The results are shown in Table 2 below.

### (Test Example 3)

### • Evaluation of friction durability (eraser durability)

The friction durability was evaluated by an eraser friction durability test for each of the base materials (1) to (23). Specifically, the sample article on which the surface-treating layer is formed was placed horizontally, an eraser (KESHI-70, plane dimension: 1 cm × 1.6 cm, manufactured by Kokuyo) is brought into contact with the surface of the surface-treating layer, a load of 1,000 gf was applied thereon, and then the eraser was reciprocated at a speed of 20 mm/sec while the load was applied. The static contact angle (degree) of water was measured every 500 round trips. The evaluation was stopped at the time point when the measured value of the contact angle was less than 100 degrees. Table 2 shows the number of round trips at the last point in time in which the contact angle exceeded 100 degrees.

### (Test Example 4)

### • Evaluation of steel wool (SW) friction durability

Steel wool friction durability evaluation was performed for each of the base materials (1) to (23). Specifically, the base material on which the surface-treating layer is formed was placed horizontally, steel wool (count #0000, size 5 mm × 10 mm × 10 mm) was brought into contact with the surface-treating layer of the base material, a load of 1,000 gf was applied thereon, and then the steel wool was reciprocated at a speed of 140 mm/sec while the load was applied. The static contact angle (degree) of water was measured every 2000 round trips, and the evaluation was stopped when the measured value of the contact angle was less than 100 degrees. The results are shown in Table 2 below (in the table, the symbol "-" means that measurement was not performed).

### (Test Example 5)

### • Evaluation of accelerated weather resistance test

An accelerated weather resistance test was performed for each of the base materials (1) to (23). In the accelerated weather resistance test, UVB irradiation was performed as follows. For UVB irradiation, a UVB-313 lamp (irradiance of 0.63 W/m² at 310 nm, manufactured by Q-Lab) was used, the distance between the lamp and the surface-treating layer of the base material was set to 5 cm, and the temperature of the plate on which the substrate was placed was 63°C. Although UVB irradiation was performed continuously, when measuring the static contact angle of water, the base material was taken out once and the surface-treating layer after UVB irradiation for a predetermined period of time was wiped back and forth 5 times with a Kimwipe (trade name, Jujo Kimberly) fully soaked in pure water and wiped back and forth 5 times with another Kimwipe fully soaked in ethanol and allowed to dry. Immediately thereafter, the static contact angle of water was measured. The evaluation was performed every 24 hours from the start of UVB irradiation until the static contact angle of water fell below 90 degrees. Table 2 shows the cumulative UVB irradiation time up to the last point in time in which the contact angle exceeded 90 degrees.

**[Table 2]**

| Treatment base material | Static contact angle of water degrees | Dynamic friction coeffic ient (-) | Eraser durability times | SW friction durability times | Accelerated weather resistance hours |
|---|---|---|---|---|---|
| Base material (1) | 115 | 0.045 | 4500 | 8000 | 504 |
| Base material (2) | 115 | 0.041 | 5500 | 12000 | 456 |
| Base material (3) | 115 | 0.048 | 5500 | 12000 | 600 |
| Base material (4) | 115 | 0.045 | 6000 | 14000 | 552 |
| Base material (5) | 115 | 0.043 | 6000 | 16000 | 528 |
| Base material (6) | 115 | 0.042 | 6000 | 16000 | 480 |
| Base material (7) | 114 | 0.038 | 6500 | 16000 | 408 |
| Base material (8) | 115 | 0.050 | 5500 | 12000 | 528 |
| Base material (9) | 115 | 0.046 | 6000 | 12000 | 480 |
| Base material (10) | 115 | 0.042 | 6000 | 14000 | 432 |
| Base material (11) | 115 | 0.039 | 6000 | 16000 | 432 |
| Base material (12) | 115 | 0.037 | 6500 | 16000 | 408 |
| Base material (13) | 115 | 0.035 | 7000 | 16000 | 384 |
| Base material (14) | 115 | 0.033 | 7500 | 18000 | 360 |
| Base material (15) | 115 | 0.070 | 3000 | 6000 | 528 |
| Base material (16) | 114 | 0.071 | 2500 | 6000 | 432 |
| Base material (17) | 115 | 0.071 | 3000 | 6000 | 504 |
| Base material (18) | 115 | 0.071 | 3500 | 6000 | 456 |
| Base material (19) | 114 | 0.071 | 3500 | 6000 | 480 |
| Base material (20) | 113 | 0.070 | 3000 | 4000 | 408 |
| Base material (21) | 114 | 0.112 | 2000 | 6000 | 504 |
| Base material (22) | 114 | 0.143 | 1500 | 4000 | 456 |
| Base material (23) | 115 | 0.030 | 6000 | 12000 | 72 |

As can be understood from the results in Table 2 above, it has been confirmed that base materials (1) to (14) treated with the surface-treating agents of the present disclosure (Examples 1-(1) to (2), 2-(1) to (5), 3-(1) to (3), 4-(1) to (4)), containing the compound (A) corresponding to the compound (α), the compound (J) and the compound (L) having -OCF₂- corresponding to the compound (β), exhibit excellent abrasion resistance (eraser durability 4000 cycles or more; SW friction durability: 8000 cycles or more), excellent surface lubricity (dynamic friction coefficient of 0.05 or less), and excellent UV resistance (accelerated weathering resistance: 350 hours or more). On the other hand, the base materials (15) to (22) treated with the surface-treating agents containing the compound (4), the compound (P), the compound (Q), or the compound (R) having a perfluoropolyether group not containing -OCF₂-, (Comparative Examples 1-(1) to (2), Comparative Examples 2-(1) to (2), Comparative Examples 3-(1) to (2), Comparative Examples 4-(1) to (2)) and the base material (23) treated with the surface-treating agent (Comparative Example 5-(1)) containing only a mixture of the compound (L) and the compound (M) did not give satisfactory results in at least one test. From this, it was confirmed that the surface-treating agent of the present disclosure is able to demonstrate a high level of balanced abrasion resistance, surface lubricity, and UV resistance by mixing the compound (α) with a perfluoropolyether group-containing silane compound containing -OCF₂- compared to the conventional products.

### Industrial Applicability

The present disclosure can be suitably utilized to form a surface-treating layer on a variety of base materials, particularly on a surface of an optical member.

## Claims

1. A surface-treating agent comprising:
(1) a compound of formula (α1) or (α2): 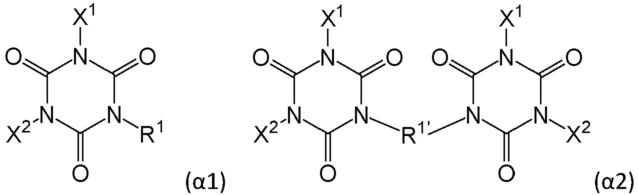 wherein:
R¹ is a monovalent organic group containing a polyether chain;
R^{1'} is a divalent organic group containing a polyether chain; the polyether chain is a chain of the formula: -(OC₆F₁₂)ₘ₁₁-(OC₅F₁₀)ₘ₁₂-(OC₄F₈)ₘ₁₃-(OC₃X¹⁰₆)ₘ₁₄-(OC₂F₄)ₘ₁₅-(OCF₂)ₘ₁₆-wherein m11 to m16 each independently are 0 or an integer of ≥ 1;
X¹⁰ each independently is H, For Cl; and the occurrence order of the respective repeating units is not limited;
X¹ each independently is a silane-containing reactive crosslinkable group; and
X² each independently is a monovalent group; and
(2) a compound which (i) is different from the compound (1) and (ii) is a perfluoropolyether group-containing silane compound having an OCF₂ unit and being represented by any of the formula (A1), (A2), (B1), (B2), (C1), (C2), (D1), (D2) or (E1): 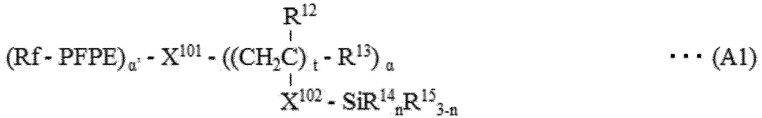 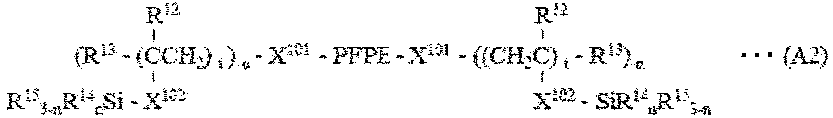
wherein, each independently at each occurrence,
Rf is C₁₋₁₆-alkyl optionally substituted with one or more F;
PFPE is -(OC₆F₁₂)*ₐ₁*-(OC₅F₁₀)*_{b1}*-(OC₄F₈)*_{c1}*-(OC₃F₆)*_{d1}*-(OC₂F₄)*ₑ₁*-(OCF₂)*_{f1}-*wherein *a1, b1, c1, d1* and *e1* are each independently an integer of 0-200, *f1* is an integer of 1-200, and the order of the respective repeating units in parenthesis with the indices *a1-f1* is not limited;
R¹² is H or lower alkyl;
R¹³ is H or halogen;
R¹⁴ is H or C₁₋₂₂-alkyl;
R¹⁵ is OH or a hydrolyzable group;
*n* in each (-SiR¹⁴ₙR¹⁵₃₋ₙ) unit is an integer of 0-3; provided that at least one R¹⁵ is present in the molecule;
X¹⁰¹ is a single bond or a di- to decavalent organic group;
X¹⁰² is a single bond or a divalent organic group;
*t* is an integer of 1-10;
α is an integer of 1-9; and
α' is an integer of 1-9;
(Rf-PFPE)_{β'}-X¹⁰⁵-(SiR¹⁴ₙR¹⁵₃₋ₙ)_{β} ··· (B1)
(R¹⁵₃₋ₙR¹⁴ₙSi)_{β}-X¹⁰⁵-PFPE-X¹⁰⁵-(SiR¹⁴ₙR¹⁵₃₋ₙ)_{β} ··· (B2)
wherein Rf, PFPE, R¹⁴, R¹⁵ and *n* are as defined for formulae (A1) and (A2) and, each independently at each occurrence,
X¹⁰⁵ is a single bond or a di- to decavalent organic group;
β is an integer of 1-9;
β' is an integer of 1-9;
(Rf-PFPE)_{γ'}-X¹⁰⁷-(SiR^{a3}ₖR^{b3}ₗR^{c3})_{γ} ··· (C1)
(R^{c3}ₘR^{b3}ₗR^{a3}ₖSi)_{γ}-X¹⁰⁷-PFPE-X¹⁰⁷-(SiR^{a3}ₖR^{b3}ₗR^{c3}ₘ)_{γ} ··· (C2)
wherein Rf and PFPE are as defined for formulae (A1) and (A2) and, each independently at each occurrence,
X¹⁰⁷ is a single bond or a di- to decavalent organic group;
γ is an integer of 1-9;
γ' is an integer of 1-9;
R^{a3} is -Z³-SiR⁷¹*ₚ*R⁷²*_{q}*R⁷³*ᵣ* wherein, each independently at each occurrence,
Z³ is -O- or a divalent organic group;
R⁷¹ has the same meaning as R^{a3}; the number of Si atoms linearly linked via a Z³ group in R^{a3} is ≤ 5;
R⁷² is OH or a hydrolyzable group;
R⁷³ is H or lower alkyl;
*p* is an integer of 0-3;
*q* is an integer of 0-3;
*r* is an integer of 0-3; provided that in each -Z³-SiR⁷¹*ₚ*R⁷²*_{q}*R⁷³*ᵣ* (*p*+*q*+*r*) = 3 and at least one
R⁷² is present in formulae (C1) and (C2);
R^{b3} is OH or a hydrolyzable group;
R^{c3} is H or lower alkyl;
*k* is an integer of 1-3;
*l* is an integer of 0-2;
*m* is an integer of 0-2; provided that, in the unit in parentheses with γ, (*k+l+m*) = 3;
(Rf-PFPE)_{δ'}-X¹⁰⁹-(CR^{d3}_{k'}R^{e3}_{l'}R^{f3}_{m'})_{δ} ··· (D1)
(R^{f3}_{m'}R^{e3}_{l'}R^{d3}_{k'}C)_{δ}-X¹⁰⁹-PFPE-X¹⁰⁹-(CR^{d3}_{k'}R^{e3}_{l'}R^{f3}_{m'})_{δ} ··· (D2)
wherein Rf and PFPE are as defined for formulae (A1) and (A2) and, each independently at each occurrence,
X¹⁰⁹ is a single bond or a di- to decavalent organic group;
δ is an integer of 1-9;
δ' is an integer of 1-9;
R^{d3} is -Z³'-CR⁸¹*p*_{'}R⁸²_{*q*'}R⁸³_{*r*'} wherein, each independently at each occurrence,
Z^{3'} is -O- or a divalent organic group;
R⁸¹ has the same meaning as R^{d3}; the number of C atoms linearly linked via a Z^{3'} group in R^{d3} is ≤ 5;
R⁸² is -Y³-SiR⁸⁵*ⱼ*R⁸⁶_{3-*j*}; wherein, each independently at each occurrence,
Y³ is a divalent organic group;
R⁸⁵ is OH or a hydrolyzable group;
R⁸⁶ is H or lower alkyl; and
j in each (-Y³-SiR⁸⁵*ⱼ*R⁸⁶_{3-*j*}) unit is an integer of 1-3;
R⁸³ is H, OH or lower alkyl;
*p'* is an integer of 0-3;
*q'* is an integer of 0-3;
*r'* is an integer of 0-3;
R^{e3} is -Y³-SiR⁸⁵*ⱼ*R⁸⁶_{3-*j*};
R^{f3} is H, OH or lower alkyl;
*k'* is an integer of 0-3;
l' is an integer of 0-3;
*m*' is an integer of 0-3; provided that at least one *q'* is 2 or 3 or at least one *l*' is 2 or 3;
(Rf-PFPE-G⁵)ₐ₅-Z⁵-((O-R¹⁶)_{c5}-SiR¹⁴ₙR¹⁵₃₋ₙ)_{b5} ··· (E1)
wherein Rf, PFPE, R¹⁴, R¹⁵ and *n* are as defined for formulae (A1) and (A2) and
G⁵ is -R¹⁷-O-, -R¹⁷-CONH-, -CONH-, or a single bond; R¹⁷ is an alkylene group;
Z⁵ is an (*a5*+*b5*)-valent hydrocarbon group or an (*a5*+*b5*)-valent group having ≥ 2 carbon atoms and having at least one etheric oxygen atom between carbon atoms in the hydrocarbon group;
R¹⁶ is alkylene;
*a5* is an integer of ≥ 1;
*b5* is an integer of > 1; provided that *(a5*+*b5)* is ≥ 3; and
*c5* is 0 or 1.

2. The surface-treating agent of claim 1, wherein
R¹ is a group R³-(OR²)*ₐ*-L- wherein
(OR²)*ₐ* is a polyether chain, preferably a polyether chain of the formula -(OC₄F₈)*ₘ₁₃*-(OC₃F₆)*ₘ₁₄*-(OC₂F₄)*ₘ₁₅*-(OCF₂)*ₘ₁₆*-
wherein *m13* and *m14* are each an integer of 0-30, and *m15* and *m16* are each an integer of 1-200; *m13* to *m16* are ≥ 5 in total; and the occurrence order of the respective repeating units is not limited;
R³ is alkyl or fluoroalkyl; and
L is a single bond or a divalent linking group; and
R^{1'} is a group -L'-(OR²)ₐ-L- wherein (OR²)ₐ is a polyether chain; and L and L' each independently at each occurrence are a single bond or a divalent linking group.

3. The surface-treating agent of claim 2, wherein
L is -(CX¹²¹X¹²²)*ₒ*-(L¹)*ₚ*-(CX¹²³X¹²⁴)*_{q}*- and
L' is -(CX¹²⁶X¹²⁷)ᵣ-(CX¹²¹X¹²²)ₒ-(L¹)ₚ-(CX¹²³X¹²⁴)_{q}-; wherein
X¹²¹-X¹²⁴ each independently are H, F, OH, or -OSi(OR¹²⁵)₃ wherein R¹²⁵ each independently is C₁₋₄-alkyl;
X¹²⁶, X¹²⁷ each independently are H, For Cl;
L¹ is -C(=O)NH-, -NHC(=O)-, -O-, -C(=O)O-, -OC(=O)-, -OC(=O)O-, or-NHC(=O)NH-, in which the left side of each bond is bonded to CX¹²¹X¹²²;
*o* is an integer of 0-10;
*p* is 0 or 1;
*q* is an integer of 1-10; and
*r* is an integer of 1-6.

4. The surface-treating agent of any of claims 1-3, wherein X¹ is
-L²-{Si(R^{a})*ₛ*(R^{b})*ₜ*(R^{c})*ᵤ*(R^{d})*ᵥ*}*ₙ*
wherein, each independently at each occurrence,
L² is a single bond or a divalent linking group;
R^{a}-R^{c} are H, halogen, C₁₋₁₀-alkoxy, C₁₋₁₀-amino, C₁₋₁₀-acetoxy, C₃₋₁₀-allyl or C₃₋₁₀-glycidyl;
R^{d} is -O-, -NH-, -C≡C-, or a silane bond;
*s, t,* *u* are 0 or 1;
*v* is an integer of 0-3;
*n* is an integer of 1-20;
if *n* = 1, then (*s*+*t*+*u*) = 3 and v = 0;
if *n* is 2-20, then (*s*+*t*+*u*) each independently is 0-2, and v each independently is 0-2; and
if *v* ≥ 1, then at least two Si atoms are bonded to each other via R^{d} in a linear, ladder, cyclic or polycyclic form.

5. The surface-treating agent of any of claims 1-4, wherein X¹ is a group selected from -L²-SiR⁵₃, -L²-Si(OR⁶)₃, -L²-Si(NR⁶₂)₃ and -L²-Si(OCOR⁶)₃, wherein
L² is -C₂H₄-, -C₃H₆-, -C₄H₈-O-CH₂-, -CO-O-CH₂-CH(OH)-CH₂-, -CH₂-, or -C₄H₈-;
R⁵ is halogen; and
R⁶ each independently is C₁₋₄-alkyl.

6. The surface-treating agent of any of claims 1-3, wherein X¹ is a silane-containing reactive crosslinkable group of the formula:
-L²-{Si(R^{a})*ₛ*(R^{b})*ₜ*(R^{c})*ᵤ*(R^{d'})*ᵥ*}*ₙ*
wherein, each independently at each occurrence,
L² is a single bond or a divalent linking group;
R^{a}-R^{c} are H, halogen, C₁₋₁₀-alkoxy, C₁₋₁₀-amino, C₁₋₁₀-acetoxy, C₃₋₁₀-allyl or C₃₋₁₀-glycidyl;
R^{d'} is a group -Z-SiR^{d1'}*_{p'}*R^{d2'}*_{q'}*-R^{d3'}*_{r'}* wherein, each independently at each occurrence,
Z is a single bond or a divalent linking group;
R^{d1'} has the same meaning as R^{d'}; the number of Si atoms linearly linked via a Z group in R^{d'} is ≤ 5;
R^{d2'} is OH or a hydrolyzable group;
R^{d3'} is H or lower alkyl;
*p', q', r'* is is are integers of 0-3, provided that (*p'*+*q'*+*r'*) = 3;
*s*, *t*, *u* are 0 or 1;
*v* is an integer of 0-3;
*n* is an integer of 1-20.

7. The surface-treating agent of any of claims 1-3, wherein X¹ is a silane-containing reactive crosslinkable group of the formula:
-L⁶-{C(R^{a6})*ₛ₆*(R^{b6})*ₜ₆*(R^{c6})*ᵤ₆*(R^{d6})*ᵥ₆*}*ₙ₆*
wherein, each independently at each occurrence,
L⁶ is a single bond or a divalent linking group;
R^{a6}-R^{c6} are H, halogen, C₁₋₁₀-alkoxy, C₁₋₁₀-amino, C₁₋₁₀-acetoxy, C₃₋₁₀-allyl, C₃₋₁₀-glycidyl, -OCO(C₁₋₆-alkyl), OH or -Y⁶-SiR⁶⁵*ⱼ₆*R⁶⁶_{3-*j6*} wherein, each independently
Y⁶ is a divalent organic group;
R⁶⁵ is OH or a hydrolyzable group;
R⁶⁶ is H or lower alkyl;
*j6* in each (-Y⁶-SiR⁶⁵ⱼ₆R⁶⁶₃₋ⱼ₆) unit is an integer of 1-3;
R^{d6} is -O-, -NH-, -C=C- or -Z⁶-CR⁶¹ₚ₆R⁶²_{q6}R⁶³ᵣ₆ wherein, each independently at each occurrence,
Z⁶ is -O- or a divalent organic group;
R⁶¹ has the same meaning as R^{d6}; the number of C atoms linearly linked via a Z⁶ group in R^{d6} is ≤ 5;
R⁶² is -Y⁶-SiR⁶⁵ⱼ₆R⁶⁶₃₋ⱼ₆;
R⁶³ is H or lower alkyl;
*p6, q6, r6* are integers of 0-3; and
*s6*, *t6, u6* are 0 or 1;
*v6* is an integer of 0-3, and
*n6* is an integer of 1-20,
provided that in the formula, at least two groups -Y⁶-iR⁶⁵ⱼ₆R⁶⁶₃₋ⱼ₆ are present.

8. The surface-treating agent according to any one of claims 1-7, wherein the compound (2) is a compound of formula (C1) or (C2).

9. The surface-treating agent of any one of claims 1-8, wherein PFPE is a group represented by:
-(OC₄F₈)*ₘ₁₃*-(OC₃F₆)*ₘ₁₄-*(OC₂F₄)*ₘ₁₅*-(OCF₂)*ₘ₁₆*-
wherein *m13* and *m14* are each an integer of 0-30, and *m15* and *m16* are each an integer of 1-200; and the occurrence order of the respective repeating units is not limited.

10. The surface-treating agent of any of claims 1-9, further comprising a solvent.

11. The use of the surface-treating agent of any of claims 1-10 as an antifouling coating agent or a water-proof coating agent.

12. The use of the surface-treating agent of any of claims 1-10 for vacuum deposition.

13. A pellet comprising the surface-treating agent of any of claims 1-10.

14. An article comprising a base material and, on a surface of the base material, a layer formed from the surface-treating agent of any of claims 1-10.

15. The article of claim 14 which is an optical member.

## Patentansprüche

1. Oberflächenbehandlungsmittel, umfassend:
(1) eine Verbindung der Formel (α1) oder (α2): 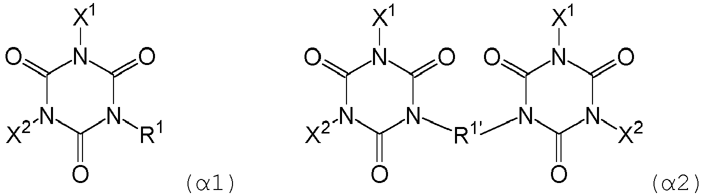 worin:
R¹ eine einwertige organische Gruppe ist, die eine Polyetherkette enthält;
R^{1'} eine zweiwertige organische Gruppe ist, die eine Polyetherkette enthält;
die Polyetherkette eine Kette der Formel: - (OC₆F₁₂)ₘ₁₁-(OC₅F₁₀)ₘ₁₂-(OC₄F₈)ₘ₁₃-(OC₃X¹⁰₆)ₘ₁₄-(OC₂F₄)ₘ₁₅-(OCF₂)ₘ₁₆-
ist, worin m11 bis m16 jeweils unabhängig 0 oder eine ganze Zahl von ≥ 1 sind;
X¹⁰ jeweils unabhängig H, F oder Cl ist; und die Reihenfolge des Auftretens der jeweiligen Wiederholungseinheiten nicht beschränkt ist;
X¹ jeweils unabhängig eine Silan-haltige reaktive vernetzbare Gruppe ist; und
X² jeweils unabhängig eine einwertige Gruppe ist; und
(2) eine Verbindung, die (i) sich von der Verbindung (1) unterscheidet und (ii) eine Perfluorpolyethergruppenhaltige Silanverbindung ist, die eine OCF₂-Einheit aufweist und durch eine der Formeln (A1), (A2), (B1), (B2), (C1), (C2), (D1), (D2) oder (E1) dargestellt ist: 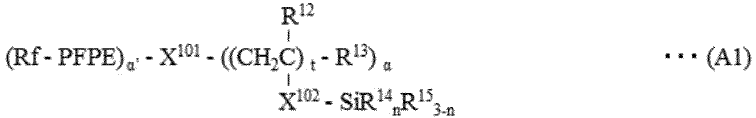 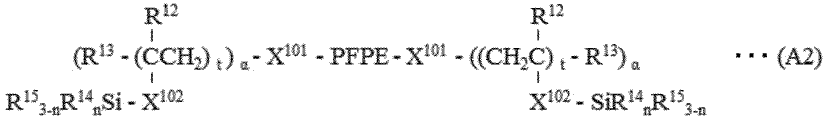
worin, jeweils unabhängig bei jedem Auftreten,
Rf C₁₋₁₆-Alkyl ist, das gegebenenfalls mit einem oder mehreren F substituiert ist;
PFPE -(OC₆F₁₂)*ₐ₁*-(OC₅F₁₀)*_{b1}*-(OC₄F₈)*_{c1}*-(OC₃F₆)*_{d1}*-(OC₂F₄)*ₑ₁-*(OCF₂)*_{f1}*- ist,
worin *a1, b1, c1, d1* und *e1* jeweils unabhängig eine ganze Zahl von 0-200 sind, *f1* eine ganze Zahl von 1-200 ist und die Reihenfolge der jeweiligen Wiederholungseinheiten in Klammern mit den Indices *a1-f1* nicht beschränkt ist;
R¹² H oder Niederalkyl ist;
R¹³ H oder Halogen ist;
R¹⁴ H oder C₁₋₂₂-Alkyl ist;
R¹⁵ OH oder eine hydrolysierbare Gruppe ist;
*n* in jeder (-SiR¹⁴ₙR¹⁵₃₋ₙ) -Einheit eine ganze Zahl von 0-3 ist; vorausgesetzt, dass mindestens ein R¹⁵ im Molekül vorhanden ist;
X¹⁰¹ eine Einfachbindung oder eine zwei- bis zehnwertige organische Gruppe ist;
X¹⁰² eine Einfachbindung oder eine zweiwertige organische Gruppe ist;
*t* eine ganze Zahl von 1-10 ist;
α eine ganze Zahl von 1-9 ist; und
α' eine ganze Zahl von 1-9 ist;
(Rf-PFPE)_{β'}-X¹⁰⁵-(SiR¹⁴ₙR⁵⁵₃₋ₙ)_{β} ··· (B1)
(R¹⁵₃₋ₙR¹⁴ₙSi)_{β}-X¹⁰⁵-PFPE-X¹⁰⁵-(SiR¹⁴ₙR¹⁵₃₋ₙ)_{β} ··· (B2)
worin Rf, PFPE, R¹⁴, R¹⁵ und *n* wie für Formel (A1) und (A2) definiert sind und, jeweils unabhängig bei jedem Auftreten,
X¹⁰⁵ eine Einfachbindung oder eine zwei- bis zehnwertige organische Gruppe ist;
β eine ganze Zahl von 1-9 ist;
β' eine ganze Zahl von 1-9 ist;
(Rf-PFPF-)_{γ'}-X¹⁰⁷-(SiR^{a3}ₖR^{b3}ₗR^{c3}ₘ)_{γ} ··· (C1)
(R^{c3}ₘR^{b3}ₗR^{a3}ₖSi)_{γ}-X¹⁰⁷-PFPE-X¹⁰⁷-(SiR^{a3}ₖR^{b3}ₗR^{c3}ₘ)_{γ} ··· (C2)
worin Rf und PFPE wie für Formel (A1) und (A2) definiert sind und, jeweils unabhängig bei jedem Auftreten,
X¹⁰⁷ eine Einfachbindung oder eine zwei- bis zehnwertige organische Gruppe ist;
γ eine ganze Zahl von 1-9 ist;
γ' eine ganze Zahl von 1-9 ist;
R^{a3} -Z³-SiR⁷¹*ₚ*R⁷²*_{g}*R⁷³*ᵣ* ist, worin, jeweils unabhängig bei jedem Auftreten,
Z³ -O- oder eine zweiwertige organische Gruppe ist;
R⁷¹ die gleiche Bedeutung wie R^{a3} hat;
die Anzahl an Si-Atomen, die linear über eine Z³-Gruppe in R^{a3} verbunden sind, ≤ 5 beträgt;
R⁷² OH oder eine hydrolysierbare Gruppe ist;
R⁷³ H oder Niederalkyl ist;
*p* eine ganze Zahl von 0-3 ist;
*q* eine ganze Zahl von 0-3 ist;
*r* eine ganze Zahl von 0-3 ist; vorausgesetzt, dass in jedem -Z³-SiR⁷¹*ₚ*R⁷²*_{q}*R⁷³*ᵣ* (*p*+*q*+*r*) = 3 und mindestens ein R⁷² in den Formeln (C1) und (C2) vorhanden ist;
R^{b3} OH oder eine hydrolysierbare Gruppe ist;
R^{c3} H oder Niederalkyl ist;
*k* eine ganze Zahl von 1-3 ist;
*l* eine ganze Zahl von 0-2 ist;
*m* eine ganze Zahl von 0-2 ist; vorausgesetzt, dass, in der Einheit in Klammern mit γ, (*k*+*l*+*m*) = 3;
(Rf**-**PFPE)_{δ'}-X¹⁰⁹-(CR^{d3}_{k'}R^{e3}_{l'}R^{f3}_{m'})_{δ} ... (D1)
(R^{f3}_{m'}R^{e3}ₗR^{d3}_{k'}C)_{δ}-X¹⁰⁹-PFPE-X¹⁰⁹-(CR^{d3}_{k'}R^{e3}_{l'}R^{f3}_{m'})_{δ} ··· (D2)
worin Rf und PFPE wie für Formel (A1) und (A2) definiert sind und, jeweils unabhängig bei jedem Auftreten,
X¹⁰⁹ eine Einfachbindung oder eine zwei- bis zehnwertige organische Gruppe ist;
5 eine ganze Zahl von 1-9 ist;
δ' eine ganze Zahl von 1-9 ist;
R^{d3} -Z³'-CR⁸¹*_{p'}*R⁸²_{*q*'}R⁸³_{*r*'} ist, worin, jeweils unabhängig bei jedem Auftreten,
Z^{3'} -O- oder eine zweiwertige organische Gruppe ist;
R⁸¹ die gleiche Bedeutung wie R^{d3} hat;
die Anzahl der C-Atome, die linear über eine Z^{3'}-Gruppe in R^{d3} verbunden sind, ≤ 5 beträgt;
R⁸² -Y³-SiR⁸⁵*ⱼ*R⁸⁶_{3-*j*} ist, worin, jeweils unabhängig bei edem Auftreten,
Y³ eine zweiwertige organische Gruppe ist;
R⁸⁵ OH oder eine hydrolysierbare Gruppe ist;
R⁸⁶ H oder Niederalkyl ist; und
j in jeder (-Y³-SiR⁸⁵*ⱼ*R⁸⁶_{3-*j*})-Einheit eine ganze Zahl von 1-3 ist;
R⁸³ H, OH oder Niederalkyl ist;
*p*' eine ganze Zahl von 0-3 ist;
*q'* eine ganze Zahl von 0-3 ist;
*r'* eine ganze Zahl von 0-3 ist;
R^{e3} -Y³-SiR⁸⁵*ⱼ*R⁸⁶_{3-*j*} ist;
R^{f3} H, OH oder Niederalkyl ist;
*k'* eine ganze Zahl von 0-3 ist;
l' eine ganze Zahl von 0-3 ist;
*m*' eine ganze Zahl von 0-3 ist; vorausgesetzt, dass mindestens ein *q*' 2 oder 3 ist oder mindestens ein *l'* 2 oder 3 ist;
(Rf-PFPE-G⁵)ₐ₅-Z⁵-((O-R¹⁶)_{c5}-SiR¹⁴ₙR¹⁵₃₋ₙ)_{b5} ··· (E1)
worin Rf, PFPFE, R¹⁴, R¹⁵ und *n* wie für Formel (A1) und (A2) definiert sind und
G⁵ -R¹⁷-O-, -R¹⁷-CONH-, -CONH- oder eine Einfachbindung ist; R¹⁷ eine Alkylengruppe ist;
Z⁵ eine (*a5*+*b5*)-wertige Kohlenwasserstoffgruppe oder eine (*a5*+*b5*)-wertige Gruppe mit ≥ 2 Kohlenstoffatomen und mindestens einem etherischen Sauerstoffatom zwischen den Kohlenstoffatomen in der Kohlenwasserstoffgruppe ist;
R¹⁶ Alkylen ist;
*a5* eine ganze Zahl von ≥ 1 ist;
*b5* eine ganze Zahl von ≥ 1 ist; vorausgesetzt, dass (*a5*+*b5*) ≥ 3 ist; und
*c5* 0 oder 1 ist.

2. Oberflächenbehandlungsmittel gemäß Anspruch 1, worin
R¹ eine Gruppe R³-(OR²)*ₐ*-L- ist, worin
(OR²)ₐ eine Polyetherkette, vorzugsweise eine Polyetherkette der Formel
- (OC₄F₈)*ₘ₁₃*-(OC₃F₆)*ₘ₁₄-*(OC₂F₄)*ₘ₁₅-*(OCF₂)*ₘ₁₆-*ist, worin *m13* und *m14* jeweils eine ganze Zahl von 0-30 sind und *m15* und *m16* jeweils eine ganze Zahl von 1-200 sind; *m13* bis *m16* insgesamt ≥ 5 sind; und die Reihenfolge des Auftretens der jeweiligen Wiederholungseinheiten nicht beschränkt ist;
R³ Alkyl oder Fluoralkyl ist; und
L eine Einfachbindung oder eine zweiwertige Verknüpfungsgruppe ist; und
R^{1'} eine Gruppe -L'-(OR²)ₐ-L- ist, worin (OR²)ₐ eine Polyetherkette ist; und L und L' jeweils unabhängig bei jedem Auftreten eine Einfachbindung oder eine zweiwertige Verknüpfungsgruppe sind.

3. Oberflächenbehandlungsmittel gemäß Anspruch 2, worin
L -(CX¹²¹X¹²²)*ₒ*-(L¹)*ₚ*-(CX¹²³X¹²⁴)*_{q}*- ist und
L' -(CX¹²⁶X¹²⁷)ᵣ-(CX¹²¹X¹²²)ₒ-(L¹)ₚ-(CX¹²³X¹²⁴)_{q}- ist, worin
X¹²¹-X¹²⁴ jeweils unabhängig H, F, OH oder -OSi(OR¹²⁵)₃ sind, worin R¹²⁵ jeweils unabhängig C₁₋₄-Alkyl ist;
X¹²⁶, X¹²⁷ jeweils unabhängig H, F oder Cl sind;
L¹ -C(=O)NH-, -NHC(=O)-, -O-, -C(=O)O-, -OC(=O)-, -OC(=O)O- oder -NHC(=O)NH- ist, bei dem die linke Seite jeder Bindung an CX¹²¹X¹²² gebunden ist;
*o* eine ganze Zahl von 0-10 ist;
*p* 0 oder 1 ist;
*q* eine ganze Zahl von 1-10 ist; und
*r* eine ganze Zahl von 1-6 ist.

4. Oberflächenbehandlungsmittel gemäß einem der Ansprüche 1-3, worin X¹
-L²-{Si(R^{a})*ₛ*(R^{b})*ₜ*(R^{c})*ᵤ*(R^{d})*ᵥ*}*ₙ*
ist, worin, jeweils unabhängig bei jedem Auftreten,
L² eine Einfachbindung oder eine zweiwertige Verknüpfungsgruppe ist;
R^{a}-R^{c} H, Halogen, C₁₋₁₀-Alkoxy, C₁₋₁₀-Amino, C₁₋₁₀-Acetoxy, C₃₋₁₀-Allyl oder C₃₋₁₀-Glycidyl sind;
R^{d} -O-, -NH-, -C≡C- oder eine Silanbindung ist;
*s*, *t*, *u* 0 oder 1 sind;
*v* eine ganze Zahl von 0-3 ist;
*n* eine ganze Zahl von 1-20 ist;
falls *n* = 1, dann (s+t+u) = 3 und v = 0;
falls *n* 2-20 ist, dann ist (*s*+*t*+*u*) jeweils unabhängig 0-2 und *v* ist jeweils unabhängig 0-2; und
falls *v* ≥ 1, dann sind mindestens zwei Si-Atome über R^{d} in linearer, leiterförmiger, cyclischer oder polycyclischer Form aneinander gebunden.

5. Oberflächenbehandlungsmittel gemäß einem der Ansprüche 1-4, worin X¹ eine Gruppe ist, ausgewählt aus -L²-SiR⁵₃,-L²-Si(OR⁶)₃, -L²-Si(NR⁶₂)₃ und -L²-Si(OCOR⁶)₃, worin
L² -C₂H₄-, -C₃H₆-, -C₄H₈-O-CH₂-, -CO-O-CH₂-CH(OH)-CH₂-,-CH₂- oder -C₄H₈- ist;
R⁵ Halogen ist; und
R⁶ jeweils unabhängig C₁₋₄-Alkyl ist.

6. Oberflächenbehandlungsmittel gemäß einem der Ansprüche 1-3, worin X¹ eine Silan-haltige reaktive vernetzbare Gruppe der Formel:
-L²-{Si(R^{a})*ₛ*(R^{b})*ₜ*(R^{c})*ᵤ*(R^{d'})*ᵥ*}*ₙ*
ist, worin, jeweils unabhängig bei jedem Auftreten,
L² eine Einfachbindung oder eine zweiwertige Verknüpfungsgruppe ist;
R^{a}-R^{c} H, Halogen, C₁₋₁₀-Alkoxy, C₁₋₁₀-Amino, C₁₋₁₀-Acetoxy, C₃₋₁₀-Allyl oder C₃₋₁₀-Glycidyl sind;
R^{d'} eine Gruppe -Z-SiR^{d1'}_{*p*'}R^{d2'}_{*q*'}R^{d3'}_{*r*'} ist, worin, jeweils unabhängig bei jedem Auftreten,
Z eine Einfachbindung oder eine zweiwertige Verknüpfungsgruppe ist;
R^{d1'} die gleiche Bedeutung wie R^{d'} hat; die Anzahl der Si-Atome, die linear über eine Z-Gruppe in R^{d'} verbunden sind, ≤ 5 beträgt;
R^{d2'} OH oder eine hydrolysierbare Gruppe ist;
R^{d3'} H oder Niederalkyl ist;
*p'*, *q', r*' ganze Zahlen von 0-3 sind, vorausgesetzt, dass (*p*'+*q*'+*r*') = 3;
*s*, *t*, *u* 0 oder 1 sind;
*v* eine ganze Zahl von 0-3 ist;
*n* eine ganze Zahl von 1-20 ist.

7. Oberflächenbehandlungsmittel gemäß einem der Ansprüche 1-3, worin X¹ eine Silan-haltige reaktive vernetzbare Gruppe der Formel:
-L⁶-{C(R^{a6})*ₛ₆*(R^{b6})*ₜ₆*(R^{c6})*ᵤ₆*(R^{d6})*ᵥ₆*}*ₙ₆*
ist, worin, jeweils unabhängig bei jedem Auftreten,
L⁶ eine Einfachbindung oder eine zweiwertige Verknüpfungsgruppe ist;
R^{a6}-R^{c6}H, Halogen, C₁₋₁₀-Alkoxy, C₁₋₁₀-Amino, C₁₋₁₀-Acetoxy, C₃₋₁₀-Allyl, C₃₋₁₀-Glycidyl, -OCO(C₁₋₆-alkyl), OH oder -Y⁶-SiR⁶⁵*ⱼ₆*R⁶⁶_{3-*j6*} sind, worin, jeweils unabhängig, Y⁶ eine zweiwertige organische Gruppe ist; R⁶⁵ OH oder eine hydrolysierbare Gruppe ist; R⁶⁶ H oder Niederalkyl ist; *j6* in jeder (-Y⁶-SiR⁶⁵*ⱼ₆*R⁶⁶_{3-*j6*}) -Einheit eine ganze Zahl von 1-3 ist;
R^{d6} -O-, -NH-, -C≡C- oder -Z⁶-CR⁶¹ₚ₆R⁶²_{q6}R⁶³ᵣ₆ ist, worin, jeweils unabhängig bei jedem Auftreten,
Z⁶ -O- oder eine zweiwertige organische Gruppe ist;
R⁶¹ die gleiche Bedeutung wie R^{d6} hat; die Anzahl der C-Atome, die linear über eine Z⁶-Gruppe in R^{d6} verbunden sind, ≤ 5 beträgt;
R⁶² -Y⁶-SiR⁶⁵ⱼ₆R⁶⁶₃₋ⱼ₆ ist;
R⁶³ H oder Niederalkyl ist;
*p6, q6, r6* ganze Zahlen von 0-3 sind; und
*s6, t6, u6* 0 oder 1 sind;
*v6* eine ganze Zahl von 0-3 ist und
*n6* eine ganze Zahl von 1-20 ist,
vorausgesetzt, dass in der Formel mindestens zwei -Y⁶-SiR⁶⁵ⱼ₆R⁶⁶₃₋ⱼ₆-Gruppen vorhanden sind.

8. Oberflächenbehandlungsmittel gemäß einem der Ansprüche 1-7, worin die Verbindung (2) eine Verbindung der Formel (C1) oder (C2) ist.

9. Oberflächenbehandlungsmittel gemäß einem der Ansprüche 1-8, worin PFPE eine Gruppe ist, die dargestellt ist durch:
- (OC₄F₈)*ₘ₁₃*-(OC₃F₆)*ₘ₁₄-*(OC₂F₄)*ₘ₁₅*-(OCF₂)*ₘ₁₆-*
worin *m13* und *m14* jeweils eine ganze Zahl von 0-30 sind und *m15* und *m16* jeweils eine ganze Zahl von 1-200 sind; und die Reihenfolge des Auftretens der jeweiligen Wiederholungseinheiten nicht beschränkt ist.

10. Oberflächenbehandlungsmittel gemäß einem der Ansprüche 1-9, ferner umfassend ein Lösungsmittel.

11. Verwendung des Oberflächenbehandlungsmittels gemäß einem der Ansprüche 1-10 als Antifouling-Beschichtungsmittel oder als wasserfestes Beschichtungsmittel.

12. Verwendung des Oberflächenbehandlungsmittels gemäß einem der Ansprüche 1-10 für Vakuumabscheidung.

13. Pellet, umfassend das Oberflächenbehandlungsmittel gemäß einem der Ansprüche 1-10.

14. Gegenstand, umfassend ein Basismaterial und, auf einer Oberfläche des Basismaterials, eine Schicht, die aus dem Oberflächenbehandlungsmittel gemäß einem der Ansprüche 1-10 gebildet ist.

15. Gegenstand gemäß Anspruch 14, der ein optisches Element ist.

## Revendications

1. Agent de traitement de surface comprenant :
(1) un composé de formule (α1) ou (α2) : 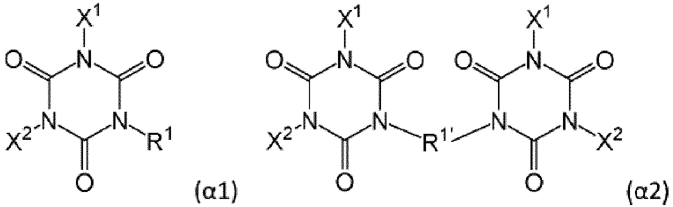 dans lequel :
R¹ est un groupe organique monovalent contenant une chaîne de polyéther ;
R^{1'} est un groupe organique divalent contenant une chaîne de polyéther ;
la chaîne de polyéther est une chaîne de la formule : -(OCeF₁₂)ₘ₁₁-(OC₅F₁₀)ₘ₁₂-(OC₄F₈)ₘ₁₃-(OC₃X¹⁰₆)ₘ₁₄-(OC₂F₄)ₘ₁₅-(OCF₂)ₘ₁₆-
dans laquelle m11 à m16 sont chacun indépendamment 0 ou un nombre entier ≥ 1 ;
X¹⁰ est chacun indépendamment H, F ou CI ; et l'ordre d'occurrence des unités de répétition respectives n'est pas limité ;
X¹ est chacun indépendamment un groupe réticulable réactif contenant du silane ; et
X² est chacun indépendamment un groupe monovalent ; et
(2) un composé qui (i) est différent du composé (1) et (ii) est un composé silane contenant un groupe perfluoropolyéther présentant une unité d'OCF₂ et étant représenté par une quelconque des formules (A1), (A2), (B1), (B2), (C1), (C2), (D1), (D2) ou (E1) : 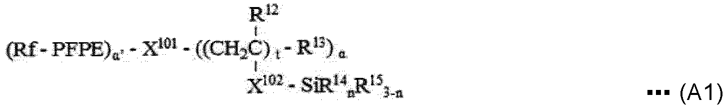 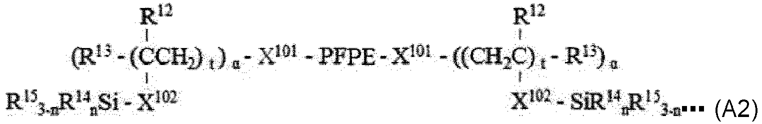
dans lequel, chacun indépendamment à chaque occurrence,
Rf est un alkyle en C₁₋₁₆ facultativement substitué par un ou plusieurs F ;
PFPE est -(OC₆F₁₂)*ₐ₁*-(OC₅F₁₀)*_{b1}*-(OC₄F₈)*_{c1}*-(OC₃F₆)*_{d1}*-(OC₂F₄)*ₑ₁*-(OCF₂)*_{f1}-*dans lequel *a1*, *b1, c1, d1* et *e1* sont chacun indépendamment un nombre entier de 0-200, *f1* est un nombre entier de 1 à 200 et l'ordre des unités de répétition respectives en parenthèses avec les indices *a1-f1* n'est pas limité ;
R¹² est H ou un alkyle inférieur ;
R¹³ est H ou un halogène ;
R¹⁴ est H ou un alkyle en C₁₋₂₂ ;
R¹⁵ est OH ou un groupe hydrolysable ;
*n* dans chaque unité de (-SiR¹⁴ₙR¹⁵₃₋ₙ) est un nombre entier de 0 à 3 ; à condition qu'au moins un R¹⁵ soit présent dans la molécule ;
X¹⁰¹ est une liaison simple ou un groupe organique divalent à décavalent ;
X¹⁰² est une liaison simple ou un groupe organique divalent ;
*t* est un nombre entier de 1 à 10 ;
α est un nombre entier de 1 à 9 ; et
α' est un nombre entier de 1 à 9 ;
(Rf-PFPE)_{β'}-X¹⁰⁵-(SiR¹⁴ₙR¹⁵₃₋ₙ)_{β} ··· (B1)
(R¹⁵₃₋ₙR¹⁴ₙSi)_{β}-X¹⁰⁵-PFPE-X¹⁰⁵-(SiR¹⁴ₙR¹⁵₃₋ₙ)_{β} ··· (B2)
dans lequel Rf, PFPE, R¹⁴, R¹⁵ et *n* sont tels que définis pour les formules (A1) et (A2) et, chacun indépendamment à chaque occurrence,
X¹⁰⁵ est une liaison simple ou un groupe organique divalent à décavalent ;
β est un nombre entier de 1 à 9 ;
β' est un nombre entier de 1 à 9 ;
(Rf-PFPE)_{γ'}-X¹⁰⁷-(SiR^{a3}ₖR^{b3}ₗR^{c3}ₘ)_{γ} ··· (C1)
(R^{c3}ₘR^{b3}ₗR^{a3}ₖSi)_{γ}-X¹⁰⁷-PFPE-x¹⁰⁷-(SiR^{a3}ₖR^{b3}ₗR^{c3}ₘ)_{γ} ··· (C2)
dans lequel Rf et PFPE sont tels que définis pour les formules (A1) et (A2) et, chacun indépendamment à chaque occurrence,
X¹⁰⁷ est une liaison simple ou un groupe organique divalent à décavalent ;
γ est un nombre entier de 1 à 9 ;
γ' est un nombre entier de 1 à 9 ;
R^{a3} est -Z³-SiR⁷¹*ₚ*R⁷²*_{q}*R⁷³*ᵣ* dans lequel, chacun indépendamment à chaque occurrence,
Z³ est -O- ou un groupe organique divalent ;
R⁷¹ a la même signification que R^{a3} ; le ombre d'atomes de Si liés linéairement via un groupe Z³ dans
R^{a3} est ≤ 5 ;
R⁷² est OH ou un groupe hydrolysable ;
R⁷³ est H ou un alkyle inférieur ;
*p* est un nombre entier de 0 à 3 ;
*q* est un nombre entier de 0 à 3 ;
*r* est un nombre entier de 0 à 3 ; à condition que dans chaque -Z³-SiR⁷¹*ₚ*R⁷²*_{q}*R⁷³*ᵣ (p*+q+*r)* = 3 et qu'au moins un R⁷² soit présent dans les formules (C1) et (C2) ;
R^{b3} est OH ou un groupe hydrolysable ;
R^{c3} est H ou un alkyle inférieur ;
*k* est un nombre entier de 1 à 3 ;
/ est un nombre entier de 0 à 2 ;
*m* est un nombre entier de 0 à 2 ; à condition que, dans l'unité entre parenthèses avec γ, *(k*+*l*+*m)*=3 *;*
(Rf-PFPE)_{δ'}-X¹⁰⁹-(CR^{d3}_{k'}R^{e3}_{l'}R^{f3}_{m'})_{δ} ··· (D1)
(R^{f3}_{m'}R^{e3}_{l'}R^{d3}_{k'}C)_{δ}-X¹⁰⁹-PFPE-X¹⁰⁹-(CR^{d3}_{k'}R^{e3}_{l'}R^{f3}_{m'})_{δ} ··· (D2)
dans lequel Rf et PFPE sont tels que définis pour les formules (A1) et (A2) et, chacun indépendamment à chaque occurrence,
X¹⁰⁹ est une liaison simple ou un groupe organique divalent à décavalent ;
δ est un nombre entier de 1 à 9 ;
δ' est un nombre entier de 1 à 9 ;
R^{d3} est -Z^{3'}-CR⁸¹_{*p*'}R⁸²_{*q*'}R⁸³_{*r*'} dans lequel, chacun indépendamment à chaque occurrence,
Z³ est -O- ou un groupe organique divalent ;
R⁸¹ a la même signification que R^{d3} ; le nombre d'atomes de C liés linéairement via un groupe Z^{3'} dans
R^{d3} est ≤ 5 ;
R⁸² est -Y³-SiR⁸⁵*ⱼ*R⁸⁶_{3-*j*} dans lequel, chacun indépendamment à chaque occurrence,
Y³ est un groupe organique divalent ;
R⁸⁵ est OH ou un groupe hydrolysable ;
R⁸⁶ est H ou un alkyle inférieur ; et
j dans chaque unité de (-Y³-SiR⁸⁵*ⱼ*R⁸⁶_{*3*-*j*}) est un nombre entier de 1 à 3 ;
R⁸³ est H, OH ou un alkyle inférieur ;
*p*' est un nombre entier de 0 à 3 ;
*q'* est un nombre entier de 0 à 3 ;
*r'* est un nombre entier de 0 à 3 ;
R^{e3} est -Y³-SiR⁸⁵*ⱼ*R⁸⁶*₃₋ⱼ*;
R^{f3} est H, OH ou un alkyle inférieur ;
*k'* est un nombre entier de 0 à 3 ;
*l*' est un nombre entier de 0 à 3 ;
*m*' est un nombre entier de 0 à 3 ; à condition qu'au moins un *q'* soit 2 ou 3 ou qu'au moins un *l'* soit 2 ou 3 ;
(Rf-PFPE-G⁵)ₐ₅-Z⁵-((O-R¹⁶)_{c5}-SiR¹⁴ₙR¹⁵₃₋ₙ)_{b5} ··· (E1)
dans lequel Rf, PFPE, R¹⁴, R¹⁵ et *n* sont tels que définis pour les formules (A1) et (A2) et
G⁵ est -R¹⁷-O-, -R¹⁷-CONH-, -CONH- ou une liaison simple ; R¹⁷ est un groupe alkylène ;
Z⁵ est un groupe hydrocarbure (*a5*+*b5*)-valent ou un groupe (*a5*+*b5*)-valent présentant ≥ 2 atomes de carbone et présentant au moins un atome d'oxygène éthérique entre les atomes de carbone dans le groupe hydrocarbure ;
R¹⁶ est un alkylène ;
*a*5 est un nombre entier ≥ 1 ;
*b5* est un nombre entier ≥ 1 ; à condition que (a5+b5) soit ≥ 3 ; et
*c5* est 0 ou 1.

2. Agent de traitement de surface selon la revendication 1, dans lequel
R¹ est un groupe R³-(OR²)*_{α}*-L- dans lequel (OR²)ₐ est une chaîne de polyéther, de préférence une chaîne de polyéther de la formule
-(OC₄F₈)*ₘ₁₃*-(OC₃F₆)*ₘ₁₄*-(OC₂F₄)*ₘ₁₅*-(OCF₂)*ₘ₁₆*-
dans lequel *m13* et *m14* sont chacun un nombre entier de 0 à 30, et *m15* et *m16* sont chacun un nombre entier de 1 à 200 ; *m13* à *m16* sont >_ 5 au total ; et l'ordre d'occurrence des unités de répétition respectives n'est pas limité ;
R³ est un alkyle ou un fluoroalkyle ; et
L est une liaison simple ou un groupe de liaison divalente ; et
R^{1'} est un groupe -L'-(OR²)ₐ₋L- dans lequel (OR²)ₐ est une chaîne de polyéther ; et L et L' chacun indépendamment à chaque occurrence sont une liaison simple ou un groupe de liaison divalente.

3. Agent de traitement de surface selon la revendication 2, dans lequel
L est -(CX¹²¹X¹²²)*ₒ*-(L¹)*ₚ*-(CX¹²³X¹²⁴)*_{q}*- et
L' est -(CX¹²⁶X¹²⁷)ᵣ-(CX¹²¹X¹²²)o-(L¹)p-(CX¹²³X¹²⁴)q- ; dans lequel
X¹²¹-X¹²⁴ chacun indépendamment sont H, F, OH ou -OSi(OR¹²⁵)₃ dans lequel R¹²⁵ chacun indépendamment est un alkyle en C1-4 ;
X¹²⁶, X¹²⁷ chacun indépendamment sont H, F ou CI ;
L¹ est -C(=O)NH-, -NHC(=O)-, -O-, -C(=O)O-, -OC(=O)-,-OC(=O)O-, ou - NHC(=O)NH-, dans lequel le côté gauche de chaque liaison est lié à CX¹²¹X¹²² ;
*o* est un nombre entier de 0 à 10 ;
*p* est 0 ou 1 ;
*q* est un nombre entier de 1 à 10 ; et
*r* est un nombre entier de 1 à 6.

4. Agent de traitement de surface selon l'une quelconque des revendications 1 à 3, dans lequel X¹ est
-L²-{Si(R^{a})₅(R^{b})*ₜ*(R^{c})*ᵤ*(R^{d})*ᵥ*}*ₙ*
dans lequel, chacun indépendamment à chaque occurrence,
L² est une liaison simple ou un groupe de liaison divalente ;
R^{a}-R^{c} sont H, un halogène, un alcoxy en C₁₋₁₀, un amino en C₁₋₁₀, un acétoxy en C₁₋₁₀, un allyle en C₃₋₁₀ ou un glycidyle en C₃₋₁₀ ;
R^{d} est -O-, -NH-, -C≡C- ou une liaison silane ;
*s*, *t, u* sont 0 ou 1 ;
*v* est un nombre entier de 0 à 3 ;
*n* est un nombre entier de 1 à 20 ;
si *n* = 1, alors *(s*+*t*+*u)* = 3 et v = 0 ;
si *n* est 2 à 20, alors (*s*+*t*+*u*) chacun indépendamment est 0 à 2, et v chacun indépendamment est 0 à 2 ; et
si *v* ≥ 1, alors au moins deux atomes de Si sont liés l'un à l'autre via R^{d} sous un forme linéaire d'échelle, cyclique ou polycyclique.

5. Agent de traitement de surface selon l'une quelconque des revendications 1 à 4, dans lequel X¹ est un groupe sélectionné parmi -L²-SiR⁵₃, -L²-Si(OR⁶)₃, -L²-Si(NR⁶₂)₃ et -L²-Si(OCOR⁶)₃, dans lequel
L² est -C₂H₄-, -C₃H₆-, -C₄H₈-O-CH₂-, -CO-O-CH₂-CH(OH)-CH₂-, -CH₂-, ou-C₄H₈- ;
R⁵ est un halogène ; et
R⁶ est chacun indépendamment un alkyle en C₁₋₄.

6. Agent de traitement de surface selon l'une quelconque des revendications 1 à 3, dans lequel X¹ est un groupe réticulable réactif contenant un silane de la formule :
-L²-{Si(R^{a})*ₛ*(R^{b})*ₜ*(R^{c})*ᵤ*(R^{d'})*ᵥ*}*ₙ*
dans lequel, chacun indépendamment à chaque occurrence,
L² est une liaison simple ou un groupe de liaison divalente ;
R^{a}-R^{c} sont H, un halogène, un alcoxy en C₁₋₁₀, un amino en C₁₋₁₀, un acétoxy en C₁₋₁₀, un allyle en C₃₋₁₀ ou un glycidyle en C₃₋₁₀ ;
R^{d'} est un groupe -Z-SiR^{d1'}_{*p*'}R^{d2'}_{*q*'}R^{d3'}*_{r'}* dans lequel, chacun indépendamment à chaque occurrence,
Z est une liaison simple ou un groupe de liaison divalente ;
R^{d1'} a la même signification que R^{d'} ; le nombre d'atomes de Si liés linéairement via un groupe Z dans R^{d'} est ≤ 5 ;
R^{d2'} est OH ou un groupe hydrolysable ;
R^{d3'} est H ou un alkyle inférieur ;
*p',q',r'* sont des nombres entiers de 0 à 3, à condition que *(p'*+*q'*+*r')*=*3* ;
s, *t, u* sont 0 ou 1 ;
*v* est un nombre entier de 0 à 3 ;
*n* est un nombre entier de 1 à 20.

7. Agent de traitement de surface selon l'une quelconque des revendications 1 à 3, dans lequel X¹ est un groupe réticulable réactif contenant un silane de la formule :
-L⁶-{C(R^{a6})*ₛ₆*(R^{b6})*ₜ₆*(R^{c6})*ᵤ₆*(R^{d6})*ᵥ₆*}*ₙ₆*
dans lequel, chacun indépendamment à chaque occurrence,
L⁶ est une liaison simple ou un groupe de liaison divalente ;
R^{a6}-R^{c6} sont H, un halogène, un alcoxy en C₁₋₁₀, un amino en C₁₋₁₀, un acétoxy en C₁₋₁₀, un allyle en C₃₋₁₀, un glycidyle en C₃₋₁₀, un alkyle en -OCO(C₁₋₆), OH ou -Y⁶-SiR⁶⁵*ⱼ₆*6R⁶⁶_{3-*j6*} dans lequel, chacun indépendamment
Y⁶ est un groupe organique divalent ;
R⁶⁵ est OH ou un groupe hydrolysable ;
R⁶⁶ est H ou un alkyle inférieur ;
*j6* dans chaque unité de (-Y⁶-SiR⁶⁵ⱼ₆R⁶⁶₃₋ⱼ₆) est un nombre entier de 1 à 3 ;
R^{d6} est -O-, -NH-, -C≡C- ou -Z⁶-CR⁶¹_{P6}R⁶²_{q6}R⁶³ᵣ₆ dans lequel, chacun indépendamment à chaque occurrence,
Z⁶ est -O- ou un groupe organique divalent ;
R⁶¹ a la même signification que R^{d6} ; le nombre d'atomes de C liés linéairement via un groupe Z⁶ dans R^{d6} est ≤5 ;
R⁶² est -Y⁶-SiR⁶⁵ⱼ₆R⁶⁶₃₋ⱼ₆ ;
R⁶³ est H ou un alkyle inférieur ;
*p6, q6, r6* sont des nombres entiers de 0 à 3 ; et
*s6, t6, u6* sont 0 ou 1 ;
*v6* est un nombre entier de 0 à 3, et
*n6* est un nombre entier de 1 à 20,
à condition que dans la formule, au moins deux groupes -Y⁶-SiR⁶⁵ⱼ₆R⁶⁶₃₋ⱼ₆ soient présents.

8. Agent de traitement de surface selon l'une quelconque des revendications 1 à 7, dans lequel le composé (2) est un composé de formule (C1) ou (C2).

9. Agent de traitement de surface selon l'une quelconque des revendications 1 à 8, dans lequel PFPE est un groupe représenté par :
-(OC₄F₈)*ₘ₁₃*-(OC₃F₆)*ₘ₁₄*-(OC2F₄)*ₘ₁₅*-(OCF2)*ₘ₁₆*-
dans lequel *m13* et *m14* sont chacun un nombre entier de 0 à 30, et *m15*et *m16* sont chacun un nombre entier de 1 à 200 ; et l'ordre d'occurrence des unités de répétition respectives n'est pas limité.

10. Agent de traitement de surface selon l'une quelconque des revendications 1 à 9, comprenant en outre un solvant.

11. Utilisation de l'agent de traitement de surface selon l'une quelconque des revendications 1 à 10 comme agent de revêtement antisalissure ou agent de revêtement étanche à l'eau.

12. Utilisation de l'agent de traitement de surface selon l'une quelconque des revendications 1 à 10 pour dépôt en phase vapeur.

13. Pastille comprenant l'agent de traitement de surface selon l'une quelconque des revendications 1 à 10.

14. Article comprenant un matériau de base et, sur une surface du matériau de base, une couche formée à partir de l'agent de traitement de surface selon l'une quelconque des revendications 1 à 10.

15. Article selon la revendication 14 qui est un élément optique.
